# EUROPEAN PATENT APPLICATION

(11) **EP 4 770 304 A1**
(43) Date of publication of application: **01.07.2026**
(21) Application number: 25216947.9
(22) Date of filing: 19.11.2025
(51) Int. Cl.: H10B 12/00

(54) **SEMICONDUCTOR DEVICE AND METHOD FOR FABRICATING THE SAME**

(30) Priority: 30.12.2024 KR 20240200999
(71) Applicant: SK hynix Inc., Bubal-eub Icheon-si Gyeonggi-do 17336 (KR)
(72) Inventor: KANG, Hong Seong, 17336 Icheon-si (KR); KWAK, Jun Ha, 17336 Icheon-si (KR); KWON, Jeong Hoon, 17336 Icheon-si (KR)
(74) Representative: Isarpatent

(57) **Abstract**

A semiconductor device including high-integrated memory cells and a method for fabricating the semiconductor device is provided. The semiconductor device includes a vertical arrangement and a horizontal arrangement of nano sheets; horizontal conductive lines that surround the horizontal arrangement of the nano sheets; pads coupled to edge portions of the horizontal conductive lines; inter-pad dielectric layers disposed between the pads; contact plugs each coupled to a different one of the pads; and contact spacers each including a first low-k material and each formed on a sidewall of each of the contact plugs.

## Description

### CROSS-REFERENCE TO RELATED APPLICATIONS

The present application claims priority under 35 U.S.C 119(a) to Korean Patent Application No. 10-2024-0200999, filed on December 30, 2024, which is incorporated herein by reference in its entirety.

### BACKGROUND

### 1. Field

Various embodiments of the present disclosure relate to a semiconductor device, and more particularly, to a semiconductor device including three-dimensional (3D) memory cells, and a method for fabricating the semiconductor device.

### 2. Description of the Related Art

Recently, there have been increasing demands for larger capacity and greater miniaturization of memory devices. In order to cope with these demands, three-dimensional (3D) memory devices that include stacked memory cells have been proposed.

### SUMMARY

Embodiments of the present disclosure are directed to a semiconductor device including high-integrated memory cells, and a method for fabricating the semiconductor device.

In accordance with an embodiment of the present disclosure, a semiconductor device may include a vertical arrangement and a horizontal arrangement of nano sheets; horizontal conductive lines that surround the horizontal arrangement of the nano sheets; pads coupled to edge portions of the horizontal conductive lines; inter-pad dielectric layers disposed between the pads; contact plugs each coupled to a different one of the pads; and contact spacers each including a first low-k material and each formed on a sidewall of each of the contact plugs.

In accordance with an embodiment of the present disclosure, a semiconductor device may include a vertical arrangement and a horizontal arrangement of nano sheets; horizontal conductive lines that surround the horizontal arrangement of the nano sheets; a stair-less structure including horizontally-oriented pads coupled to edge portions of the horizontal conductive lines and low-k inter-pad dielectric layers formed between the horizontally-oriented pads; vertically-oriented contact plugs each coupled to a different one of the horizontally-oriented pads; and low-k spacers surrounding outer walls of the respective contact plugs.

In some embodiments, the semiconductor device further comprising: contact liners formed on sidewalls of the low-k spacers; and inter-pad liners formed between the low-k inter-pad dielectric layers and the pads.

Wherein the low-k spacers and the low-k inter-pad dielectric layers each have a lower dielectric constant than silicon carbon oxide (SiCO) and silicon oxide (SiO₂).

Wherein the low-k spacers and the low-k inter-pad dielectric layers each include SiCOH, SiOF, or a combination thereof.

In some embodiments, the semiconductor device further comprising: a vertical conductive line coupled to the vertical arrangement of the nano sheets; data storage elements each coupled to a different one of the nano sheets in the vertical arrangement and the horizontal arrangement; first contact nodes formed between the nano sheets and the vertical conductive line; and second contact nodes formed between the nano sheets and the data storage elements.

In accordance with an embodiment of the present disclosure, a method for fabricating a semiconductor device may include forming an alternating stack of sacrificial sheets and inter-pad dielectric layers over a substrate; forming contact holes whose heights gradually decrease in a stacking direction of the sacrificial sheets and the inter-pad dielectric layers in the alternating stack; forming low-k spacers on sidewalls of the contact holes; forming sacrificial plugs each filling a different one of the contact holes on the low-k spacers; removing the sacrificial sheets of the alternating stack and forming pad-shaped openings; forming pads that fill the pad-shaped openings; removing the sacrificial plugs and forming plug openings; cutting portions of the low-k spacers through the plug openings and exposing the pads; and forming contact plugs that fill the plug openings and are coupled to the pads.

In some embodiments, the method further comprising forming contact liners on the sidewalls of the contact holes, before forming the low-k spacers.

Wherein the contact liners comprising include oxide, nitride, or a combination thereof.

Wherein the low-k spacers and the inter-pad dielectric layers each include SiCOH, SiOF, or a combination thereof.

Wherein the contact holes are formed horizontally spaced apart from each other with different depths.

Wherein forming the contact holes includes etching the alternating stack to have a stair-less structure, through a plurality of mask processes and a plurality of etch processes.

In some embodiments, the method further comprising: before forming the alternating stack, forming nano sheet target layers stacked vertically spaced apart from each other over the substrate; trimming first portions of the nano sheet target layers and forming flat plate-shaped sheets; forming horizontal conductive lines that surround the flat plate-shaped sheets and are horizontally oriented; and forming a vertical conductive line coupled to the flat plate-shaped sheets.

In some embodiments, the method further comprising: after forming the pads, horizontally recessing second portions of the nano sheet target layers and forming fan-like sheets; selectively growing contact nodes on side surfaces of the respective fan-like sheets; and forming data storage elements each coupled to a different one of the contact nodes.

Wherein forming the alternating stack of the sacrificial sheets and the inter-pad dielectric layers over the substrate includes: forming the sacrificial sheets and inter-pad recesses between the sacrificial sheets over the substrate; and forming a low-k dielectric layer that fills the inter-pad recesses to form the inter-pad dielectric layers.

In some embodiments, the method further comprising conformally forming inter-pad liners on the inter-pad recesses, before forming the low-k dielectric layer.

In accordance with an embodiment of the present disclosure, a semiconductor device may include a substrate; a cell array region including a plurality of horizontal conductive lines that are vertically stacked in a first direction over the substrate; a connection region including pads and low-k inter-pad dielectric layers that are alternately stacked in the first direction; contact plugs each coupled to a different one of the pads; and low-k spacers formed on sidewalls of the respective contact plugs.

### BRIEF DESCRIPTION OF THE DRAWINGS

FIG. 1A is a schematic perspective view illustrating a memory cell in accordance with an embodiment of the present disclosure.
FIG. 1B is a schematic cross-sectional view of the memory cell illustrated in FIG. 1A.
FIG. 2A is a schematic perspective view illustrating a semiconductor device in accordance with an embodiment of the present disclosure.
FIG. 2B is a partial perspective view illustrating a first spacer.
FIG. 2C is a partial perspective view illustrating a second spacer.
FIG. 3 is a schematic perspective view illustrating a semiconductor device in accordance with an embodiment of the present disclosure.
FIG. 4A is a schematic perspective view illustrating a semiconductor device in accordance with an embodiment of the present disclosure.
FIG. 4B is a schematic plan view of the semiconductor device illustrated in FIG. 4A.
FIG. 4C is a schematic cross-sectional view of the semiconductor device taken along line A-A' illustrated in FIG. 4B.
FIG. 4D is a schematic cross-sectional view of the semiconductor device taken along line B-B' illustrated in FIG. 4B.
FIG. 4E is a cross-sectional view of the semiconductor device taken along line B1-B1' illustrated in FIG. 4B.
FIGS. 5A to 34B illustrate various views of a semiconductor device formed utilizing a method for fabricating the semiconductor device in accordance with an embodiment of the present disclosure.
FIG. 35 is a schematic cross-sectional view of a semiconductor device in accordance with an embodiment of the present disclosure.
FIG. 36 is a schematic cross-sectional view of a semiconductor device in accordance with an embodiment of the present disclosure.
FIG. 37 is a schematic cross-sectional view of a semiconductor device in accordance with an embodiment of the present disclosure.
FIG. 38 is a schematic cross-sectional view of a semiconductor device in accordance with an embodiment of the present disclosure.
FIGS. 39A and 39B are schematic cross-sectional views of a semiconductor device in accordance with embodiments of the present disclosure.
FIGS. 40A and 40B illustrate various views illustrating a stack assembly in accordance with embodiments of the present disclosure.

### DETAILED DESCRIPTION

Various embodiments of the present disclosure described herein may be described with reference to cross-sectional views, plan views and block diagrams, which are ideal schematic views of a semiconductor device. It is noted that the structures of the drawings may be modified by fabricating techniques and/or tolerances. The embodiments of the present disclosure are not limited to the described embodiments and the specific structures illustrated in the drawings, but may include other embodiments, or modifications of the described embodiments including any changes in the structures that may be produced according to requirements of the fabricating process. Accordingly, the regions illustrated in the drawings have schematic attributes, and the shapes of the regions illustrated in the drawings are intended to illustrate specific structures of regions of the elements, and are not intended to limit the scope of the disclosure.

The following embodiment relates to three-dimensional memory cells, in which memory cells are vertically stacked to increase memory cell density and reduce parasitic capacitance.

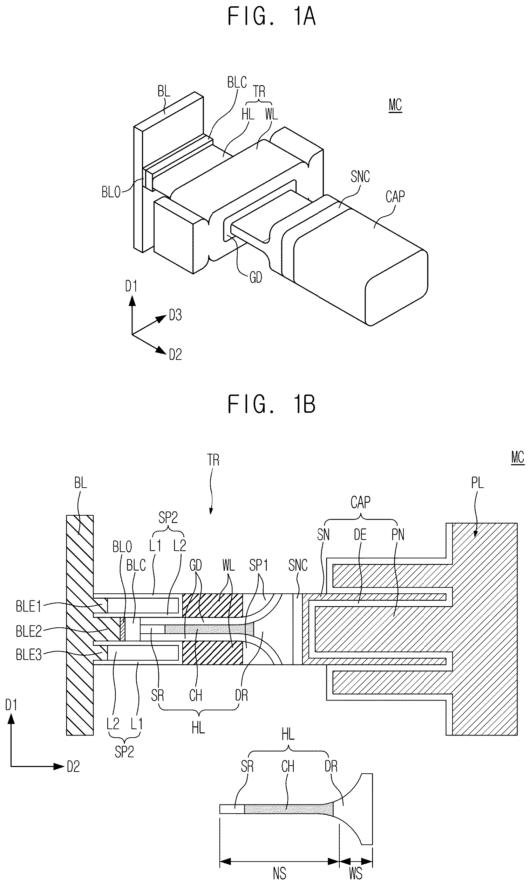

FIG. 1A is a schematic perspective view illustrating a memory cell MC in accordance with an embodiment of the present disclosure. FIG. 1B is a schematic cross-sectional view of the memory cell MC illustrated in FIG. 1A.

Referring to FIGS. 1A and 1B, the memory cell MC may include a first conductive line BL, a switching element TR, and a data storage element CAP.

The first conductive line BL may be vertically oriented in a first direction D1. The first conductive line BL may include a bit line. The first conductive line BL may be referred to as a "vertical conductive line", a "vertically-oriented bit line", a "vertically-extending bit line", or a "pillar-shaped bit line". The first conductive line BL may include a conductive material. The first conductive line BL may include a silicon-based material, a metal-based material, or a combination thereof. The first conductive line BL may include polysilicon, metal, metal nitride, metal silicide, or a combination thereof. The first conductive line BL may include polysilicon, titanium nitride, tungsten, or a combination thereof. For example, the first conductive line BL may include a titanium nitride/tungsten (TiN/W) stack in which titanium nitride and tungsten are sequentially stacked.

The switching element TR has a function of controlling voltage or current supply to the data storage element CAP during a data write operation and a data read operation performed on the data storage element CAP. The switching element TR may include a nano sheet HL, a nano sheet dielectric layer GD, and a second conductive line WL. The second conductive line WL may include a horizontal conductive line (for example, horizontally oriented) or a horizontal word line, and the nano sheet HL may include an active layer. The switching element TR may include a transistor, and in this case, the second conductive line WL may serve as a gate or a gate electrode. The switching element TR may also be referred to as a "nano sheet transistor", an "access element" or a "selection element". The second conductive line WL may be referred to as a "horizontal gate electrode" or a "horizontal word line".

The nano sheet HL may extend in a second direction D2 that intersects with the first direction D1. The second conductive line WL may horizontally extend in a third direction D3 that intersects with the first direction D1 and the second direction D2. The first direction D1 may be a vertical direction, the second direction D2 may be a first horizontal direction, and the third direction D3 may be a second horizontal direction (for example, perpendicular to the first horizontal direction). The nano sheet HL may extend in the first horizontal direction, i.e., the second direction D2, and the second conductive line WL may extend in the second horizontal direction, i.e., the third direction D3. The nano sheet HL may be referred to as a "horizontal layer" or a "channel body".

The nano sheet HL may include a channel CH, a first doped region SR between the channel CH and the first conductive line BL, and a second doped region DR between the channel CH and the data storage element CAP. The first doped region SR may be electrically coupled to the first conductive line BL, and the second doped region DR may be electrically coupled to the data storage element CAP. A height of the second doped region DR in the first direction D1 may be greater than a height of the channel CH in the first direction D1. A length of the second doped region DR in the second direction D2 may be less than a length of the channel CH in the second direction D2. The lengths of the first doped region SR, the channel CH and the second doped region DR in the third direction D3 may be equal to one another.

The nano sheet HL may include a first sheet region NS and a second sheet region WS that are horizontally disposed in the second direction D2. The second sheet region WS may extend from the first sheet region NS. The second sheet region WS may have a thickness that gradually increases in the second direction D2 from the first sheet region NS toward the data storage element CAP between the first sheet region NS and the data storage element CAP. An average vertical height or thickness of the second sheet region WS in the first direction D1 may be greater than an average vertical height or thickness of the first sheet region NS. Hereinafter, the first sheet region NS is referred to as a "narrow sheet", and the second sheet region WS is referred to as a "wide sheet".

The narrow sheet NS may have a flat plate shape. The wide sheet WS may have a fan-like shape. The wide sheet WS may have a thickness that gradually increases in the second direction D2. The narrow sheet NS may be referred to as a "flat plate-shaped sheet", and the wide sheet WS may be referred to as a "fan-like (or fan, conical flask, etc.) shaped sheet". Upper and lower surfaces of the wide sheet WS may each have a curvature.

The first doped region SR and the channel CH may be disposed in the narrow sheet NS, and the second doped region DR may be disposed in the wide sheet WS. The channel CH formed in the narrow sheet NS may be referred to as a "narrow channel" or a "flat channel". A portion of the second doped region DR may extend to be disposed in the narrow sheet NS. The second doped region DR may include a thick portion disposed in the wide sheet WS and a thin portion disposed in the narrow sheet NS. One side of the wide sheet WS and one side of the second doped region DR, which contact the data storage element CAP, may each have a flat side shape.

A horizontal length of the wide sheet WS in the second direction D2 may be less than a horizontal length of the narrow sheet NS. The narrow sheet NS may be referred to as a "long sheet", and the wide sheet WS may be referred to as a "short sheet".

The nano sheet HL may include a semiconductive material. For example, the nano sheet HL may include polysilicon, monocrystalline silicon, germanium, or silicon-germanium. In some embodiments, the nano sheet HL may include an oxide semiconductor material. For example, the oxide semiconductor material may include indium gallium zinc oxide (IGZO), InSnZnO (commonly referred to as Indium-Tin-Zinc-Oxide (ITZO)), zinc stannate (ZnSnO), or a combination thereof. In some embodiments, the nano sheet HL may include conductive metal oxide.

In some embodiments, the nano sheet HL may include a two-dimensional material or a two-dimensional semiconductor material. The two-dimensional semiconductor material may refer to a semiconductor material having a layered structure in which constituent atoms are two-dimensionally bonded. The two-dimensional material has excellent electrical properties, and even when a thickness of the two-dimensional material is reduced to a nano scale, the two-dimensional semiconductor material may maintain high mobility without significantly changing its property. For example, the nano sheet HL may include molybdenum disulfide (MoS₂), tungsten disulfide (WS₂), or molybdenum diselenide (MoSe₂).

When the nano sheet HL is formed of the oxide semiconductor material, the channel CH may also be formed of the oxide semiconductor material, and the first and second doped regions SR and DR may be omitted. The nano sheet HL may also be referred to as an "active layer" or a "thin body".

The first doped region SR and the second doped region DR may be doped with an impurity having the same conductivity type. Each of the first doped region SR and the second doped region DR may be doped with an N-type conductive impurity or a P-type conductive impurity. For example, the conductive impurity may include arsenic (As), phosphorus (P), boron (B), indium (In), and combinations thereof. The first doped region SR may be electrically coupled to the first conductive line BL, and the second doped region DR may be electrically coupled to the data storage element CAP. The first and second doped regions SR and DR may be referred to as "first and second source/drain regions".

The nano sheet HL may be horizontally oriented in the second direction D2 from the first conductive line BL.

The second conductive line WL may have a gate-all-around (GAA) structure. For example, the second conductive line WL may surround the nano sheet HL and extend in the third direction D3. The nano sheet dielectric layer GD may be formed between the nano sheet HL and the second conductive line WL. The nano sheet dielectric layer GD may surround the nano sheet HL. The second conductive line WL may surround the nano sheet HL on the nano sheet dielectric layer GD.

The second conductive line WL may include a metal material, a metal-based material, a semiconductive material, or a combination thereof. The second conductive line WL may include molybdenum, molybdenum nitride, ruthenium, titanium nitride, tungsten, polysilicon, or a combination thereof. For example, the second conductive line WL may include a TiN/W stack in which titanium nitride and tungsten are sequentially stacked. The second conductive line WL may include an N-type work function material or a P-type work function material. The N-type work function material may have a low work function of approximately 4.5 eV or less, and the P-type work function material may have a high work function of approximately 4.5 eV or greater. The second conductive line WL may include a stack of a low work function material and a high work function material.

The nano sheet dielectric layer GD may be disposed between the nano sheet HL and the second conductive line WL. The nano sheet dielectric layer GD may be referred to as a "gate dielectric layer" or a "channel-side dielectric layer". The nano sheet dielectric layer GD may include silicon oxide, silicon nitride, metal oxide, metal oxynitride, metal silicate, a high-k material, a ferroelectric material, an anti-ferroelectric material, or a combination thereof. The nano sheet dielectric layer GD may include silicon oxide (SiO₂), silicon nitride (Si₃N₄), hafnium oxide (HfO₂), aluminum oxide (Al₂O₃), zirconium oxide (ZrO₂), aluminum oxynitride (AlON), hafnium oxynitride (HfON), hafnium silicate (HfSiO), hafnium silicon oxynitride (HfSiON), hafnium zirconium oxide (HfZrO), or a combination thereof. The nano sheet dielectric layer GD may be formed by thermal oxidation of a semiconductive material. The nano sheet dielectric layer GD may be formed by a combination of deposition of a nano sheet dielectric material and oxidation of a semiconductive material.

The data storage element CAP may include a memory element such as a capacitor. The data storage element CAP may be horizontally disposed in the second direction D2 from the switching element TR. The data storage element CAP may include a first electrode SN, a second electrode PN on the first electrode SN, and a dielectric layer DE between the first electrode SN and the second electrode PN. The first electrode SN may horizontally extend in the second direction D2 from the nano sheet HL. The first electrode SN, the dielectric layer DE and the second electrode PN may be horizontally disposed in the second direction D2. The first electrode SN may include an inner space and a plurality of outer surfaces, and the inner space of the first electrode SN may include a plurality of inner surfaces. The outer surfaces of the first electrode SN may include a vertical outer surface and a plurality of horizontal outer surfaces. The vertical outer surface of the first electrode SN may vertically extend in the first direction D1, and the horizontal outer surfaces of the first electrode SN may horizontally extend in the second direction D2 or the third direction D3. The inner space of the first electrode SN may be a three-dimensional space. The dielectric layer DE may conformally cover the inner surfaces of the first electrode SN. The second electrode PN may be disposed in the inner space of the first electrode SN on the dielectric layer DE. Some of the outer surfaces of the first electrode SN may be electrically coupled to the second doped region DR of the nano sheet HL. The second electrode PN of the data storage element CAP may be coupled to a common plate PL.

The data storage element CAP may have a three-dimensional structure. The first electrode SN may have a three-dimensional structure, which may have a horizontal three-dimensional structure that is oriented in the second direction D2. In an example of the three-dimensional structure, the first electrode SN may have a cylindrical shape. The cylindrical shape of the first electrode SN may include cylindrical inner surfaces and cylindrical outer surfaces. Some of the cylindrical outer surfaces of the first electrode SN may be electrically coupled to the second doped region DR of the nano sheet HL. The dielectric layer DE and the second electrode PN may be disposed on the cylindrical inner surfaces and cylindrical outer surfaces of the first electrode SN.

In some embodiments, the first electrode SN may have a pillar shape or a pylinder shape. The pylinder shape may refer to a structure in which a pillar shape and a cylindrical shape are merged.

The first electrode SN and the second electrode PN may include metal, noble metal, metal nitride, conductive metal oxide, conductive noble metal oxide, metal carbide, metal silicide, or a combination thereof. For example, the first electrode SN and the second electrode PN may include titanium (Ti), titanium nitride (TiN), titanium silicon nitride (TiSiN), tantalum (Ta), tantalum nitride (TaN), tungsten (W), tungsten nitride (WN), ruthenium (Ru), ruthenium oxide (RuO₂), iridium (Ir), iridium oxide (IrO₂), platinum (Pt), molybdenum (Mo), molybdenum nitride (MoN), molybdenum oxide (MoO), a titanium nitride/tungsten (TiN/W) stack, a tungsten nitride/tungsten (WN/W) stack, a titanium silicon nitride/titanium nitride (TiSiN/TiN) stack, a titanium nitride/titanium silicon nitride (TiN/TiSiN) stack, a titanium silicon nitride/titanium nitride/tungsten (TiSiN/TiN/W) stack, or a combination thereof. The second electrode PN may also include a combination of a metal-based material and a silicon-based material. For example, the second electrode PN may be a titanium nitride/silicon germanium/tungsten nitride (TiN/SiGe/WN) stack. In the titanium nitride/silicon germanium/tungsten nitride (TiN/SiGe/WN) stack, silicon germanium may be a gap-fill material that fills the inside of the first electrode SN, titanium nitride (TiN) may serve as the second electrode PN of the data storage element CAP, and tungsten nitride may be a low-resistance material.

The dielectric layer DE may be referred to as a "capacitor dielectric layer" or a "memory layer". The dielectric layer DE may include silicon oxide, silicon nitride, a high-k material, a perovskite material, or a combination thereof. The high-k material may include hafnium oxide (HfO₂), zirconium oxide (ZrO₂), aluminum oxide (Al₂O₃), lanthanum oxide (La₂O₃), titanium oxide (TiO₂), tantalum oxide (Ta₂O₅), niobium oxide (Nb₂O₅), or strontium titanium oxide (SrTiO₃). In some embodiments, the dielectric layer DE may be formed of a composite layer including two or more layers of the above-described high-k material.

The dielectric layer DE may be formed of zirconium (Zr)-based oxide. The dielectric layer DE may have a stack structure containing zirconium oxide (ZrO₂). The dielectric layer DE may include a ZA (ZrO₂/Al₂O₃) stack or a ZAZ (ZrO₂/Al₂O₃/ZrO₂) stack. The ZA stack may have a structure in which aluminum oxide (Al₂O₃) is stacked on zirconium oxide (ZrO₂). The ZAZ stack may have a structure in which zirconium oxide (ZrO₂), aluminum oxide (Al₂O₃) and zirconium oxide (ZrO₂) are sequentially stacked. Each of the ZA stack and the ZAZ stack may be referred to as a "zirconium oxide (ZrO₂)-based layer".

In some embodiments, the dielectric layer DE may be formed of hafnium (Hf)-based oxide. The dielectric layer DE may have a stack structure containing hafnium oxide (HfO₂). The dielectric layer DE may include an HA (HfO₂/Al₂O₃) stack or an HAH (HfO₂/Al₂O₃/HfO₂) stack. The HA stack may have a structure in which aluminum oxide (Al₂O₃) is stacked on hafnium oxide (HfO₂). The HAH stack may have a structure in which hafnium oxide (HfO₂), aluminum oxide (Al₂O₃), and hafnium oxide (HfO₂) are sequentially stacked. Each of the HA stack and the HAH stack may be referred to as a "hafnium oxide (HfO₂)-based layer". In the ZA stack, ZAZ stack, HA stack, and HAH stack, aluminum oxide (Al₂O₃) may have a greater band gap energy than zirconium oxide (ZrO₂) and hafnium oxide (HfO₂). Aluminum oxide (Al₂O₃) may have a lower dielectric constant than zirconium oxide (ZrO₂) and hafnium oxide (HfO₂). Accordingly, the dielectric layer DE may include a stack of a high-k material and a high band gap material having a greater band gap energy than the high-k material. The dielectric layer DE may include silicon oxide (SiO₂) as a high band gap material other than aluminum oxide (Al₂O₃). Because the dielectric layer DE includes a high band gap material, leakage current may be suppressed. The high band gap material may be thinner than the high-k material.

In some embodiments, the dielectric layer DE may include a stack structure in which a high-k material and a high band gap material are alternately stacked. For example, the dielectric layer DE may include a ZAZA (ZrO₂/Al₂O₃/ZrO₂/Al₂O₃) stack, a ZAZAZ (ZrO₂/Al₂O₃/ZrO₂/Al₂O₃/ZrO₂) stack, an HAHA (HfO₂/Al₂O₃/HfO₂/Al₂O₃) stack, an HAHAH (HfO₂/Al₂O₃/HfO₂/Al₂O₃/HfO₂) stack, an HZAZH (HfO₂/ZrO₂/Al₂O₃/ZrO₂/HfO₂) stack, a ZHZAZHZ (ZrO₂/HfO₂/ZrO₂/Al₂O₃/ZrO₂/HfO₂/ZrO₂) stack, an HZHZ (HfO₂/ZrO₂/HfO₂/ZrO₂) stack, an AHZAZHA (Al₂O₃/HfO₂/ZrO₂/Al₂O₃/ZrO₂/HfO₂/Al₂O₃) stack, an AHZAHZA(Al₂O₃/HfO₂/ZrO₂/Al₂O₃/HfO₂/ZrO₂/Al₂O₃) stack, or a ZHZAZHZAT (ZrO₂/HfO₂/ZrO₂/Al₂O₃/ZrO₂/HfO₂/ZrO₂/Al₂O₃/TiO₂) stack. In the above-described stack structures, aluminum oxide (Al₂O₃) may be thinner than zirconium oxide (ZrO₂) and hafnium oxide (HfO₂).

In some embodiments, the dielectric layer DE may include a high-k material and a high band gap material. The dielectric layer DE may have a laminated structure in which a plurality of high-k materials and a plurality of high band gap materials are stacked or an intermixed structure in which a high-k material and a high band gap material are intermixed.

In some embodiments, the dielectric layer DE may include a ferroelectric material, an anti-ferroelectric material, or a combination thereof. For example, the dielectric layer DE may include HfZrO.

In some embodiments, the dielectric layer DE may include a combination of a high-k material and a ferroelectric material, a combination of a high-k material and an anti-ferroelectric material, or a combination of a high-k material or a ferroelectric material and an anti-ferroelectric material.

In some embodiments, the data storage element CAP may further include a plurality of interface control layers to alleviate leakage current. The interface control layers may each include titanium oxide (TiO₂), tantalum oxide (Ta₂O₅), niobium oxide (Nb₂O₅), niobium nitride (NbN), niobium oxynitride (NbON), or a combination thereof. The data storage element CAP may include a first interface control layer, a second interface control layer, or a combination thereof. The first interface control layer and the second interface control layer may be conductive or dielectric. The first interface control layer may be formed between the first electrode SN and the dielectric layer DE, and the second interface control layer may be formed between the dielectric layer DE and the second electrode PN. The first interface control layer and the second interface control layer may be the same material or different materials. For example, a structure of the data storage element CAP in which the first interface control layer, the dielectric layer DE and the second interface control layer are sequentially stacked may include an NZHZAZHZATN (Nb₂O₅/ZrO₂/HfO₂/ZrO₂/Al₂O₃/ZrO₂/HfO₂/ZrO₂/Al₂O₃/TiO₂/Nb₂O₅) stack.

The data storage element CAP may include a three-dimensional capacitor. The data storage element CAP may include a Metal-Insulator-Metal (MIM) capacitor. The data storage element CAP may be replaced with another data storage material. For example, the data storage material may be a thyristor, a phase-change material, a Magnetic Tunnel Junction (MTJ), or a variable resistance material.

The memory cell MC may further include a first contact node BLC and a second contact node SNC. The first contact node BLC may be disposed between the first conductive line BL and the nano sheet HL. The first contact node BLC may include a metal-based material or a semiconductive material. For example, the first contact node BLC may include titanium, titanium nitride, tungsten, or a combination thereof. In addition, the first contact node BLC may include doped polysilicon, and the first doped region SR may include an impurity diffused from the first contact node BLC. The second contact node SNC may be disposed between the nano sheet HL and the first electrode SN. The second contact node SNC may include a metal-based material or a semiconductive material. For example, the second contact node SNC may include titanium, titanium nitride, tungsten, or a combination thereof. In addition, the second contact node SNC may include doped silicon, and the second doped region DR may include an impurity diffused from the second contact node SNC. A height of the first contact node BLC in the first direction D1 may be less than a height of the second contact node SNC in the first direction D1. The height of the first contact node BLC in the first direction D1 may be greater than a height of the channel CH in the first direction D1. The first and second contact nodes BLC and SNC may each include phosphorus-doped polysilicon or arsenic-doped polysilicon.

In some embodiments, the second contact node SNC may be selectively grown from the wide sheet WS of the nano sheet HL. The second contact node SNC may be formed by selective epitaxial growth (SEG). For example, the second contact node SNC may be a silicon epitaxial layer formed by the SEG. The second contact node SNC may be a doped silicon epitaxial layer.

In some embodiments, the first contact node BLC may also be selectively grown from the narrow sheet NS of the nano sheet HL. The first contact node BLC may be formed by selective epitaxial growth (SEG). For example, the first contact node BLC may be a silicon epitaxial layer formed by the SEG. The first contact node BLC may be a doped silicon epitaxial layer.

The first contact node BLC may be a narrow sheet-side contact node, and the second contact node SNC may be a wide sheet-side contact node.

The nano sheet HL may include a first edge and a second edge. The first edge may refer to a portion of the first doped region SR electrically coupled to the first conductive line BL, and the second edge may refer to a portion of the second doped region DR electrically coupled to the first electrode SN of the data storage element CAP.

The memory cell MC may further include an ohmic contact layer BLO between the first contact node BLC and the first conductive line BL. The ohmic contact layer BLO may include metal silicide such as titanium silicide or molybdenum silicide.

The memory cell MC may further include a first spacer SP1 and a second spacer SP2. The first spacer SP1 may be disposed between the second conductive line WL and the second doped region DR. The second spacer SP2 may be disposed between the first conductive line BL and the second conductive line WL. The first and second spacers SP1 and SP2 may each include a dielectric material. The first and second spacers SP1 and SP2 may each include silicon oxide, silicon nitride, or a combination thereof. The first spacer SP1 may include silicon nitride. The second spacer SP2 may be a stack of silicon nitride and silicon oxide. The first and second spacers SP1 and SP2 may be disposed on both sidewalls of the second conductive line WL. That is, the first and second spacers SP1 and SP2 may extend in the third direction D3. The first spacer SP1 may surround the second doped region DR of the nano sheet HL, and the second spacer SP2 may surround the first doped region SR of the nano sheet HL. The second spacer SP2 may include a stack of a first liner L1 and a second liner L2. The first liner L1 of the second spacer SP2 may be silicon nitride, and the second liner L2 may be silicon oxide. The second liner L2 may partially fill an inner space of the first liner L1.

The first conductive line BL may include a plurality of horizontal extension portions BLE1, BLE2 and BLE3. The horizontal extension portions BLE1, BLE2 and BLE3 may extend in the second direction D2. The horizontal extension portions may include an inner horizontal extension portion BLE2 and outer horizontal extension portions BLE1 and BLE3. The inner horizontal extension portion BLE2 of the first conductive line BL may extend to be disposed in a gap between the first liners L1 vertically adjacent to each other. Accordingly, the inner horizontal extension portion BLE2 of the first conductive line BL may be electrically coupled to the ohmic contact layer BLO.

The outer horizontal extension portions BLE1 and BLE3 of the first conductive line BL may extend to be disposed within one side of the second spacer SP2. Accordingly, the outer horizontal extension portions BLE1 and BLE3 of the first conductive line BL may contact the second liner L2 of the second spacer SP2.

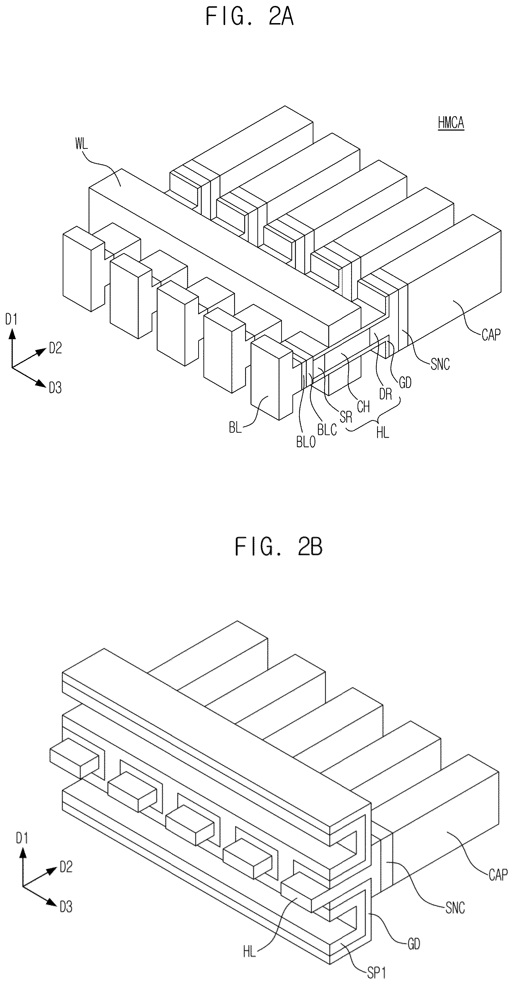

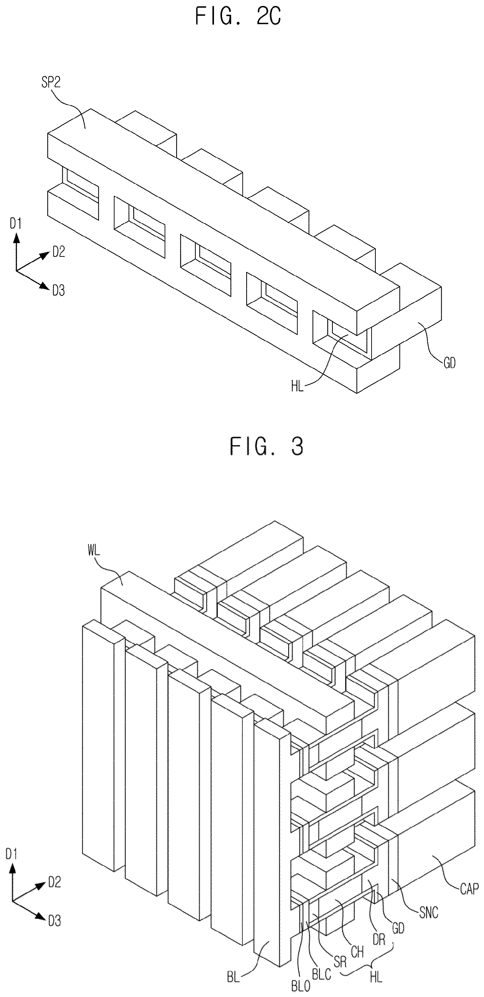

FIG. 2A is a schematic view illustrating a semiconductor device in accordance with an embodiment of the present disclosure. FIG. 2B is a partial perspective view illustrating a first spacer SP1. FIG. 2C is a partial perspective view illustrating a second spacer SP2.

FIG. 2A illustrates a horizontal array HMCA having a structure in which a plurality of memory cells MC as described above with reference to FIGS. 1A and 1B are disposed in a third direction D3.

Referring to FIGS. 1A, 1B, and 2A, the horizontal array HMCA may include a horizontal arrangement of the memory cells MC. The memory cells MC of the horizontal array HMCA may be horizontally spaced apart in the third direction D3. Each of the memory cells MC of the horizontal array HMCA may be coupled to a different one of first conductive lines BL. The memory cells MC of the horizontal array HMCA may share one second conductive line WL. Each of the memory cells MC may include a first conductive line BL, a nano sheet HL, and a data storage element CAP. The nano sheet HL may include a first doped region SR, a channel CH, and a second doped region DR. A first contact node BLC and an ohmic contact layer BLO may be formed between the first doped region SR of the nano sheet HL and the first conductive line BL. A second contact node SNC may be formed between the second doped region DR of the nano sheet HL and the data storage element CAP. The nano sheet HL may be surrounded by a nano sheet dielectric layer GD. The second conductive line WL may extend in the third direction D3 while surrounding the channels CH of the nano sheets HL on the nano sheet dielectric layer GD.

The horizontal array HMCA may further include the first spacer SP1 and the second spacer SP2 as described above with reference to FIG. 1B.

Referring back to FIG. 2B, the first spacer SP1 may have an integral structure that extends in a first direction D1. The first spacer SP1 may surround portions of the nano sheets HL, that is, the second doped regions DR of the nano sheets HL disposed at the same horizontal level. Portions of the first spacer SP1 may be disposed between the nano sheets HL, and thus the first spacer SP1 may vertically extend in the first direction D1. A crosssection of the first spacer SP1 may have a cup shape.

Referring back to FIG. 2C, the second spacer SP2 may extend in the third direction D3 while surrounding portions of the nano sheets HL, that is, the first doped regions SR of the nano sheets HL disposed at the same horizontal level.

FIG. 3 is a schematic perspective view illustrating a semiconductor device 100V in accordance with an embodiment of the present disclosure. The semiconductor device 100V illustrated in FIG. 3 may include a structure in which the horizontal array HMCA illustrated in FIG. 2A is vertically stacked in a first direction D1. Detailed descriptions of overlapping components (for example, previously discussed) are provided above with reference to FIGS. 1A to 2C.

Referring to FIG. 3, the semiconductor device 100V may include a vertical stack of horizontal arrays HMCA. The semiconductor device 100V may include a horizontal arrangement of a plurality of first conductive lines BL and a vertical arrangement of a plurality of second conductive lines WL. A vertical arrangement of memory cells MC stacked in the first direction D1 may share one first conductive line BL. A horizontal arrangement of memory cells MC arranged in a third direction D3 may be coupled to different first conductive lines BL.

The horizontal arrangement of memory cells MC arranged in the third direction D3 may share one second conductive line WL. The vertical arrangement of memory cells MC stacked in the first direction D1 may be coupled to different second conductive lines WL.

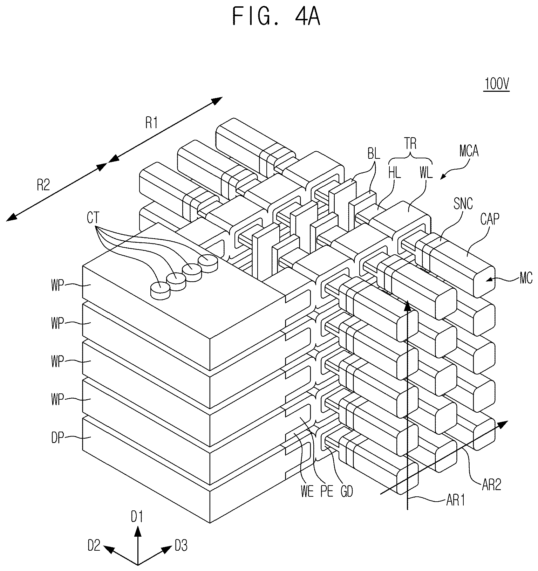

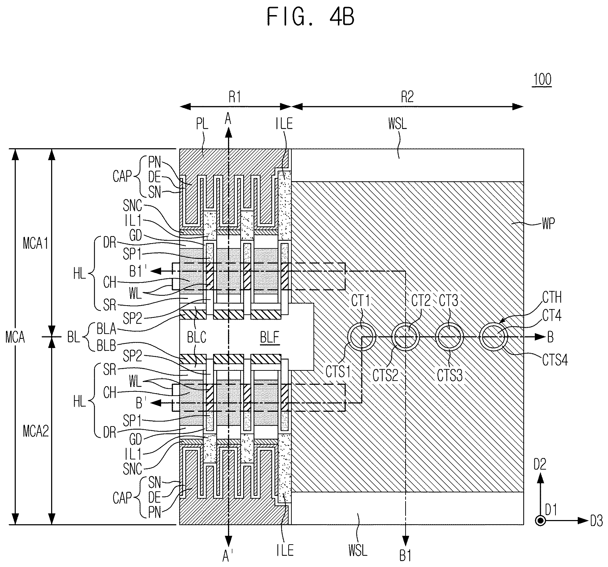

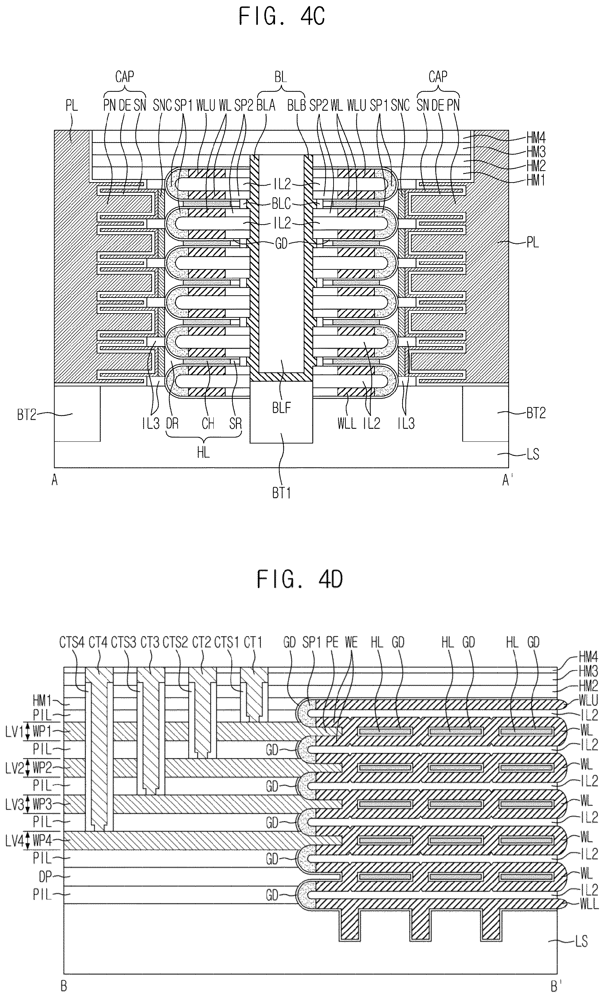

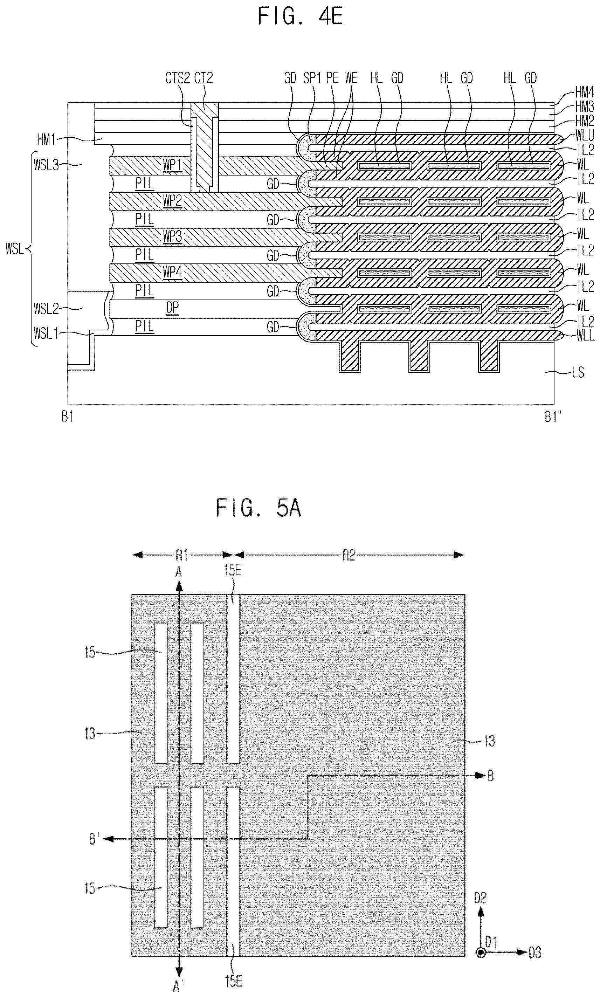

FIG. 4A is a schematic perspective view illustrating a semiconductor device 100 in accordance with an embodiment of the present disclosure. FIG. 4B is a schematic plan view of the semiconductor device 100 illustrated in FIG. 4A. FIG. 4C is a schematic cross-sectional view of the semiconductor device 100 taken along line A-A' illustrated in FIG. 4B. FIG. 4D is a schematic cross-sectional view of the semiconductor device 100 taken along line B-B' illustrated in FIG. 4B. FIG. 4E is a cross-sectional view of the semiconductor device 100 taken along line B1-B1' illustrated in FIG. 4B. Detailed descriptions of overlapping components are provided above with reference to FIGS. 1A to 3.

Referring to FIGS. 4A to 4E, the semiconductor device 100 may include a memory cell array MCA. The memory cell array MCA may include a three-dimensional array of memory cells MC. Detailed descriptions of the memory cells MC are provided above with reference to FIGS. 1A and 1B. The memory cell array MCA may be disposed on a lower structure LS.

The memory cell array MCA may include a first region R1 and a second region R2. The first region R1 may be a region in which the three-dimensional array of memory cells MC is formed, and the second region R2 may be a region in which pads WP coupled to second conductive lines WL of the memory cells MC and contact plugs CT are formed. The first region R1 may be referred to as an "array region", and the second region R2 may be referred to as a "pad region" or a "connection region". The first region R1 may include a vertical stack of the memory cells MC, and the second region R2 may include a vertical stack of the pads WP. The second region R2 may be referred to as a "sharing connection region", a "sharing contact region", or a "common contact region".

The lower structure LS may be disposed at a lower level than the memory cell array MCA. The lower structure LS may be a material appropriate for semiconductor processing. The lower structure LS may include a semiconductor substrate, a conductive material, a dielectric material, a semiconductive material, or a combination thereof. The lower structure LS may include silicon, monocrystalline silicon, polysilicon, amorphous silicon, silicon germanium, monocrystalline silicon germanium, polycrystalline silicon germanium, carbon-doped silicon, epitaxial silicon, a combination thereof, or multilayers thereof. The lower structure LS may also include another semiconductor material such as germanium. The lower structure LS may also include a III-V group semiconductor substrate, for example, a compound semiconductor substrate such as GaAs.

In some embodiments, the lower structure LS may include a metal wiring structure, a dielectric structure, a conductive structure, a bonding pad structure, another memory, or a peripheral circuit portion. For example, the lower structure LS may include a structure in which the peripheral circuit portion, the metal wiring structure and the bonding pad structure are sequentially stacked. The memory cell array MCA and the peripheral circuit portion of the lower structure LS may be bonded by wafer bonding. The wafer bonding may include pad bonding, hybrid bonding, oxide-to-oxide bonding, metal-to-metal bonding, or a combination thereof.

Each of the memory cells MC may include a first conductive line BL, a switching element TR, and a data storage element CAP. The switching element TR may include a second conductive line WL, a nano sheet dielectric layer GD, and a nano sheet HL.

The semiconductor device 100 may include a column array AR1 of the memory cells MC and a row array AR2 of the memory cells MC. The column array AR1 may include a plurality of memory cells MC vertically stacked in a first direction D1. The memory cells MC in the column array AR1 may share the first conductive line BL. The row array AR2 may include a plurality of memory cells MC horizontally disposed in a third direction D3. The memory cells MC in the row array AR2 may share the second conductive line WL. The first direction D1 may be a vertical direction, and the third direction D3 may be a horizontal direction.

The semiconductor device 100 may include a horizontal arrangement of a plurality of first conductive lines BL and a vertical arrangement of a plurality of second conductive lines WL. A vertical arrangement of the memory cells MC stacked in the first direction D1 may share one first conductive line BL. A horizontal arrangement of the memory cells MC disposed in the third direction D3 may be coupled to different first conductive lines BL. The horizontal arrangement of the memory cells MC disposed in the third direction D3 may share one second conductive line WL. The vertical arrangement of the memory cells MC stacked in the first direction D1 may be coupled to different second conductive lines WL.

The semiconductor device 100 may include a first sub-cell array MCA1 and a second sub-cell array MCA2. The first sub-cell array MCA1 and the second sub-cell array MCA2 may each include a three-dimensional array of the memory cells MC. The first sub-cell array MCA1 and the second sub-cell array MCA2 may share the first conductive line BL. The first conductive line BL may include a first vertical conductive line BLA and a second vertical conductive line BLB. A bottom portion of the first vertical conductive line BLA and a bottom portion of the second vertical conductive line BLB may be merged with each other. The first conductive line BL may have a U shape formed by merging the first vertical conductive line BLA and the second vertical conductive line BLB. The memory cells MC of the first sub-cell array MCA1 may share the first vertical conductive line BLA, and the memory cells MC of the second sub-cell array MCA2 may share the second vertical conductive line BLB. In this way, the first and second sub-cell arrays MCA1 and MCA2 adjacent to each other in a second direction D2 may have a mirror-type structure of sharing the first conductive line BL. From the perspective of a top view, the first and second vertical conductive lines BLA and BLB may each have a rectangular shape.

A first inter-cell dielectric layer IL1 may be disposed between the data storage elements CAP adjacent to each other in the third direction D3. A second inter-cell dielectric layer IL2 may be disposed between the second conductive lines WL vertically stacked in the first direction D1. A third inter-cell dielectric layer IL3 may be disposed between first electrodes SN of the data storage elements CAP vertically stacked in the first direction D1. The first to third inter-cell dielectric layers IL1, IL2 and IL3 may each include silicon oxide, silicon carbon oxide (SiCO), silicon nitride, or a combination thereof. The first inter-cell dielectric layer IL1 may be referred to as a "device isolation layer".

The memory cell array MCA may further include a first contact node BLC and a second contact node SNC. The first contact node BLC may be disposed between the first and second vertical conductive lines BLA and BLB and the nano sheet HL. The first contact node BLC may include a metal-based material or a semiconductive material. For example, the first contact node BLC may include titanium, titanium nitride, tungsten, or a combination thereof. In addition, the first contact node BLC may include doped polysilicon, and a first doped region SR may include an impurity diffused from the first contact node BLC. The second contact node SNC may be disposed between the nano sheet HL and the first electrode SN. The second contact node SNC may include a metal-based material or a semiconductive material. For example, the second contact node SNC may include titanium, titanium nitride, tungsten, or a combination thereof. In addition, the second contact node SNC may include doped polysilicon, and a second doped region DR may include an impurity diffused from the second contact node SNC. A height of the first contact node BLC in the first direction D1 may be less than a height of the second contact node SNC in the first direction D1. The height of the first contact node BLC in the first direction D1 may be greater than a height of the channel CH in the first direction D1. The first and second contact nodes BLC and SNC may each include doped polysilicon, for example, phosphorus-doped polysilicon or arsenic-doped polysilicon.

The memory cell array MCA may further include an ohmic contact layer (refer to reference symbol "BLO" of FIGS. 1A and 1B) between the first contact node BLC and the first conductive line BL. The ohmic contact layer may include metal silicide, such as titanium silicide or molybdenum silicide.

The memory cell array MCA may further include a first spacer SP1 and a second spacer SP2. The first spacer SP1 may be disposed between the second conductive line WL and the second doped region DR. The second spacer SP2 may be disposed between the first conductive line BL and the second conductive line WL. The first and second spacers SP1 and SP2 may each include a dielectric material. The first and second spacers SP1 and SP2 may each include silicon oxide, silicon nitride, or a combination thereof. As described above with reference to FIGS. 2B and 2C, the first and second spacers SP1 and SP2 may extend in the third direction D3 on both sidewalls of the second conductive line WL. The first and second spacers SP1 and SP2 may surround a horizontal arrangement of the nano sheets HL in the third direction D3. In addition, the first spacer SP1 may vertically extend in the first direction D1.

The memory cell array MCA may include a plurality of second conductive lines WL vertically stacked in the first direction D1. The memory cell array MCA may include a plurality of nano sheets HL vertically stacked in the first direction D1. The memory cell array MCA may include a plurality of data storage elements CAP vertically stacked in the first direction D1. The memory cell array MCA may include a plurality of first conductive lines BL spaced apart in the third direction D3. The memory cell array MCA may include a dummy second conductive line WLU disposed at a level higher than an uppermost second conductive line WL and a dummy second conductive line WLL disposed at a level lower than a lowermost second conductive line WL. The dummy second conductive lines WLU and WLL may each have a linear shape extending horizontally.

The memory cell array MCA may include a stack of a plurality of hard mask layers HM1, HM2, HM3 and HM4 disposed at a level higher than the uppermost dummy second conductive line WLU.

The memory cell array MCA may include a plurality of first and second bottom protection layers BT1 and BT2. The first bottom protection layers BT1 may prevent the first conductive lines BL and the lower structure LS from coming into electrical contact with each other. The second bottom protection layers BT2 may prevent the data storage elements CAP and the lower structure LS from coming into electrical contact with each other. The first and second bottom protection layers BT1 and BT2 may each include a dielectric material.

An array isolation layer BLF may be disposed between the first vertical conductive line BLA and the second vertical conductive line BLB of the first conductive line BL. The array isolation layer BLF may include a dielectric material. For example, the array isolation layer BLF may include silicon oxide, silicon nitride, air gap-embedded silicon oxide, or a combination thereof.

The nano sheets HL of the switching elements TR horizontally disposed in the third direction D3 may share one second conductive line WL. The nano sheets HL of the switching elements TR horizontally disposed in the third direction D3 may be coupled to different first conductive lines BL. The switching elements TR stacked in the first direction D1 may share one first conductive line BL. The switching elements TR horizontally disposed in the third direction D3 may share one second conductive line WL.

Second electrodes PN of the data storage elements CAP may be coupled to a common plate PL. The second electrodes PN of the data storage elements CAP may be merged with each other and form a common plate PL.

Referring back to FIGS. 4A, 4B, 4D and 4E, the second conductive lines WL of the memory cell array MCA may be coupled to pads WP1 to WP4, respectively. Each of the pads WP1 to WP4 may be horizontally oriented. Each of the second conductive lines WL may include a different one of edge portions WE each having a concave shape. Each of the pads WP1 to WP4 may include a different one of inner edges PE. The inner edges PE of the pads WP1 to WP4 may each have a convex shape. The inner edges PE of the pads WP1 to WP4 may be disposed in inner spaces of the edge portions WE of the second conductive lines WL. The inner edges PE of the pads WP1 to WP4 may be electrically coupled to the edge portions WE of the second conductive lines WL. The inner edges PE of the pads WP1 to WP4 and the edge portions WE of the second conductive lines WL may contact the first spacer SP1.

The second region R2 may include an alternating stack of the pads WP1 to WP4 and inter-pad dielectric layers PIL and contact plugs CT1 to CT4 having different heights. The contact plugs CT1 to CT4 may be disposed in the alternating stack of the pads WP1 to WP4 and the inter-pad dielectric layers PIL and be laterally spaced apart from each other in a first horizontal direction, i.e., the third direction D3. The contact plugs CT1 to CT4 may have different heights in the first direction D1. Top surfaces of the contact plugs CT1 to CT4 may be disposed in the same horizontal plane, and each of bottom portions of the contact plugs CT1 to CT4 may be adjoined to a different one of the pads WP1 to WP4.

Referring back to FIG. 4D, the first contact plug CT1 may be electrically coupled to the first pad WP1 at a first level LV1 and be electrically coupled to the second conductive line WL at the first level LV1 through the first pad WP1. The second contact plug CT2 may be electrically coupled to the second pad WP2 at a second level L2 and be electrically coupled to the second conductive line WL at the second level LV2 through the second pad WP2. The third contact plug CT3 may be electrically coupled to the third pad WP3 at a third level LV3 and be electrically coupled to the second conductive line WL at the third level LV3 through the third pad WP3. The fourth contact plug CT4 may be electrically coupled to the fourth pad WP4 at a fourth level LV4 and be electrically coupled to the second conductive line WL at the fourth level LV4 through the fourth pad WP4.

A first contact spacer CTS1 may be disposed on sidewalls of the first contact plug CT1, and a second contact spacer CTS2 may be disposed on sidewalls of the second contact plug CT2. A third contact spacer CTS3 may be disposed on sidewalls of the third contact plug CT3, and a fourth contact spacer CTS4 may be disposed on sidewalls of the fourth contact plug CT4. A vertical height of the fourth contact plug CT4 may be greater than a vertical height of the third contact plug CT3, and the vertical height of the third contact plug CT3 may be greater than a vertical height of the second contact plug CT2. The vertical height of the second contact plug CT2 may be greater than a vertical height of the first contact plug CT1. The vertical heights may refer to heights in the first direction D1.

The fourth contact plug CT4 and the fourth contact spacer CTS4 may penetrate the pads WP1, WP2 and WP3 at the first level LV1, the second level LV2 and the third level LV3. The fourth contact plug CT4 may be electrically isolated from the pads WP1, WP2 and WP3 at the first level LV1, the second level LV2 and the third level LV3 by the fourth contact spacer CTS4.

The third contact plug CT3 and the third contact spacer CTS3 may penetrate the pads WP1 and WP2 at the first level LV1 and the second level LV2. The third contact plug CT3 may be electrically isolated from the pads WP1 and WP2 at the first level LV1 and the second level LV2 by the third contact spacer CTS3.

The second contact plug CT2 and the second contact spacer CTS2 may penetrate the pad WP1 at the first level LV1. The second contact plug CT2 may be electrically isolated from the pad WP1 at the first level LV1 by the second contact spacer CTS2.

The first pad WP1 may surround side surfaces of the second to fourth contact plugs CT2, CT3 and CT4. The second pad WP2 may surround the side surfaces of the third and fourth contact plugs CT3 and CT4. The third pad WP3 may surround the side surface of the fourth contact plug CT4.

The first pad WP1 may directly contact a bottom surface of the first contact plug CT1. The second pad WP2 may directly contact a bottom surface of the second contact plug CT2. The third pad WP3 may directly contact a bottom surface of the third contact plug CT3. The fourth pad WP4 may directly contact a bottom surface of the fourth contact plug CT4.

At the same horizontal level, the second conductive lines WL of the first sub-cell array MCA1 and the second conductive lines WL of the second sub-cell array MCA2 may share the pads WP1 to WP4 at the respective levels. For example, the second pad WP2 may be coupled in common to the second conductive line WL of the first sub-cell array MCA1 and the second conductive line WL of the second sub-cell array MCA2.

As described above, the pads WP1 to WP4 of the second region R2 may have a stair-less structure. Because the pads WP1 to WP4 are formed with the stair-less structure, an occupied area or volume of the pads WP1 to WP4 in the second region R2 may be reduced. In a comparative example, when the pads WP1 to WP4 are formed with a stair structure, the second region R2 may include the pads WP1 to WP4 having the stair structure, and accordingly, an occupied area of the second region R2 may increase.

The contact spacers CTS1 to CTS4 may each include a dielectric material. The contact spacers CTS1 to CTS4 may each include silicon oxide, silicon nitride, or a combination thereof. In some embodiments, the contact spacers CTS1 to CTS4 may each include a low-k material having a dielectric constant of 4 or less, for example, 2.0 to 3.5. The contact spacers CTS1 to CTS4 may each include SiCOH (carbon doped dielectric materials (or carbon doped oxide dielectrics) including silicon (Si), carbon (C), oxygen (O), and hydrogen (H)), silicon oxyfluoride (SiOF), or a combination thereof. A dielectric constant of SiCOH may be approximately 3, which is lower than a dielectric constant of SiCO. The dielectric constant of SiCO may be approximately 4. The contact spacers CTS1 to CTS4 may each have a lower dielectric constant than silicon oxide (SiO₂) and SiCO.

The inter-pad dielectric layers PIL may be disposed between the pads WP1 to WP4. The inter-pad dielectric layers PIL may each include a dielectric material. The inter-pad dielectric layers PIL may each include silicon oxide, silicon nitride, or a combination thereof. In some embodiments, the inter-pad dielectric layers PIL may include a low-k material having a dielectric constant of 4 or less, for example, 2.0 to 3.5. The inter-pad dielectric layers PIL may each include SiCOH, SiOF, or a combination thereof. A dielectric constant of SiCOH may be approximately 3, which is lower than a dielectric constant of SiCO. The dielectric constant of SiCO may be approximately 4. The inter-pad dielectric layers PIL may each have a lower dielectric constant than silicon oxide (SiO₂) and SiCO.

Referring back to FIG. 4E, outer edges of the pads WP1 to WP4 may contact a pad isolation layer WSL. The pad isolation layer WSL may include a stack of a first pad isolation layer WSL1, a second pad isolation layer WSL2 and a third pad isolation layer WSL3. The stack of the first pad isolation layer WSL1 and the second pad isolation layer WSL2 may be a lower pad isolation layer. A dummy sheet DP may be disposed between the first pad isolation layer WSL1 and the inter-pad dielectric layers PIL. The dummy sheet DP may be the same material as the nano sheets HL.

As described above, the semiconductor device 100 may include the vertical and horizontal arrangements of the nano sheets HL, the second conductive lines WL oriented horizontally while surrounding the horizontal arrangement of the nano sheets HL, the pads WP1 to WP4 coupled to the edge portions of the second conductive lines WL, the inter-pad dielectric layers PIL disposed between the pads WP1 to WP4, the contact plugs CT1 to CT4 each coupled to a different one of the pads WP1 to WP4, and the contact spacers CTS1 to CTS4 formed on the sidewalls of the contact plugs CT1 to CT4, respectively. The contact spacers CTS1 to CTS4 may each include a low-k material. The inter-pad dielectric layers PIL may each include a low-k material.

Because the contact spacers CTS1 to CTS4 each include a low-k material, parasitic capacitance with the pads WP1 to WP3 surrounding the contact plugs CT2 to CT4 may be reduced. Consequently, because the contact spacers CTS1 to CTS4 each include a low-k material, the speed of the semiconductor device 100 may increase, and power consumption may be reduced.

FIGS. 5A to 34B illustrate various views of a semiconductor device formed utilizing a method for fabricating the semiconductor device in accordance with an embodiment of the present disclosure.

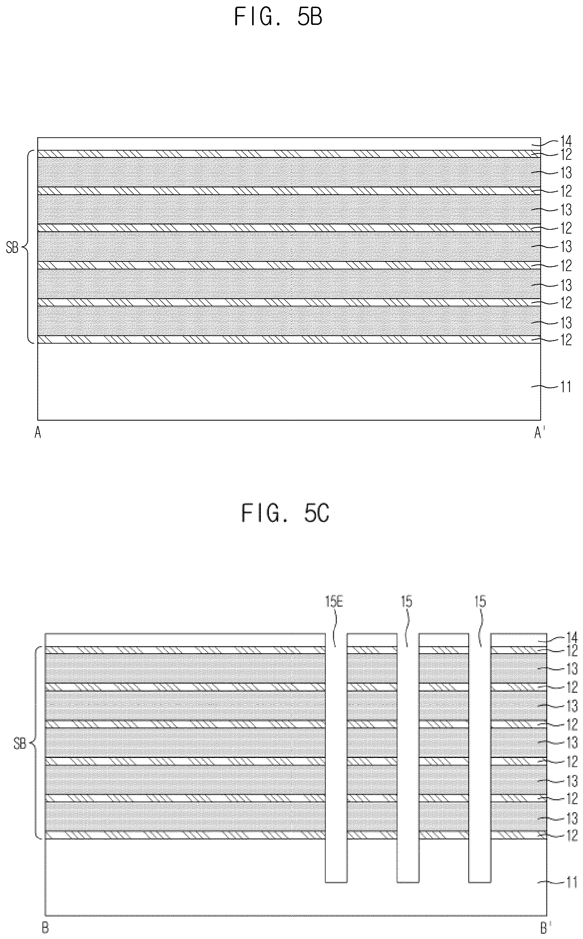

FIG. 5A is a plan view illustrating a structure at a second mold layer level to describe a method for forming a mold stack SB. FIG. 5B is a cross-sectional view of the structure taken along line A-A' illustrated in FIG. 5A. FIG. 5C is a cross-sectional view of the structure taken along line B-B' illustrated in FIG. 5A.

Referring to FIGS. 5A to 5C, the mold stack SB may be formed on a substrate 11. The mold stack SB may include an alternating stack of first mold layers 12 and second mold layers 13. The mold stack SB may be formed in each of a first region R1 and a second region R2. The first region R1 may be a region in which a three-dimensional array of memory cells is formed, and the second region R2 may be a region in which pads coupled to the memory cells and contact plugs are formed. The first region R1 may be referred to as an "array region", and the second region R2 may be referred to as a "pad region" or a "connection region". The second region R2 may also be referred to as a "sharing connection region", a "sharing contact region", or a "common contact region".

The substrate 11 may be a material appropriate for semiconductor processing. The substrate 11 may include a semiconductor substrate, a conductive material, a dielectric material, a semiconductive material, or a combination thereof. The substrate 11 may include silicon, monocrystalline silicon, polysilicon, amorphous silicon, silicon germanium, monocrystalline silicon germanium, polycrystalline silicon germanium, carbon-doped silicon, epitaxial silicon, a combination thereof, or multilayers thereof. The substrate 11 may also include another semiconductor material such as germanium. The substrate 11 may also include a III-V group semiconductor substrate, for example, a compound semiconductor substrate such as GaAs. The mold stack SB may include an alternating stack of the first mold layers 12 and the second mold layers 13.

To form the mold stack SB, the first mold layers 12 may be alternately stacked with the second mold layers 13, and the first mold layers 12 and the second mold layers 13 may be epitaxially grown multiple times.

The first mold layers 12 and the second mold layers 13 may be different semiconductive materials. The first mold layers 12 may each include silicon germanium or monocrystalline silicon germanium. The second mold layers 13 may each include monocrystalline silicon. The first mold layers 12 and the second mold layers 13 may be formed by an epitaxial growth process. A lowermost first mold layer 12 may serve as a seed layer during the epitaxial growth process. Each of the first mold layers 12 may be thinner than each of the second mold layers 13. The first mold layers 12 may include first epitaxially grown layers, and the second mold layers 13 may include second epitaxially grown layers.

In an embodiment, a plurality of monocrystalline silicon germanium layers may be alternately stacked with a plurality of monocrystalline silicon layers in the mold stack SB. For example, the first mold layers 12 may be the monocrystalline silicon germanium layers, and the second mold layers 13 may be the monocrystalline silicon layers. A stack of a monocrystalline silicon germanium layer (first mold layers 12) and a monocrystalline silicon layer (a SiGe/Si stack) (second mold layers 13) may be stacked multiple times (for example, in alternating layers). The first mold layers 12 may be referred to as "sacrificial layers", and the second mold layers 13 may be referred to as "nano sheet target layers" or "recess target layers".

The mold stack SB may be referred to as a "vertical stack". The mold stack SB may be formed by alternately stacking a plurality of sacrificial layers and a plurality of nano sheet target layers. The sacrificial layers may be monocrystalline silicon germanium layers, and the nano sheet target layers may be monocrystalline silicon layers.

A thickness ratio of the first mold layers 12 and a thickness ratio of the second mold layers 13 in the mold stack SB may be variously modified. For example, the thickness of the first mold layers 12 may be 5 to 20 nm, and the thickness of the second mold layers 13 may be 50 to 80 nm. A quantity of the first mold layers 12 and a quantity of the second mold layers 13 in the mold stack SB may be variously modified. In some embodiments, a triple stack including the first mold layer 12, the second mold layer 13 and the first mold layer 12 may be defined at lowermost and uppermost portions of the mold stack SB. The second mold layer 13 of the triple stack may have a thickness less than the second mold layers 13 of the mold stack SB.

A first hard mask layer 14 may be formed on the mold stack SB. The first hard mask layer 14 may include a dielectric material such as an oxide-based material, a nitridebased material, a carbon-based material, or a combination thereof. For example, the first hard mask layer 14 may include SiO₂, Si₃N₄, amorphous carbon, or a combination thereof.

Subsequently, portions of the mold stack SB may be etched using the first hard mask layer 14 as a barrier, and a plurality of sacrificial isolation openings 15 may be formed. The sacrificial isolation openings 15 may be initial openings for cell isolation. From the perspective of a top view, cross-sections of the sacrificial isolation openings 15 may each have a rectangular shape. In some embodiments, the cross-sections of the sacrificial isolation openings 15 may each have a circular shape or an oval shape. In some embodiments, the sacrificial isolation openings 15 may be referred to as "sacrificial isolation trenches". The sacrificial isolation openings 15 may vertically extend in a first direction D1 and extend lengthwise in a second direction D2. The sacrificial isolation openings 15 may be disposed at a predetermined interval in a third direction D3. A bottom surface of each of the sacrificial isolation openings 15 may extend inside of the substrate 11.

The sacrificial isolation openings 15 may be formed in the first region R1. Edge sacrificial isolation openings 15E may be formed while the sacrificial isolation openings 15 are formed. The edge sacrificial isolation openings 15E may be formed at a boundary portion between the first region R1 and the second region R2. A length of each of the edge sacrificial isolation openings 15E in the second direction D2 may be greater than a length of each of the sacrificial isolation openings 15.

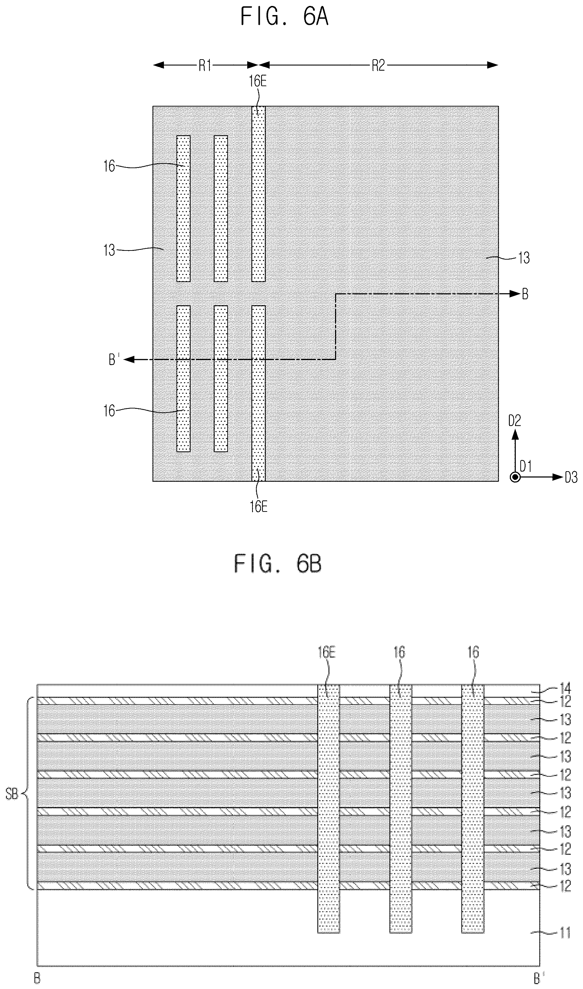

FIG. 6A is a plan view illustrating the structure at the second mold layer level to describe a method for forming sacrificial isolation layers 16. FIG. 6B is a cross-sectional view of the structure taken along line B-B' illustrated in FIG. 6A.

Referring to FIGS. 6A and 6B, the sacrificial isolation layers 16 may be formed to fill the sacrificial isolation openings 15. The sacrificial isolation layers 16 may include the same material. The sacrificial isolation layers 16 may be each formed of a dielectric material. The sacrificial isolation layers 16 may have an etch selectivity with respect to the mold stack SB. For example, the sacrificial isolation layers 16 may each include silicon oxide, silicon nitride, silicon carbon oxide, silicon carbon nitride, or a combination thereof. Forming the sacrificial isolation layers 16 may include forming sacrificial isolation materials on the mold stack SB to fill the sacrificial isolation openings 15 and planarizing the sacrificial isolation materials so that a surface of the first hard mask layer 14 is exposed.

The sacrificial isolation layers 16 may vertically extend in the first direction D1 and extend lengthwise in the second direction D2. The sacrificial isolation layers 16 may be disposed at a predetermined interval in the third direction D3. Each of the sacrificial isolation layers 16 may include a stack of a first sacrificial liner layer and a first sacrificial gap-fill layer. The first sacrificial liner layer may be silicon nitride, and the first sacrificial gap-fill layer may be silicon oxide. The sacrificial isolation layers 16 may penetrate the mold stack SB in the first direction D1.

The sacrificial isolation layers 16 may be formed in the first region R1. Edge sacrificial isolation layers 16E may be formed while the sacrificial isolation layers 16 are formed. The edge sacrificial isolation layers 16E may be formed at the boundary portion between the first region R1 and the second region R2. A length of each of the edge sacrificial isolation layers 16E in the second direction D2 may be greater than a length of each of the sacrificial isolation layers 16.

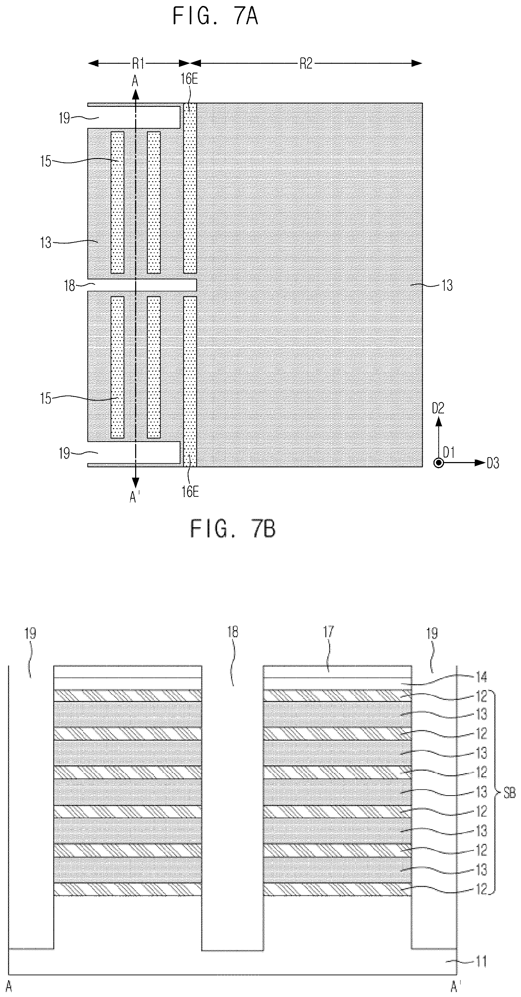

FIG. 7A is a plan view illustrating the structure at the second mold layer level to describe a method for forming sacrificial linear openings 18 and 19. FIG. 7B is a cross-sectional view of the structure taken along line A-A' illustrated in FIG. 7A.

Referring to FIGS. 7A and 7B, a second hard mask layer 17 may be formed on the mold stack SB and the sacrificial isolation layers 16. The second hard mask layer 17 may include silicon nitride. The second hard mask layer 17 may be formed by etching a second hard mask material using a mask layer such as photoresist. The second hard mask layer 17 may have a plurality of line-shaped openings defined therein.

Portions of the mold stack SB may be etched using the second hard mask layer 17 as an etch barrier. Accordingly, a plurality of sacrificial linear openings 18 and 19 may be formed between the sacrificial isolation layers 16. The sacrificial linear openings may include a first sacrificial linear opening 18 and a second sacrificial linear opening 19. From the perspective of a top view, the first sacrificial linear opening 18 and the second sacrificial linear opening 19 may be line-shaped openings extending in the third direction D3. The first sacrificial linear opening 18 and the second sacrificial linear opening 19 may vertically extend in the first direction D1. The sacrificial isolation layers 16 may be disposed between the first sacrificial linear opening 18 and the second sacrificial linear opening 19 in the second direction D2. From the perspective of a top view, cross sections of the first and second sacrificial linear openings 18 and 19 may each have a rectangular shape. In some embodiments, the cross sections of the first and second sacrificial linear openings 18 and 19 may each have a circular shape or an oval shape. The first and second sacrificial linear openings 18 and 19 may each have a width in the second direction D2 which is less than a width in the third direction D3. The first and second sacrificial linear openings 18 and 19 may be referred to as "sacrificial linear trenches". The sacrificial isolation layers 16 may not contact the first and second sacrificial linear openings 18 and 19. The first sacrificial linear opening 18 and the second sacrificial linear opening 19 may have different horizontal lengths in the third direction D3.

The first and second sacrificial linear openings 18 and 19 may be formed in the first region R1. One end of the first sacrificial linear opening 18 may extend to be disposed between the edge sacrificial isolation layers 16E.

Hereinafter, the thicknesses of the first mold layers 12 and the second mold layers 13 in the cross-sectional view of the structure taken along line A-A' are described. The thicknesses of the first mold layers 12 in the cross-sectional view of the structure taken along line A-A' may be equal to the thicknesses of the first mold layers 12 in the cross-sectional view of the structure taken along line B-B'. The thicknesses of the second mold layers 13 in the cross-sectional view of the structure taken along line A-A' may be equal to the thicknesses of the second mold layers 13 in the cross-sectional view of the structure taken along line B-B'.

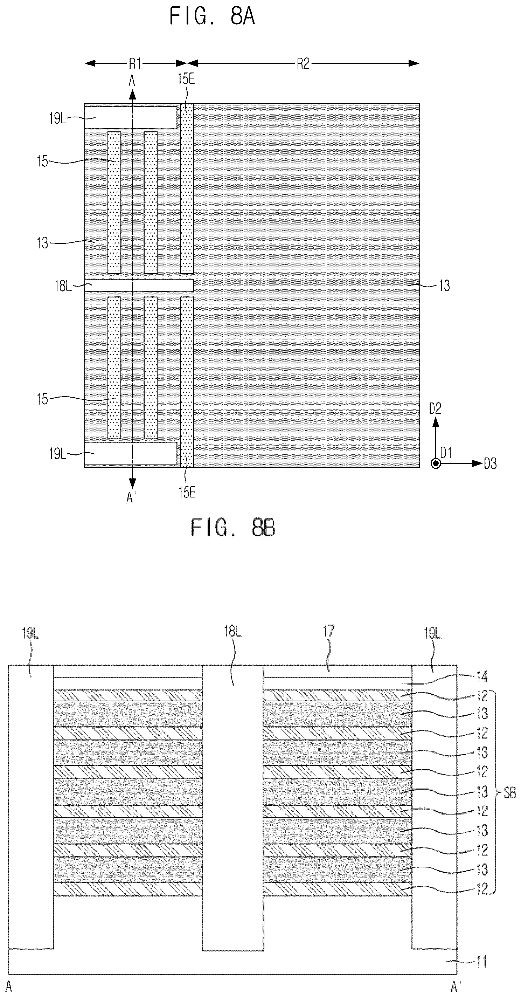

FIG. 8A is a plan view illustrating the structure at the second mold layer level to describe a method for forming linear sacrificial layers 18L and 19L. FIG. 8B is a cross-sectional view of the structure taken along line A-A' illustrated in FIG. 8A.

Referring to FIGS. 8A and 8B, the linear sacrificial layers 18L and 19L may be formed to fill the first and second sacrificial linear openings 18 and 19. The linear sacrificial layers may include a first linear sacrificial layer 18L and a second linear sacrificial layer 19L. From the perspective of a top view, the first linear sacrificial layer 18L and the second linear sacrificial layer 19L may have line shapes extending in the third direction D3. The first linear sacrificial layer 18L and the second linear sacrificial layer 19L may vertically extend in the first direction D1. The sacrificial isolation layers 16 may be disposed between the first linear sacrificial layer 18L and the second linear sacrificial layer 19L in the second direction D2. From the perspective of a top view, cross sections of the first and second linear sacrificial layers 18L and 19L may each have a rectangular shape. In some embodiments, the cross-sections of the first and second linear sacrificial layers 18L and 19L may each have a circular shape or an oval shape. The first and second linear sacrificial layers 18L and 19L may include the same material. The first and second linear sacrificial layers 18L and 19L may each be formed of a dielectric material. For example, the first and second linear sacrificial layers 18L and 19L may each include silicon oxide, silicon nitride, silicon carbon oxide, silicon carbon nitride, or a combination thereof. The sacrificial isolation layers 16 may not contact the first and second linear sacrificial layers 18L and 19L.

The first and second linear sacrificial layers 18L and 19L may be formed in the first region R1. One end of the first linear sacrificial layer 18L may extend to be disposed between the edge sacrificial isolation layers 16E.

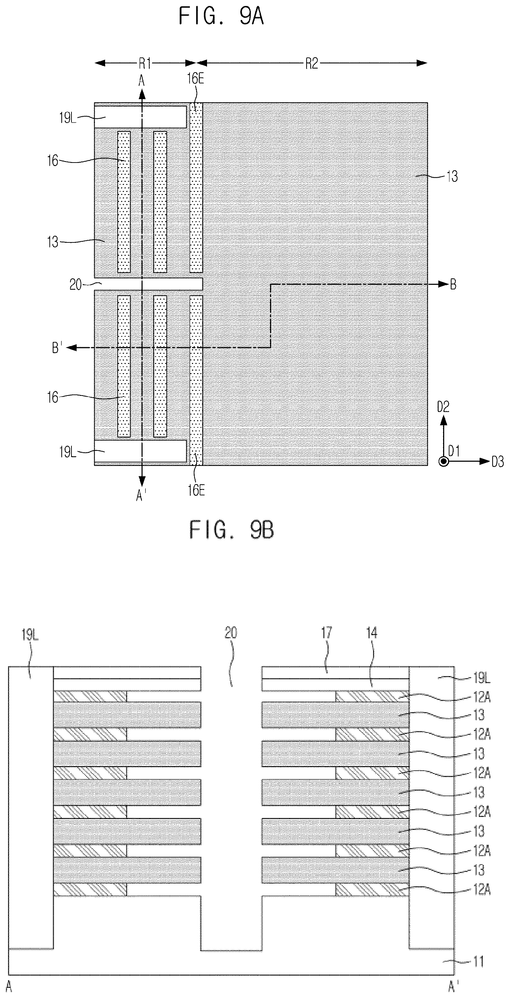

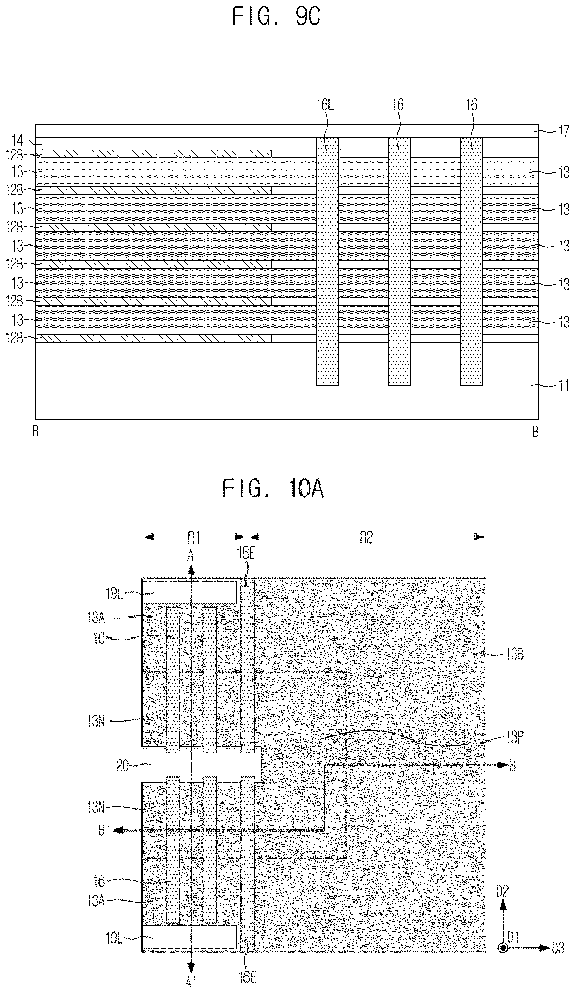

FIG. 9A is a plan view illustrating the structure at the second mold layer level to describe recessing of the first mold layers 12. FIG. 9B is a cross-sectional view of the structure taken along line A-A' illustrated in FIG. 9A. FIG. 9C is a cross-sectional view of the structure taken along line B-B' illustrated in FIG. 9A.

Referring to FIGS. 9A to 9C, among the first linear sacrificial layer 18L and the second linear sacrificial layer 19L, the first linear sacrificial layer 18L may be selectively removed. Accordingly, a first linear opening 20 may be formed. From the perspective of a top view, the first linear opening 20 may be disposed horizontally spaced apart from the second linear sacrificial layer 19L in the second direction D2.

The first mold layers 12 may be selectively recessed through the first linear opening 20.

A difference in etch selectivity between the first mold layers 12 and the second mold layers 13 may be used to selectively recess the first mold layers 12. The first mold layers 12 may be removed using a wet etch process or a dry etch process. For example, when the first mold layers 12 include silicon germanium layers, and the second mold layers 13 include monocrystalline silicon layers, the silicon germanium layers may be etched using an etchant or etch gas having a selectivity with respect to the monocrystalline silicon layers. The first mold layers each having an original thickness may remain as indicated by reference numeral "12A". The first mold layers 12A may remain in the first region R1, and pad-side first mold layers 12B may remain in the second region R2.

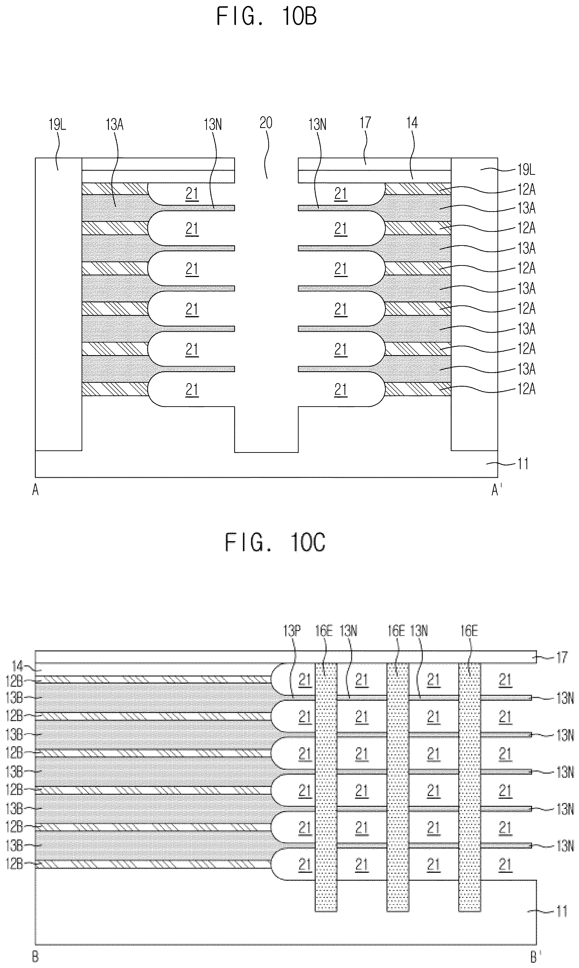

FIG. 10A is a plan view illustrating the structure at the second mold layer level to describe recessing of the second mold layers 13. FIG. 10B is a cross-sectional view of the structure taken along line A-A' illustrated in FIG. 10A. FIG. 10C is a cross-sectional view of the structure taken along line B-B' illustrated in FIG. 10A.

Referring to FIGS. 10A to 10C, a portion (a first portion) of each of the second mold layers 13 may be recessed to form a narrow sheet 13N. The wet etch process or dry etch process may be used to recess the second mold layers 13. An original body portion 13A and the narrow sheet 13N may be formed by the partial recessing of each of the second mold layers 13. The original body portion 13A may maintain an original thickness, and the narrow sheet 13N may have a thickness less than the original thickness. A horizontal length of the original body portion 13A in the second direction D2 may be equal to or different from a horizontal length of the narrow sheet 13N in the second direction D2. A combination of the original body portion 13A and the narrow sheet 13N may be referred to as a "preliminary active layer". The narrow sheet 13N may be referred to as a "flat plate-shaped sheet" or a "protruding narrow sheet".

A recess process for forming the narrow sheet 13N may be referred to as a "thinning process" or "trimming process" of the second mold layer 13. To form the narrow sheet 13N, an upper surface, lower surface and side surface of the second mold layer 13 may be recessed. The narrow sheet 13N may be referred to as a "thin-body active layer". The narrow sheet 13N may include a monocrystalline silicon layer. The recess process for forming the narrow sheet 13N may use, for example, Hot SC-1 (HSC1). The HSC1 may include a solution in which ammonium hydroxide (NH₄OH), hydrogen peroxide (H₂O₂) and water (H₂O) are mixed in a ratio of 1:4:20. Using the HSC1, the second mold layers 13 may be selectively etched.

The narrow sheets 13N may be formed by the partial recess process for the second mold layers 13 as described above. An inter-nano sheet recess 21 may be formed between the narrow sheets 13N that are vertically disposed. Upper and lower surfaces of each of the narrow sheets 13N may each include a flat surface. A boundary portion between the original body portion 13A and the narrow sheet 13N may be vertical or have a curvature. Each of the first mold layers 12A may be disposed between the original body portions 13A that are vertically stacked.

The narrow sheets 13N may be formed in the first region R1, and pad-side narrow sheets 13P may be formed in the second region R2 while the narrow sheets 13N are formed.

The original body portions 13A may remain in the first region R1, and pad-side second mold layers 13B may remain in the second region R2.

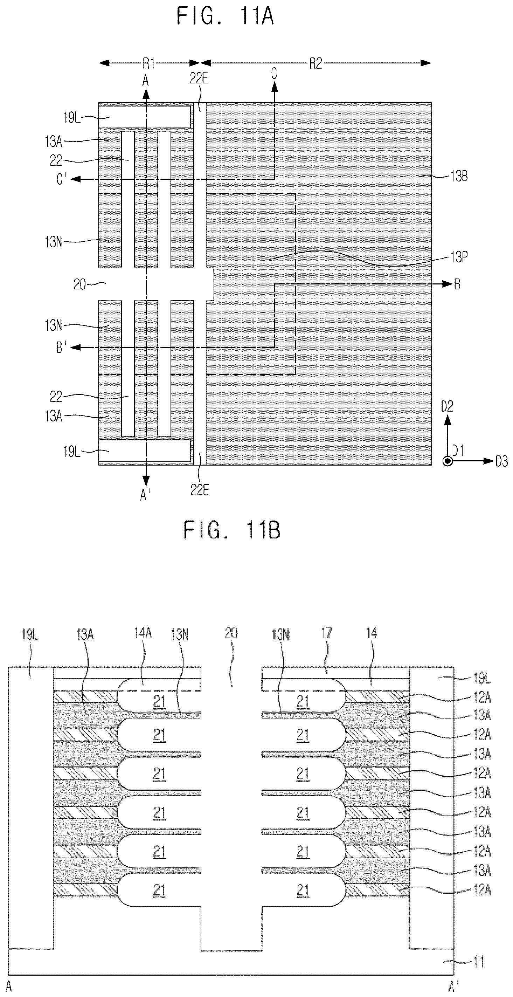

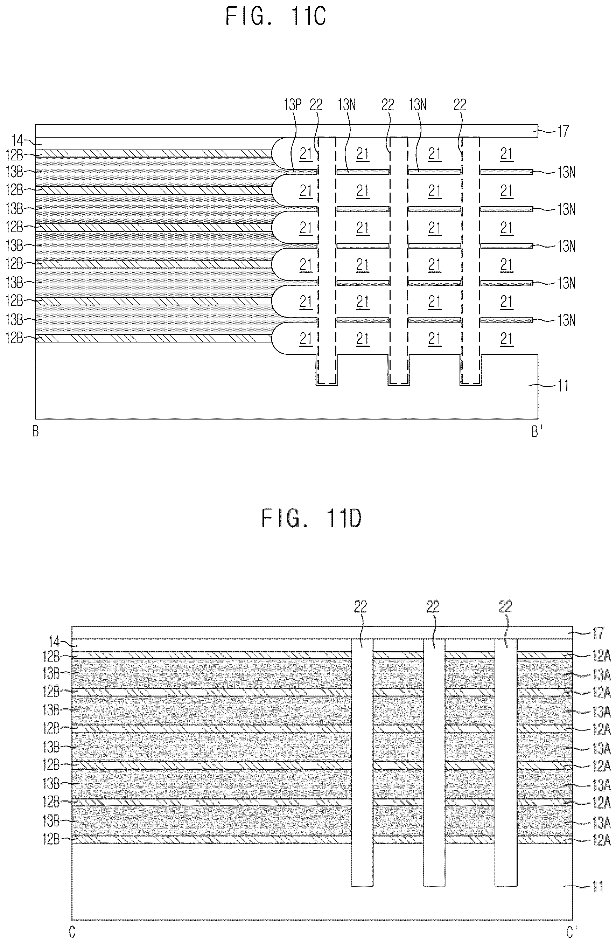

FIG. 11A is a plan view illustrating the structure at a narrow sheet level to describe a method for forming sacrificial isolation layer-level openings 22. FIG. 11B is a cross-sectional view of the structure taken along line A-A' illustrated in FIG. 11A. FIG. 11C is a cross-sectional view of the structure taken along line B-B' illustrated in FIG. 11A. FIG. 11D is a cross-sectional view of the structure taken along line C-C' illustrated in FIG. 11A.

Referring to FIGS. 11A to 11D, the sacrificial isolation layers 16 may be selectively stripped through the inter-nano sheet recesses 21. Accordingly, each of the sacrificial isolation layer-level openings 22 may be formed between the original body portions 13A in the third direction D3.

Side surfaces of the first mold layers 12A, side surfaces of the original body portions 13A and side surfaces of the narrow sheets 13N may be exposed in the third direction D3 by the sacrificial isolation layer-level openings 22.

While the sacrificial isolation layer-level openings 22 are formed, a portion of the first hard mask layer 14 (refer to reference numeral "14A" of FIG. 11B) may be recessed. Accordingly, a space of an uppermost inter-nano sheet recess 21 may be expanded.

While the sacrificial isolation layer-level openings 22 are formed, the edge sacrificial isolation layers 16E may be removed. Accordingly, edge sacrificial isolation layer-level openings 22E may be formed.

The sacrificial isolation layer-level openings 22 may be formed in the first region R1.

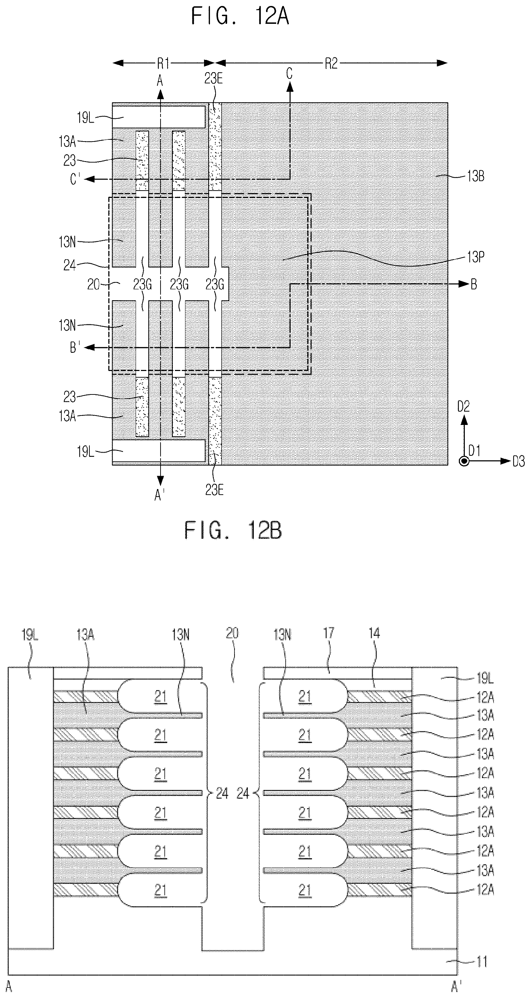

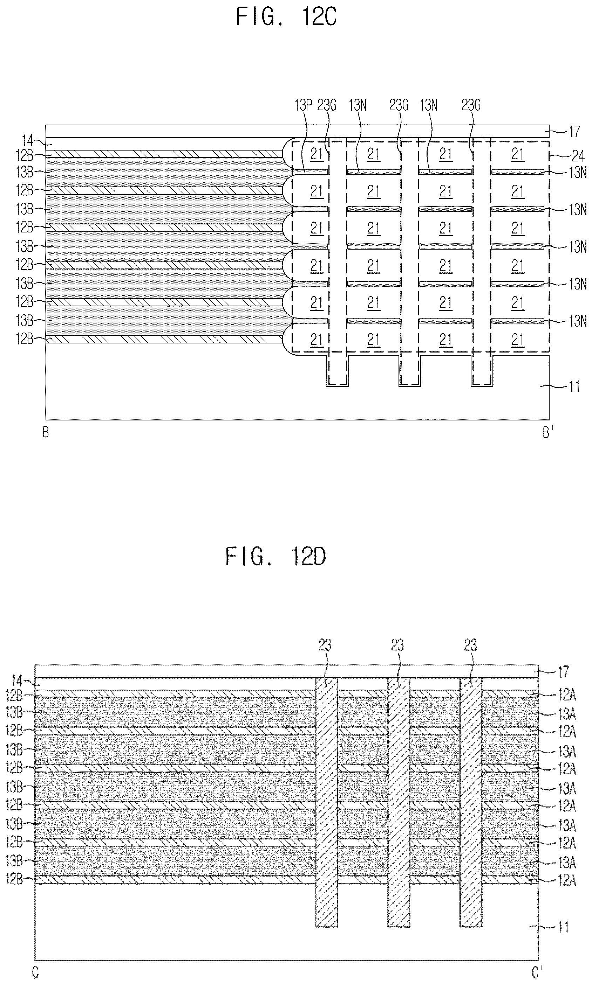

FIG. 12A is a plan view illustrating the structure at the narrow sheet level to describe a method for forming first inter-cell dielectric layers 23. FIG. 12B is a cross-sectional view of the structure taken along line A-A' illustrated in FIG. 12A. FIG. 12C is a cross-sectional view of the structure taken along line B-B' illustrated in FIG. 12A. FIG. 12D is a cross-sectional view of the structure taken along line C-C' illustrated in FIG. 12A.

Referring to FIGS. 12A to 12D, the first inter-cell dielectric layers 23 may be formed in the sacrificial isolation layer-level openings 22. The first inter-cell dielectric layers 23 may each include a dielectric material. The first inter-cell dielectric layers 23 may each include silicon oxide, silicon nitride, silicon carbon oxide, or a combination thereof. Forming the first inter-cell dielectric layers 23 may include forming a dielectric material that fills the sacrificial isolation layer-level openings 22 and performing an etch-back process on the dielectric material. While the first inter-cell dielectric layers 23 are formed, edge inter-cell dielectric layers 23E may be formed to fill the edge sacrificial isolation layer-level openings 22E.

The first inter-cell dielectric layers 23 may fill portions of the sacrificial isolation layer-level openings 22. The side surfaces of the first mold layers 12A and the side surfaces of the original body portions 13A may be covered by the first inter-cell dielectric layers 23 in the third direction D3. The first inter-cell dielectric layers 23 may expose the side surfaces of the narrow sheets 13N. The other portions of the sacrificial isolation layer-level openings 22, i.e., non-gap-filled portions 23G, may expose the side surfaces of the narrow sheets 13N. The non-gap-filled portions 23G may be defined between the narrow sheets 13N in the third direction D3. The first inter-cell dielectric layers 23 may be formed in the first region R1.

After the first inter-cell dielectric layers 23 are formed, a nano sheet all-open recess 24 that opens all of the narrow sheets 13N may be formed. The nano sheet all-open recess 24 may refer to a combination of the inter-nano sheet recesses 21 and the non-gap-filled portions 23G of the sacrificial isolation layer-level openings 22. The nano sheet all-open recess 24 may expose all of the narrow sheets 13N in the third direction D3.

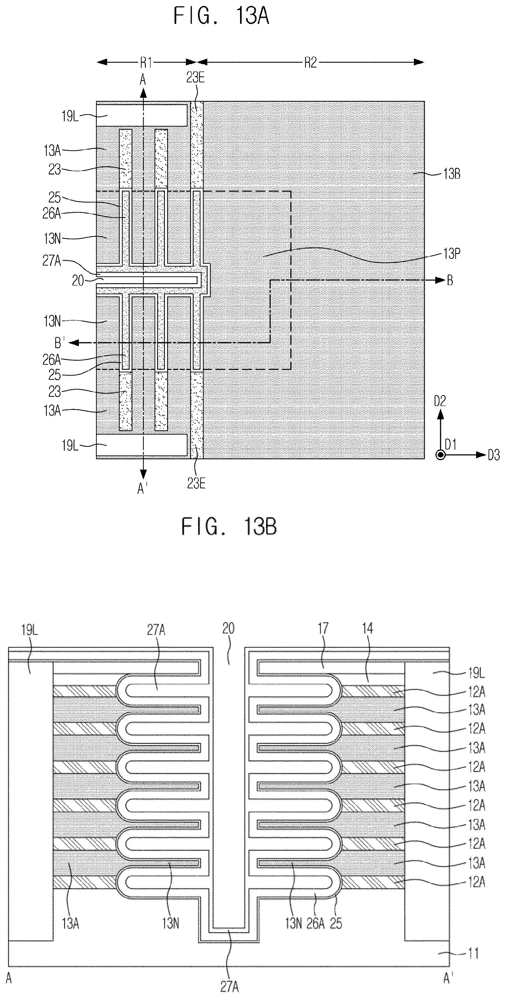

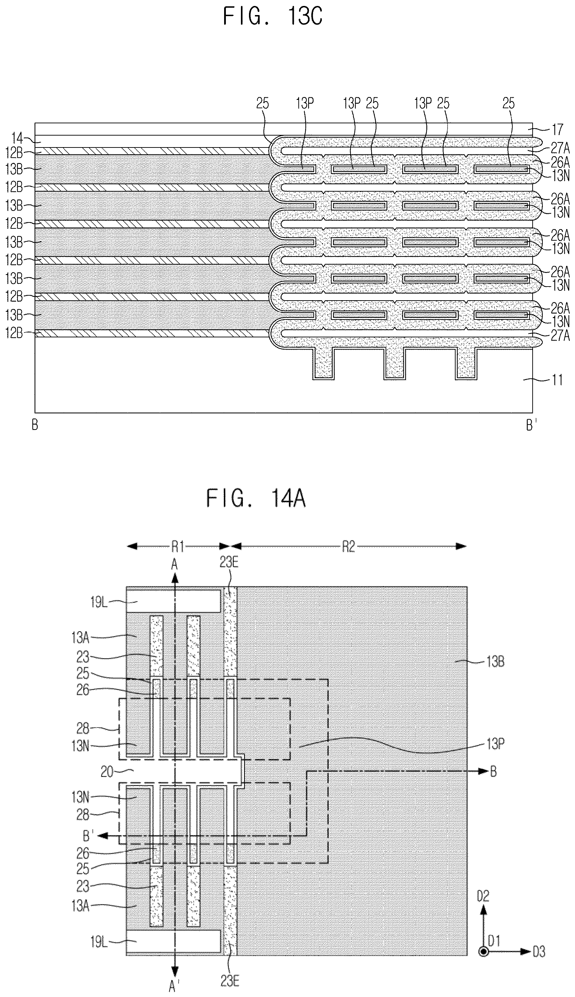

FIG. 13A is a plan view illustrating the structure at the narrow sheet level to describe a method for forming a first spacer layer 26A. FIG. 13B is a cross-sectional view of the structure taken along line A-A' illustrated in FIG. 13A. FIG. 13C is a cross-sectional view of the structure taken along line B-B' illustrated in FIG. 13A.

Referring to FIGS. 13A to 13C, a nano sheet dielectric layer 25 may be formed on exposed portions of the narrow sheets 13N. The nano sheet dielectric layer 25 may be referred to as a "gate dielectric layer".

The nano sheet dielectric layer 25 may be formed by oxidizing the surfaces of the narrow sheets 13N. In some embodiments, the nano sheet dielectric layer 25 may be formed by deposition and oxidation processes of silicon oxide. The nano sheet dielectric layer 25 may include silicon oxide, silicon nitride, metal oxide, metal oxynitride, metal silicate, a high-k material, a ferroelectric material, an anti-ferroelectric material, or a combination thereof. The nano sheet dielectric layer 25 may include SiO₂, Si₃N₄, HfO₂, Al₂O₃, ZrO₂, AlON, HfON, HfSiO, HfSiON, or a combination thereof. The nano sheet dielectric layer 25 may be formed on all surfaces of the narrow sheets 13N.

The first spacer layer 26A may be formed on the nano sheet dielectric layer 25. The first spacer layer 26A may include silicon nitride. The first spacer layer 26A may surround and cover the narrow sheets 13N on the nano sheet dielectric layer 25. The first spacer layer 26A may be thicker than the nano sheet dielectric layer 25.

Second inter-cell dielectric layers 27A may be formed on the first spacer layer 26A. The second inter-cell dielectric layers 27A may each include silicon oxide.

The nano sheet dielectric layer 25 and the first spacer layer 26A may also be formed on the surface of the substrate 11.

As described above, the first spacer layer 26A may be disposed between the narrow sheets 13N in the third direction D3.

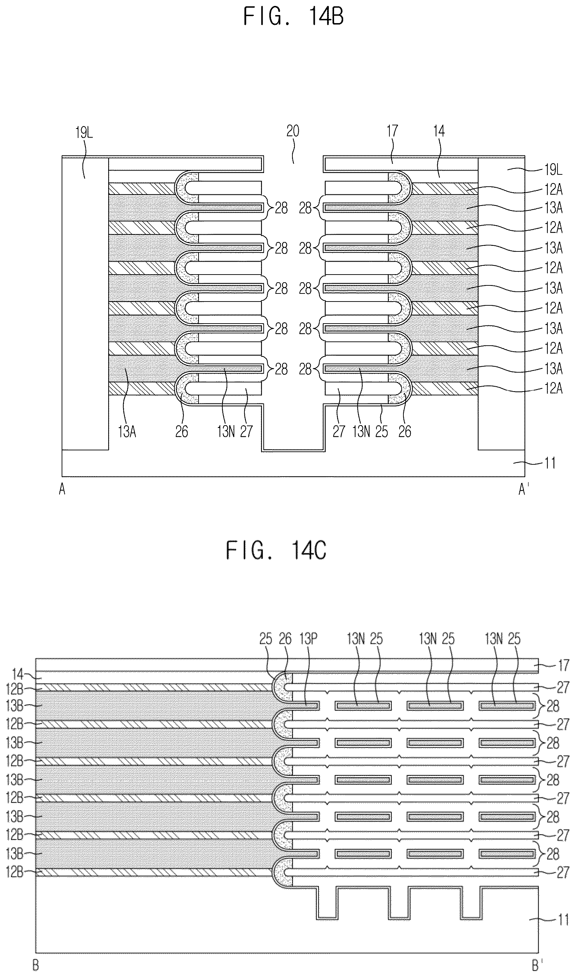

FIG. 14A is a plan view illustrating the structure at the narrow sheet level to describe a method for forming first spacers 26. FIG. 14B is a cross-sectional view of the structure taken along line A-A' illustrated in FIG. 14A. FIG. 14C is a cross-sectional view of the structure taken along line B-B' illustrated in FIG. 14A.

Referring to FIGS. 14A to 14C, the second inter-cell dielectric layers 27A may be cut through the first linear opening 20. Subsequently, the first spacer layer 26A may be selectively recessed. The remaining first spacer layers may become the first spacers 26, and the second inter-cell dielectric layers may remain as indicated by reference numeral "27".

As the first spacers 26 are formed, linear surrounding recesses 28 surrounding the narrow sheets 13N may be formed on the nano sheet dielectric layer 25. Each of the second inter-cell dielectric layers 27 may be disposed between the linear surrounding recesses 28 that are vertically disposed.

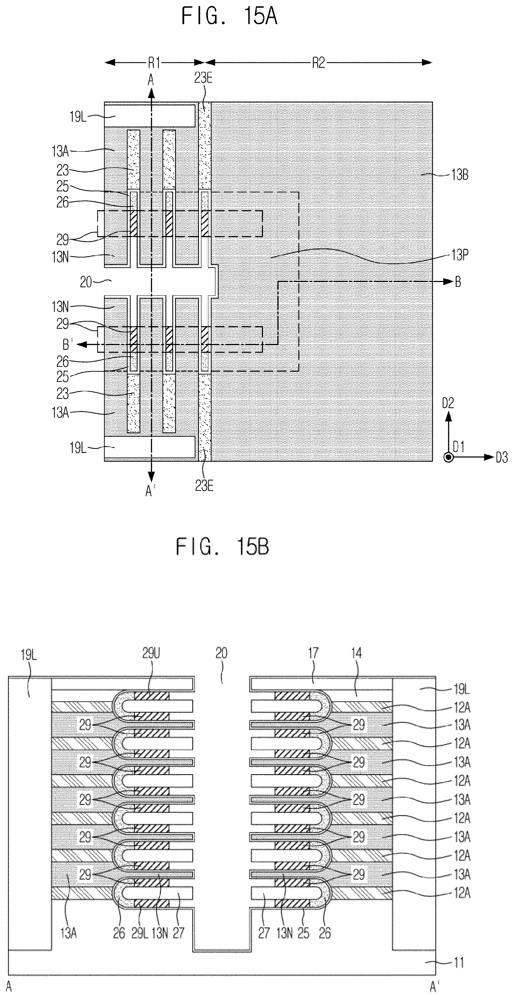

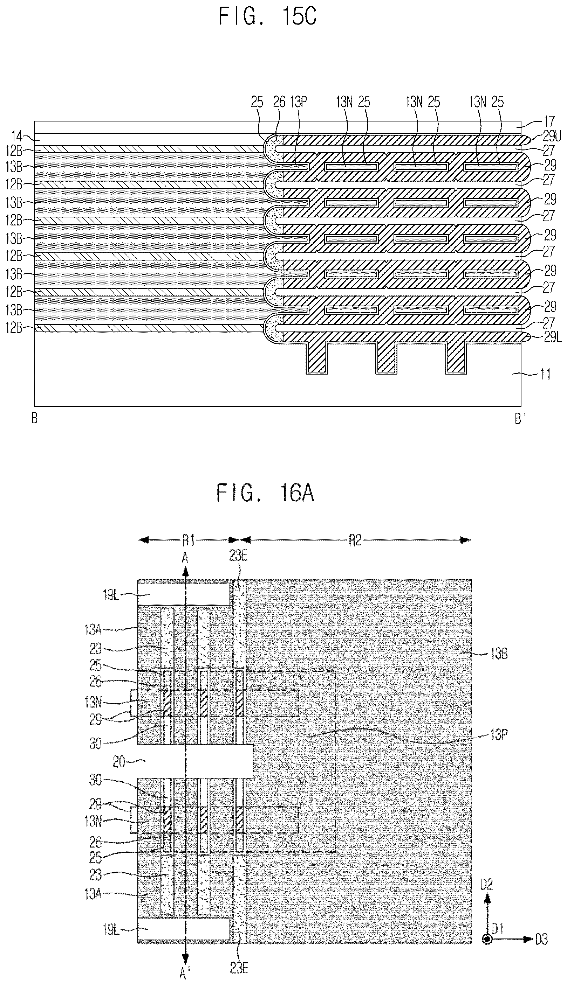

FIG. 15A is a plan view illustrating the structure at the narrow sheet level to describe a method for forming horizontal conductive lines 29. FIG. 15B is a cross-sectional view of the structure taken along line A-A' illustrated in FIG. 15A. FIG. 15C is a cross-sectional view of the structure taken along line B-B' illustrated in FIG. 15A.

Referring to FIGS. 15A to 15C, the horizontal conductive lines 29 may be formed to fill the linear surrounding recesses 28. The horizontal conductive lines 29 may horizontally extend in the third direction D3.

Forming the horizontal conductive lines 29 may include depositing a conductive material that fills the linear surrounding recesses 28 on the nano sheet dielectric layer 25 and performing a horizontal etch-back process on the conductive material. Each of the horizontal conductive lines 29 may simultaneously surround the narrow sheets 13N at the same level. The horizontal conductive lines 29 may each include a metal-based material, a semiconductive material, or a combination thereof. The horizontal conductive lines 29 may each include molybdenum, molybdenum nitride, ruthenium, titanium nitride, tungsten, polysilicon, or a combination thereof. For example, the horizontal conductive lines 29 may each include a titanium nitride and tungsten (TiN/W) stack in which titanium nitride and tungsten are sequentially stacked. The horizontal conductive lines 29 may each include an N-type work function material or a P-type work function material. The N-type work function material may have a low work function of approximately 4.5 eV or less, and the P-type work function material may have a high work function of approximately 4.5 eV or greater. Each of the second inter-cell dielectric layers 27 may be disposed between a plurality of horizontal conductive lines 29 in the first direction D1. The horizontal conductive lines 29 surrounding the narrow sheets 13N may be referred to as "gate-all-around (GAA) electrodes". The narrow sheets 13N may be referred to as "nano sheet channels", "nano wires" or "nano wire channels".

A lower-level dummy horizontal electrode 29L may be formed on the surface of the substrate 11. An upper-level dummy horizontal electrode 29U may be formed over an uppermost horizontal conductive line 29. The dummy horizontal electrodes 29L and 29U may each have a non-surrounding shape.

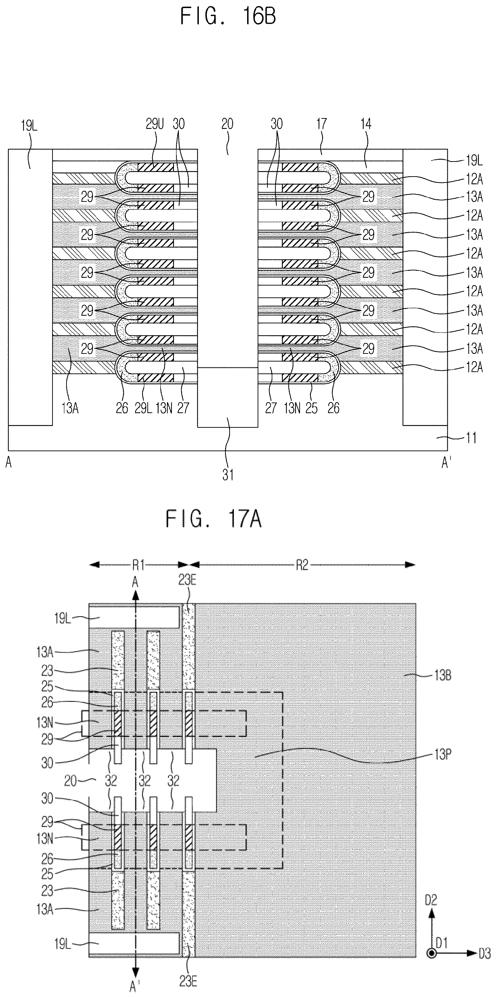

FIG. 16A is a plan view illustrating the structure at the narrow sheet level to describe a method for forming second spacers 30. FIG. 16B is a cross-sectional view of the structure taken along line A-A' illustrated in FIG. 16A.

Referring to FIGS. 16A and 16B, each of the second spacers 30 may be formed on one side of each of the horizontal conductive lines 29. The second spacer 30 may include silicon oxide, silicon nitride, silicon carbon oxide, an embedded air gap, or a combination thereof. Deposition and etch-back processes of a spacer material may be performed to form the second spacer 30. The second spacer 30 may include a stack of a silicon oxide liner and a silicon nitride liner.

After the second spacers 30 are formed, a portion of the nano sheet dielectric layer 25 may be cut to expose one side of each of the narrow sheets 13N.

The second spacers 30 may surround the narrow sheets 13N at the same horizontal level in the third direction D3 on one side of the horizontal conductive lines 29.

Subsequently, a first bottom protection layer 31 may be formed on the surface of the substrate 11. The first bottom protection layer 31 may include a material having an etch selectivity with respect to the substrate 11. The first bottom protection layer 31 may include a dielectric material. The first bottom protection layer 31 may include silicon oxide, silicon nitride, silicon carbon oxide, or a combination thereof.

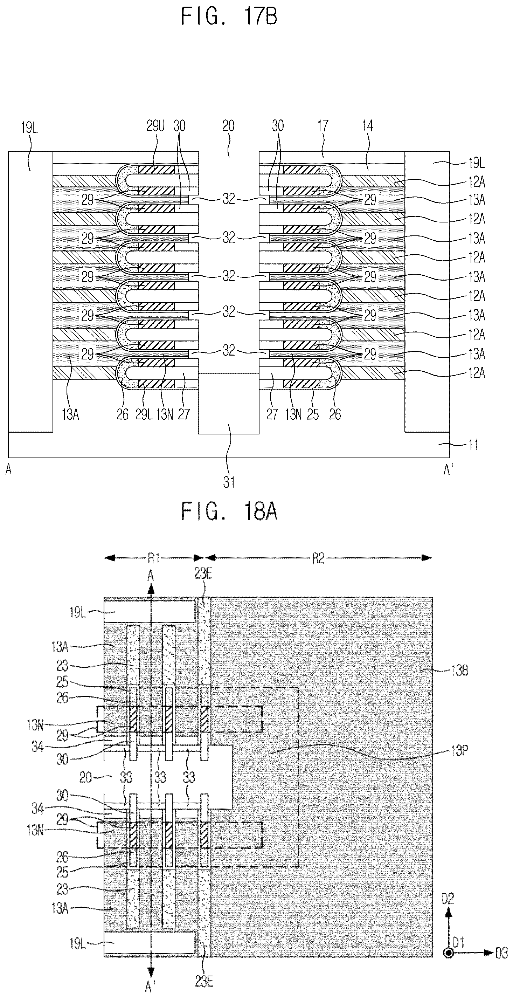

FIG. 17A is a plan view illustrating the structure at the narrow sheet level to describe a method for forming narrow sheet cuts 32. FIG. 17B is a cross-sectional view of the structure taken along line A-A' illustrated in FIG. 17A.

Referring to FIGS. 17A and 17B, one side of the narrow sheets 13N and one side of the nano sheet dielectric layers 25 may be cut. Accordingly, the narrow sheet cuts 32 that are horizontally sunken from edges of the second spacer 30 may be formed. While the narrow sheet cuts 32 are formed, the surface of the substrate 11 may be protected by the first bottom protection layer 31. The narrow sheet cuts 32 may be referred to as "narrow sheet level recesses".

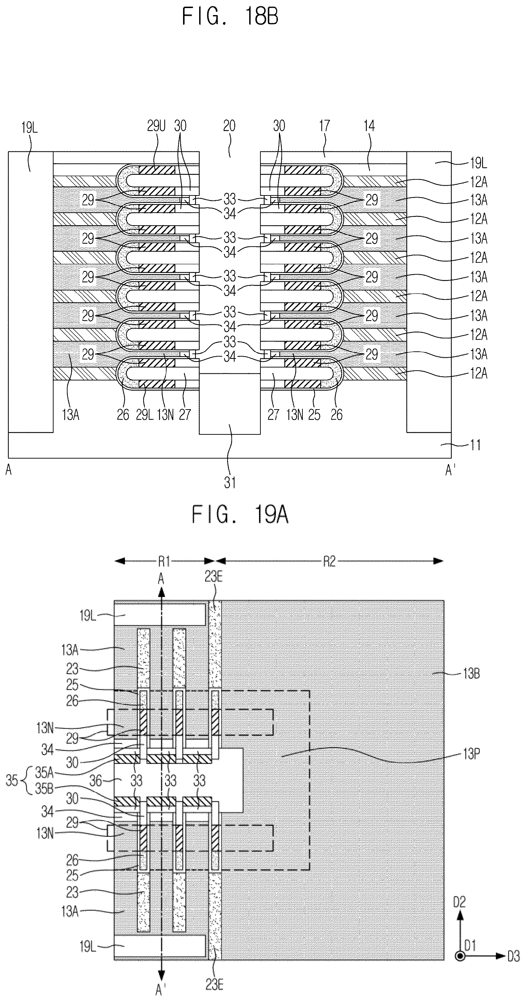

FIG. 18A is a plan view illustrating the structure at the narrow sheet level to describe a method for forming first contact nodes 33. FIG. 18B is a cross-sectional view of the structure taken along line A-A' illustrated in FIG. 18A.

Referring to FIGS. 18A and 18B, the first contact nodes 33 may be selectively formed from the edges of the narrow sheets 13N. The first contact nodes 33 may be formed through selective epitaxial growth (SEG). The first contact nodes 33 may be epitaxial layers of a silicon layer. The first contact nodes 33 may be doped silicon epitaxial layers.

First doped regions 34 may be formed within one side of the narrow sheets 13N. A heat treatment process may be performed to form the first doped regions 34, and thus dopants may be diffused from the first contact nodes 33.

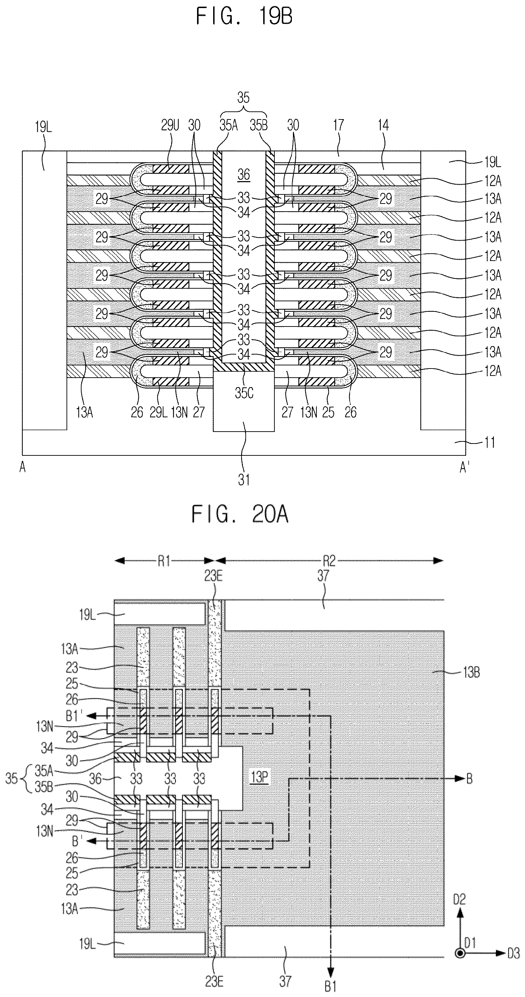

FIG. 19A is a plan view illustrating the structure at the narrow sheet level to describe a method for forming first and second vertical conductive lines 35A and 35B. FIG. 19B is a cross-sectional view of the structure taken along line A-A' illustrated in FIG. 19A.

Referring to FIGS. 19A and 19B, vertical conductive lines 35 may be formed on the first contact nodes 33. Before the vertical conductive lines 35 are formed, ohmic contact layers may be formed on the first contact nodes 33. The ohmic contact layers may each include metal silicide such as titanium silicide or molybdenum silicide. The vertical conductive lines 35 may include the first vertical conductive lines 35A and the second vertical conductive lines 35B.

Forming the first and second vertical conductive lines 35A and 35B may include depositing a metal material and etching the metal material. Bottom portions 35C of the first vertical conductive lines 35A and the second vertical conductive lines 35B that are adjacent to each other may be merged.

The first and second vertical conductive lines 35A and 35B may be vertically oriented in the first direction D1. The first and second vertical conductive lines 35A and 35B may include bit lines. The first and second vertical conductive lines 35A and 35B may each include metal, a metal-base material, or a combination thereof. The first and second vertical conductive lines 35A and 35B may each include metal, metal nitride, metal silicide, or a combination thereof. The first and second vertical conductive lines 35A and 35B may each include titanium nitride, tungsten, or a combination thereof. For example, the first and second vertical conductive lines 35A and 35B may include a titanium nitride/tungsten (TiN/W) stack in which titanium nitride and tungsten are sequentially stacked.

Top portions of the first and second vertical conductive lines 35A and 35B may extend to a portion of a surface of the second hard mask layer 17.

The first and second vertical conductive lines 35A and 35B may be coupled in common to the narrow sheets 13N disposed in the first direction D1.

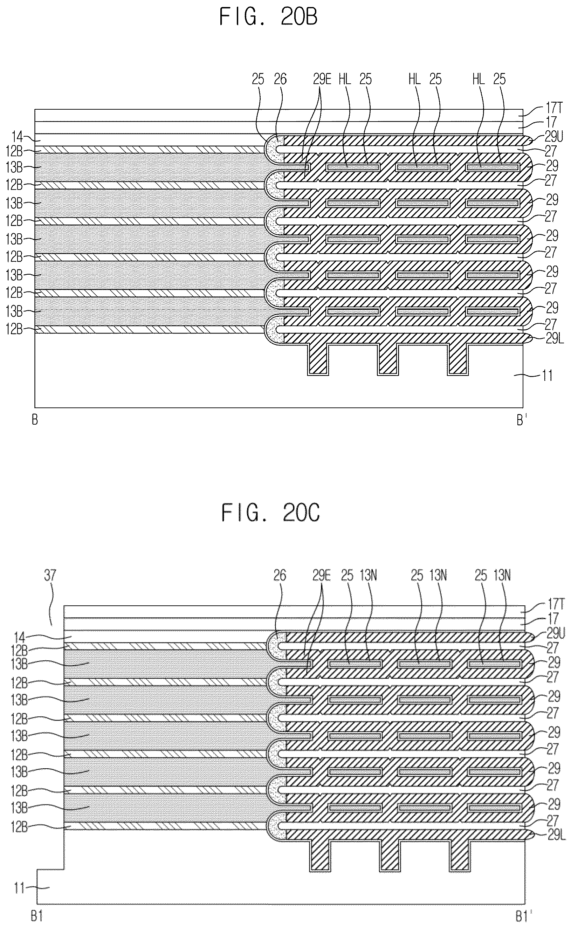

FIG. 20A is a plan view illustrating the structure at a nano sheet level to describe a method for forming pad isolation openings 37. FIG. 20B is a cross-sectional view of the structure taken along line B-B' illustrated in FIG. 20A. FIG. 20C is a cross-sectional view of the structure taken along line B1-B1' illustrated in FIG. 20A.

Referring to FIGS. 20A to 20C, an array isolation layer 36 may be formed to fill the first linear opening 20 on the first and second vertical conductive lines 35A and 35B. The array isolation layer 36 may vertically extend in the first direction D1 and horizontally extend in the third direction D3. The array isolation layer 36 may be formed between the first vertical conductive lines 35A and the second vertical conductive lines 35B in the third direction D3. The array isolation layer 36 may include a dielectric material. The array isolation layer 36 may include silicon oxide, silicon nitride, an air gap, or a combination thereof.

Subsequently, the pad-side first mold layers 12B and the pad-side second mold layers 13B may be etched in the second region R2, and a plurality of pad isolation openings 37 may be formed. The pad isolation openings 37 may horizontally extend in the third direction D3 and vertically extend in the first direction D1.

Referring back to FIGS. 20B and 20C, edge portions 29E of the horizontal conductive lines 29 may cover edges of the pad-side second mold layers 13B with the nano sheet dielectric layer 25 interposed therebetween.

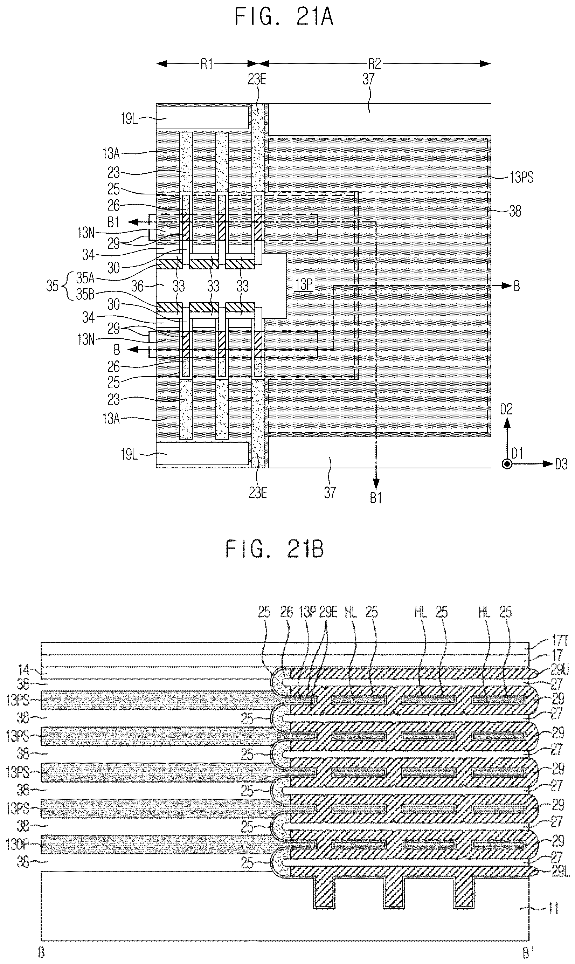

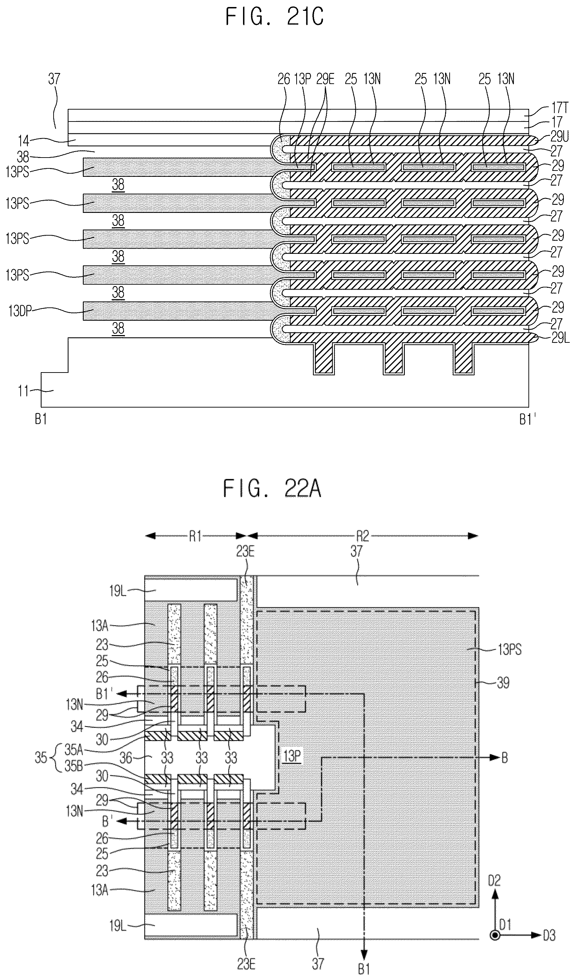

FIG. 21A is a plan view illustrating the structure at the nano sheet level to describe a method for forming pad-side sheets 13PS. FIG. 21B is a cross-sectional view of the structure taken along line B-B' illustrated in FIG. 21A. FIG. 21C is a cross-sectional view of the structure taken along line B1-B1' illustrated in FIG. 21A.

Referring to FIGS. 21A to 21C, the pad-side first mold layers 12B and the pad-side second mold layers 13B may be sequentially recessed to form the pad-side sheets 13PS. The pad-side first mold layers 12B may be removed entirely, and upper and lower surfaces of the pad-side second mold layers 13B may be recessed.

Each of inter-pad recesses 38 may be formed between the pad-side sheets 13PS. The upper and lower surfaces of the narrow sheets 13N may each include a flat surface.

Among the pad-side sheets 13PS, a lowermost pad-side sheet may be referred to as a "dummy sheet 13DP".

The pad-side sheets 13PS may be sacrificial sheets that are replaced with pads in a subsequent process. Horizontal lengths of the pad-side sheets 13PS may be equal to one another. The pad-side sheets 13PS may have a stair-less structure.

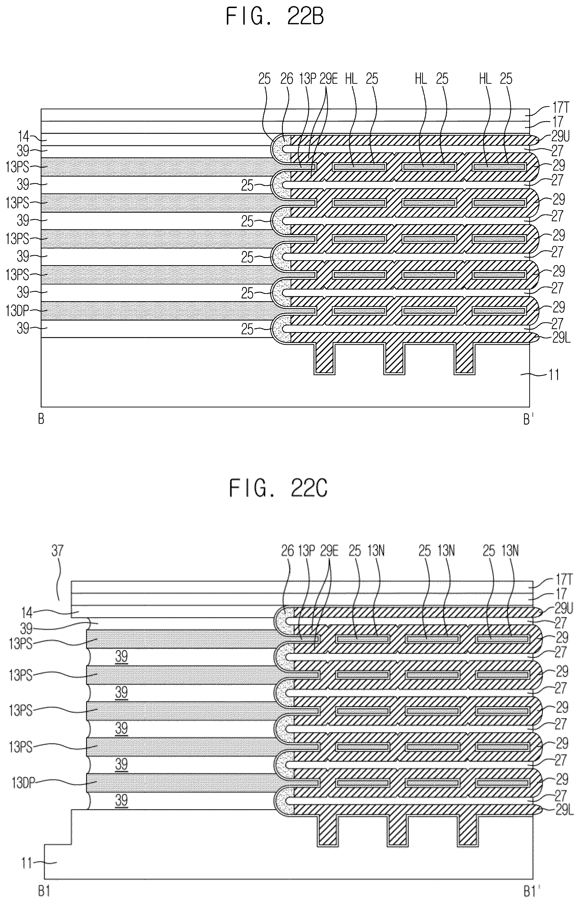

FIG. 22A is a plan view illustrating the structure at the nano sheet level to describe a method for forming inter-pad dielectric layers 39. FIG. 22B is a cross-sectional view of the structure taken along line B-B' illustrated in FIG. 22A. FIG. 22C is a cross-sectional view of the structure taken along line B1-B1' illustrated in FIG. 22A.

Referring to FIGS. 22A to 22C, the inter-pad dielectric layers 39 may be formed to fill the inter-pad recesses 38. The inter-pad dielectric layers 39 may have a selectivity with respect to the pad-side sheets 13PS. The inter-pad dielectric layers 39 may each include silicon oxide, silicon nitride, or a combination thereof.

Deposition and etch-back processes of a sacrificial material may be performed to form the inter-pad dielectric layers 39. After the inter-pad dielectric layers 39 are formed, outer edges of the pad-side sheets 13PS and dummy sheet 13DP may be exposed.

In some embodiments, the inter-pad dielectric layers 39 may each include a low-k material having a dielectric constant of 4 or less, for example, 2.0 to 3.5. The inter-pad dielectric layers 39 may each include SiCOH, SiOF, or a combination thereof. A dielectric constant of SiCOH may be approximately 3, which is lower than a dielectric constant of SiCO. The dielectric constant of SiCO may be approximately 4.

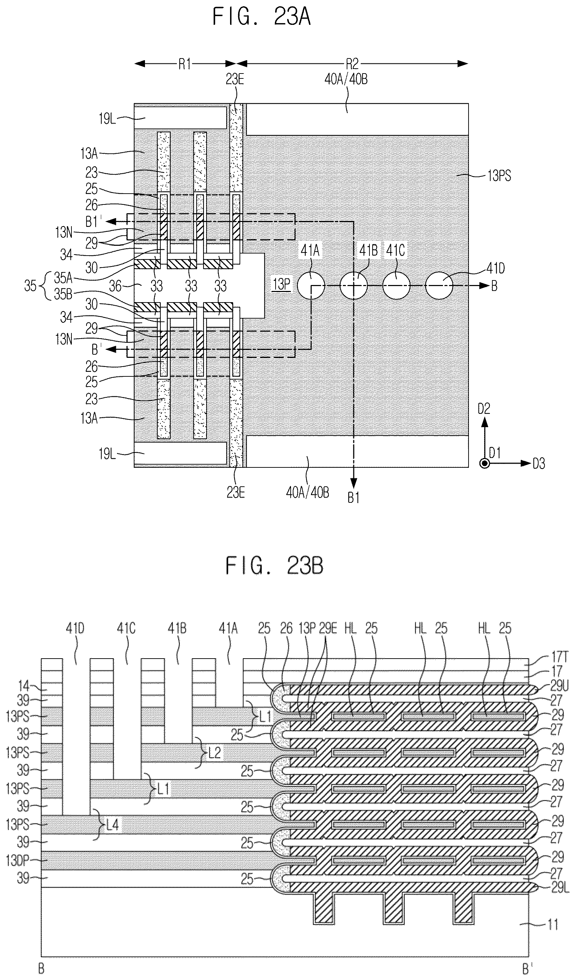

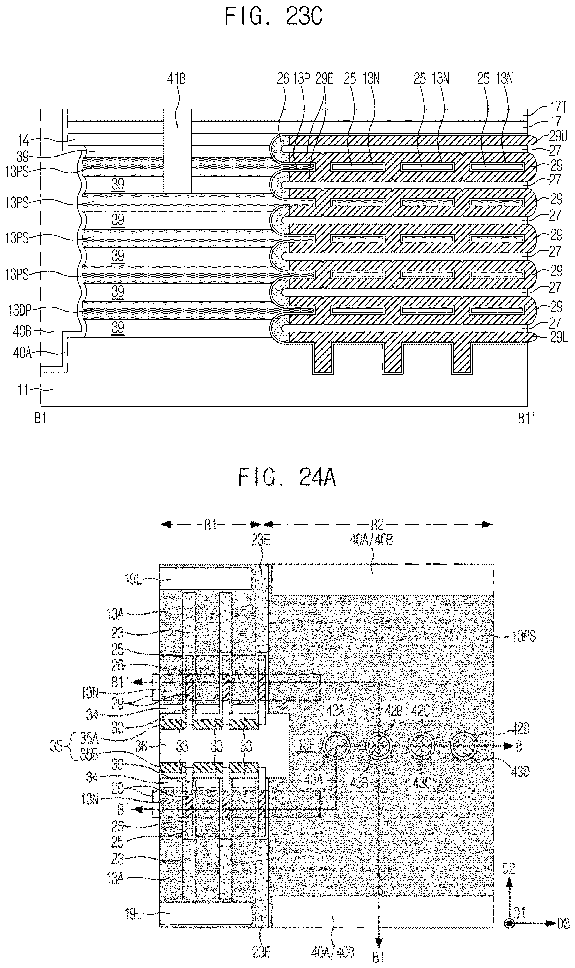

FIG. 23A is a plan view illustrating the structure at the nano sheet level to describe a method for forming contact holes 41A, 41B, 41C and 41D. FIG. 23B is a cross-sectional view of the structure taken along line B-B' illustrated in FIG. 23A. FIG. 23C is a cross-sectional view of the structure taken along line B1-B1' illustrated in FIG. 23A.

Referring to FIGS. 23A to 23C, first and second pad isolation layers 40A and 40B may be formed to fill bottom portions of the pad isolation openings 37.

Subsequently, a plurality of contact holes 41A, 41B, 41C and 41D may be sequentially formed in the second region R2.

The first to third hard mask layers 14, 17 and 17T and an uppermost inter-pad dielectric layer 39 may be etched to form a first contact hole 41A. The first contact hole 41A may expose an upper surface of the pad-side sheet 13PS at a first level L1.

After the first contact hole 41A is masked, the first to third hard mask layers 14, 17 and 17T and the pad-side sheet 13PS at the first level L1 may be etched to form a second contact hole 41B. In addition, the uppermost inter-pad dielectric layer 39 and the inter-pad dielectric layer 39 between the first level L1 and a second level L2 may be etched to form the second contact hole 41B. The second contact hole 41B may expose an upper surface of the pad-side sheet 13PS at the second level L2.

After the first and second contact holes 41A and 41B are masked, the first to third hard mask layers 14, 17 and 17T and the pad-side sheets 13PS at the first and second levels L1 and L2 may be etched to form a third contact hole 41C. In addition, the uppermost inter-pad dielectric layer 39, the inter-pad dielectric layer 39 between the first level L1 and the second level L2 and the inter-pad dielectric layer 39 between the second level L2 and a third level L3 may be etched to form the third contact hole 41C. The third contact hole 41C may expose an upper surface of the pad-side sheet 13PS at the third level L3.

After the first, second and third contact holes 41A, 41B and 41C are masked, the first to third hard mask layers 14, 17, and 17T, the pad-side sheets 13PS at the first level L1, the pad-side sheet 13PS at the second level L2, and the pad-side sheet 13PS at the third level L3 may be etched to form a fourth contact hole 41D. In addition, the uppermost inter-pad dielectric layer 39, the inter-pad dielectric layer 39 between the first level L1 and the second level L2, the inter-pad dielectric layer 39 between the second level L2 and a third level L3, and the inter-pad dielectric layer 39 between the third level L3 and a fourth level LV4 may be etched to form the fourth contact hole 41D. The fourth contact hole 41D may expose an upper surface of the pad-side sheet 13PS at the fourth level L4.

As described above, after the first contact hole 41A is formed, the first contact hole 41A may be masked while the second contact hole 41B is formed. While the third contact hole 41C is formed, the first and second contact holes 41A and 41B may be masked. While the fourth contact hole 41D is formed, the first, second and third contact holes 41A, 41B and 41C may be masked. In some embodiments, the order of forming the first to fourth contact holes 41A to 41D may be variously modified.

Through a series of formation processes of the contact holes as described above, the first contact hole 41A, the second contact hole 41B, the third contact hole 41C, and the fourth contact hole 41D may be sequentially formed. The first contact hole 41A may be shallower than the second contact hole 41B, the second contact hole 41B may be shallower than the third contact hole 41C, and the third contact hole 41C may be shallower than the fourth contact hole 41D. Depths of the first to fourth contact holes 41A to 41D may gradually become shallower in a stacking direction of the pad-side sheets 13PS, i.e., the first direction D1.

The second contact hole 41B may penetrate the pad-side sheet 13PS at the first level L1, and the third contact hole 41C may penetrate the pad-side sheets 13PS at the first and second levels L1 and L2. The fourth contact hole 41D may penetrate the pad-side sheets 13PS at the first to third levels L1, L2, and L3. The first contact hole 41A may not penetrate the pad-side sheet 13PS at the first level L1.

In some embodiments, the plurality of contact holes 41A, 41B, 41C, and 41D may be sequentially formed from a deepest contact hole. For example, the fourth contact hole 41D, the third contact hole 41C, the second contact hole 41B, and the first contact hole 41A may be sequentially formed. The order of forming the fourth contact hole 41D, the third contact hole 41C, the second contact hole 41B, and the first contact hole 41A may be variously modified.

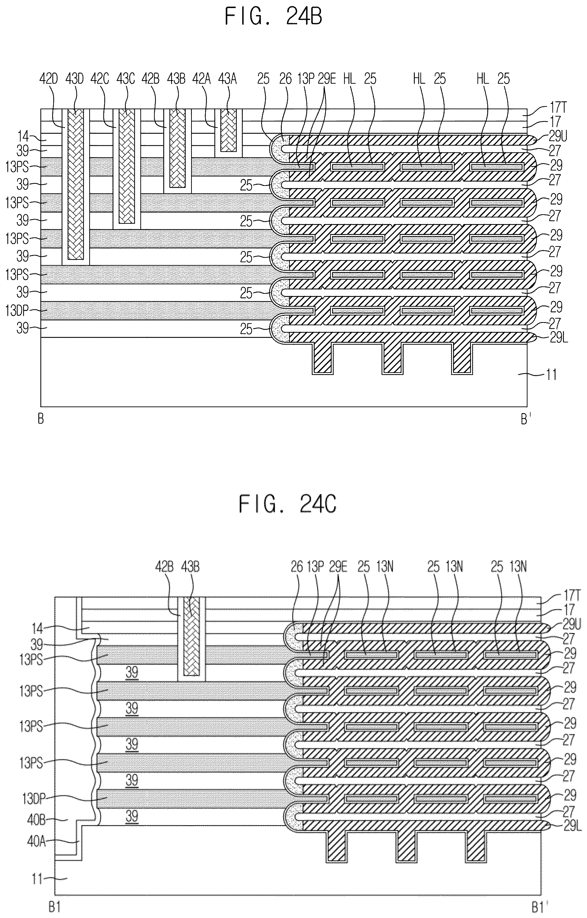

FIG. 24A is a plan view illustrating the structure at the nano sheet level to describe a method for forming contact spacers 42A to 42D and sacrificial plugs 43A to 43D. FIG. 24B is a cross-sectional view of the structure taken along line B-B' illustrated in FIG. 24A. FIG. 24C is a cross-sectional view of the structure taken along line B1-B1' illustrated in FIG. 24A.

Referring to FIGS. 24A to 24C, the contact spacers 42A to 42D may be formed on sidewalls of the first to fourth contact holes 41A to 41D, respectively. The contact spacers 42A to 42D may be formed by deposition and etch processes of a dielectric material. The contact spacers 42A to 42D may each include silicon oxide, silicon nitride, or a combination thereof. The contact spacers 42A to 42D may each include a low-k material. The contact spacers 42A to 42D may each include a low-k material having a dielectric constant of 4 or less, for example, a dielectric constant of 2.0 to 3.5. The contact spacers 42A to 42D may each include SiCOH, SiOF, or a combination thereof. A dielectric constant of SiCOH may be approximately 3, which is lower than a dielectric constant of SiCO. The dielectric constant of SiCO may be approximately 4.

Subsequently, the sacrificial plugs 43A to 43D may be formed to fill the first to fourth contact holes 41A to 41D, respectively, on the contact spacers 42A to 42D. The sacrificial plugs 43A to 43D may be formed by deposition and planarization processes of a sacrificial plug material. The sacrificial plugs 43A to 43D may include a metal-based material. For example, the sacrificial plugs 43A to 43D may be formed by deposition and chemical mechanical polishing (CMP) processes of a tungsten layer.

The sacrificial plugs 43A to 43D may include a structure in which heights thereof gradually decrease in the stacking direction of the pad-side sheets 13PS, i.e., the first direction D1.

As described above, the pad-side sheets 13PS, the contact spacers 42A to 42D and the sacrificial plugs 43A to 43D may be formed in the second region R2.

A first contact spacer 42A may be disposed on a sidewall of a first sacrificial plug 43A, and a second contact spacer 42B may be disposed on a sidewall of a second sacrificial plug 43B. A third contact spacer 42C may be disposed on a sidewall of a third sacrificial plug 43C, and a fourth contact spacer 42D may be disposed on a sidewall of a fourth sacrificial plug 43D. A vertical height of the fourth sacrificial plug 43D may be greater than a vertical height of the third sacrificial plug 43C, and the vertical height of the third sacrificial plug 43C may be greater than a vertical height of the second sacrificial plug 43B. The vertical height of the second sacrificial plug 43B may be greater than a vertical height of the first sacrificial plug 43A. The vertical heights may refer to heights in the first direction D1.

The fourth sacrificial plug 43D and the fourth contact spacer 42D may penetrate the pad-side sheets 13PS and inter-pad dielectric layers 39 at the first to third levels L1, L2 and L3. The fourth sacrificial plug 43D may be electrically isolated from the pad-side sheets 13PS at the first to third levels L1, L2 and L3 by the fourth contact spacer 42D.

The third sacrificial plug 43C and the third contact spacer 42C may penetrate the pad-side sheets 13PS and inter-pad dielectric layers 39 at the first and second levels L1 and L2. The third sacrificial plug 43C may be electrically isolated from the pad-side sheets 13PS at the first and second levels L1 and L2 by the third contact spacer 42C.

The second sacrificial plug 43B and the second contact spacer 42B may penetrate the pad-side sheet 13PS and inter-pad dielectric layer 39 at the first level L1. The second sacrificial plug 43B may be electrically isolated from the pad-side sheet 13PS at the first level L1 by the second contact spacer 42B.

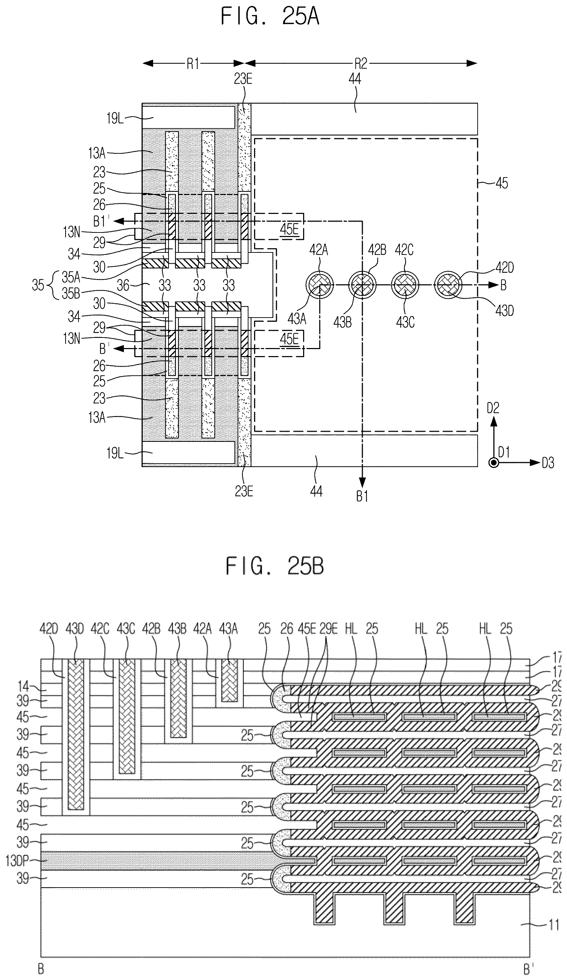

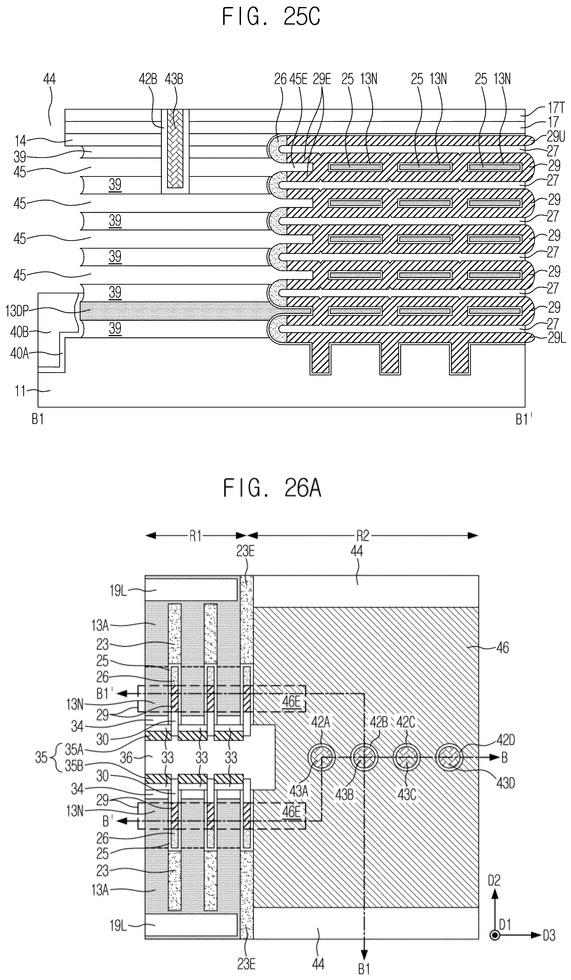

FIG. 25A is a plan view illustrating the structure at the nano sheet level to describe a method for forming pad-shaped openings 45. FIG. 25B is a cross-sectional view of the structure taken along line B-B' illustrated in FIG. 25A. FIG. 25C is a cross-sectional view of the structure taken along line B1-B1' illustrated in FIG. 25A.

Referring to FIGS. 25A to 25C, the pad isolation layers 40A and 40B may be recessed. Accordingly, pad isolation openings 44 each having a reduced height may be defined on upper portions of the recessed pad isolation layers 40A and 40B.

Outer surfaces of the pad-side sheets 13PS and inter-pad dielectric layers 39 may be exposed by the pad isolation openings 44. The dummy sheet 13DP may not be exposed by the recessed pad isolation layers 40A and 40B.

Subsequently, the pad-side sheets 13PS may be selectively removed to form the pad-shaped openings 45 between the inter-pad dielectric layers 39. The pad-shaped openings 45 may include inner edges 45E which may expose the nano sheet dielectric layer 25.

Subsequently, the nano sheet dielectric layer 25 may be cut through the inner edges 45 of the pad-shaped openings 45. Accordingly, the edge portions 29E of the horizontal conductive lines 29 may be exposed.

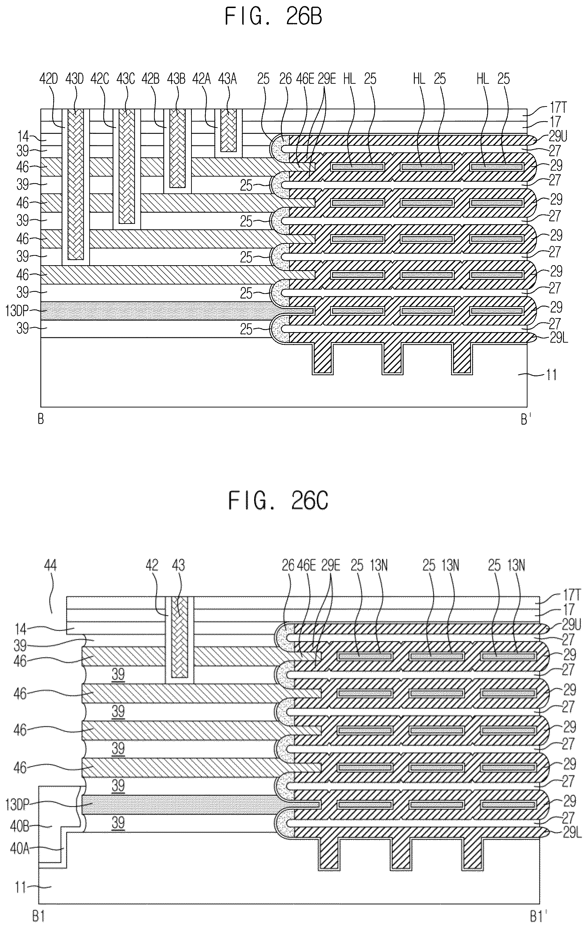

FIG. 26A is a plan view illustrating the structure at the nano sheet level to describe a method for forming pads 46. FIG. 26B is a cross-sectional view of the structure taken along line B-B' illustrated in FIG. 26A. FIG. 26C is a cross-sectional view of the structure taken along line B1-B1' illustrated in FIG. 26A.

Referring to FIGS. 26A to 26C, the pads 46 may be formed to fill the pad-shaped openings 45. Deposition and etch processes of a pad material may be performed to form the pads 46. The pads 46 may be horizontally oriented and electrically coupled to the horizontal conductive lines 29. The pads 46 and the horizontal conductive lines 29 may be the same material. The pads 46 may each include titanium nitride, tungsten, or a combination thereof. The pads 46 may include inner edges 46E, and the inner edges 46E of the pads 46 may be coupled to the edge portions 29E of the horizontal conductive lines 29.

As described above, each of the inter-pad dielectric layers 39 may be disposed between the pads 46. When the inter-pad dielectric layers 39 each include a low-k material, parasitic capacitance between the pads 46 may be reduced. Consequently, parasitic capacitance between the horizontal conductive lines 29 may also be reduced.

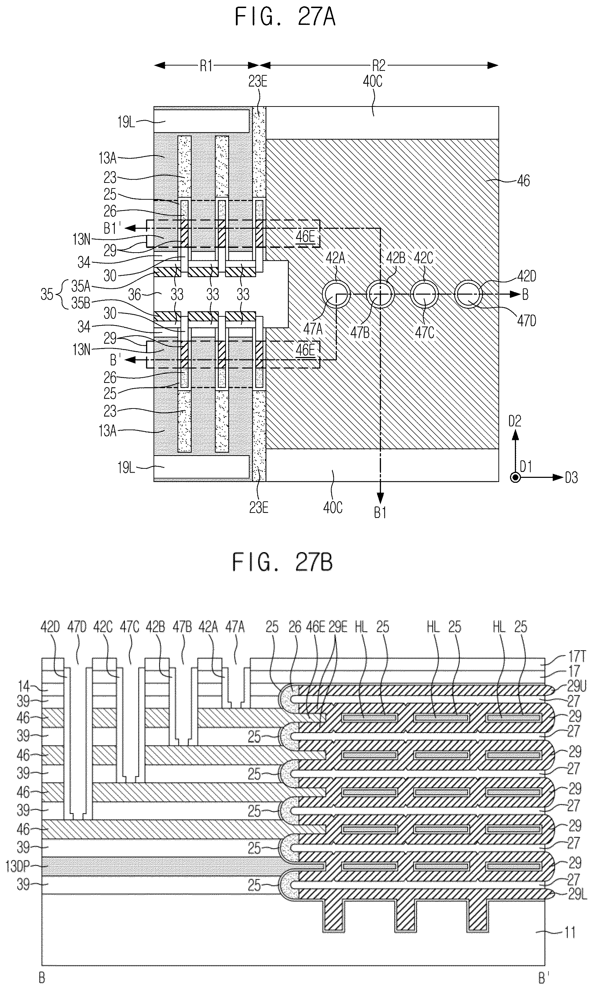

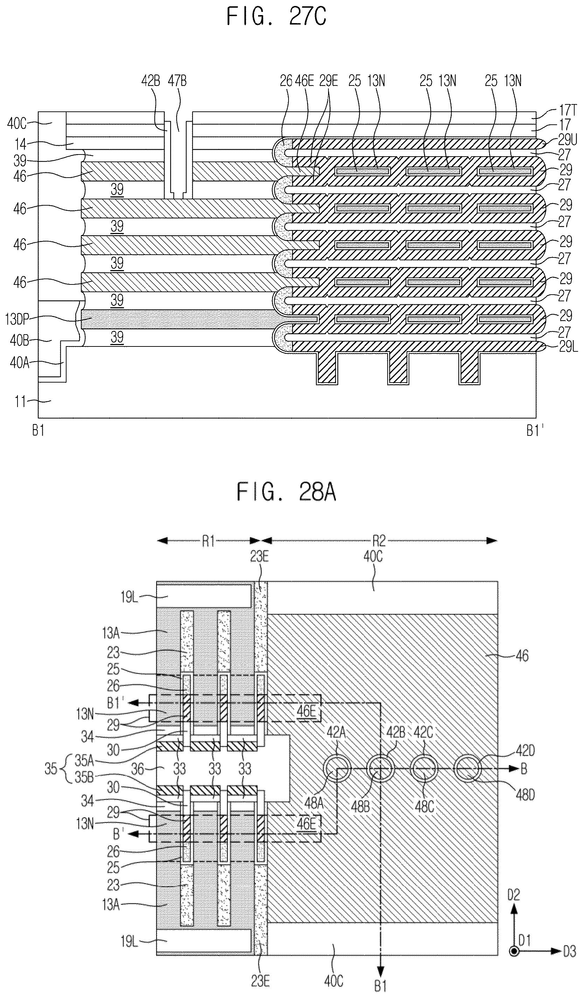

FIG. 27A is a plan view illustrating the structure at the nano sheet level to describe a method for forming plug openings 47A to 47D. FIG. 27B is a cross-sectional view of the structure taken along line B-B' illustrated in FIG. 27A. FIG. 27C is a cross-sectional view of the structure taken along line B1-B1' illustrated in FIG. 27A.

Referring to FIGS. 27A to 27C, third pad isolation layers 40C may be formed to fill the pad isolation openings 44.

Subsequently, the sacrificial plugs 43A to 43D may be removed, and the plug openings 47A to 47D may be formed. Subsequently, bottom surfaces of the contact spacers 42A to 42D may be cut, and the plug openings 47A to 47D may expand.

A first plug opening 47A may be shallower than a second plug opening 47B, the second plug opening 47B may be shallower than a third plug opening 47C, and the third plug opening 47C may be shallower than a fourth plug opening 47D. Depths of the plug openings 47A to 47D may gradually become shallower in a stacking direction of the pads 46, i.e., the first direction D1 (i.e., the plug openings 47A to 47D may have different depths).

The second plug opening 47B may penetrate the pads 46 at the first level L1, and the third plug opening 47C may penetrate the pads 46 at the first and second levels L1 and L2. The fourth plug opening 47D may penetrate the pads 46 at the first to third levels L1, L2, and L3. The first plug opening 47A may not penetrate the pads 46 at the first level L1.

The first plug opening 47A may expose an upper surface of the pad 46 at the first level, the second plug opening 47B may expose an upper surface of the pad 46 at the second level, the third plug opening 47C may expose an upper surface of the pad 46 at the third level, and the fourth plug opening 47D may expose an upper surface of the pad 46 at the fourth level. The first to fourth levels are described above with reference to FIG. 23B.

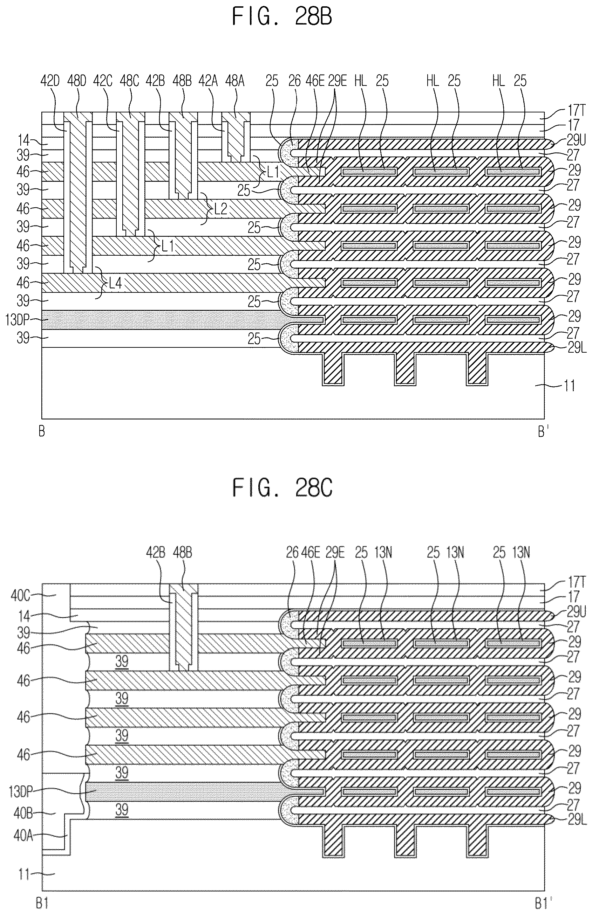

FIG. 28A is a plan view illustrating the structure at the nano sheet level to describe a method for forming contact plugs 48A to 48D. FIG. 28B is a cross-sectional view of the structure taken along line B-B' illustrated in FIG. 28A. FIG. 28C is a cross-sectional view of the structure taken along line B1-B1' illustrated in FIG. 28A.

Referring to FIGS. 28A to 28C, the contact plugs 48A to 48D may be formed to fill the plug openings 47A to 47D. The contact plugs 48A to 48D may be formed by deposition and planarization processes of a plug material. The contact plugs 48A to 48D may each include a metal-based material. For example, the contact plugs 48A to 48D may be formed by deposition and chemical mechanical polishing (CMP) processes of a tungsten layer.

The contact plugs 48A to 48D may include a structure in which heights thereof gradually decrease in the stacking direction of the pads 46, i.e., the first direction D1. The contact plugs 48A to 48D may be vertically oriented in the first direction D1. The contact plugs 48A to 48D may be referred to as "contact pillars".

As described above, the pads 46, the contact spacers 42A to 42D, and the contact plugs 48A to 48D may be formed in the second region R2.

The first contact spacer 42A may be disposed on a sidewall of a first contact plug 48A, and the second contact spacer 42B may be disposed on a sidewall of a second contact plug 48B. The third contact spacer 42C may be disposed on a sidewall of a third contact plug 48C, and the fourth contact spacer 42D may be disposed on a sidewall of a fourth contact plug 48D. A vertical height of the fourth contact plug 48D may be greater than a vertical height of the third contact plug 48C, and the vertical height of the third contact plug 48C may be greater than a vertical height of the second contact plug 48B. The vertical height of the second contact plug 48B may be greater than a vertical height of the first contact plug 48A. The vertical heights may refer to heights in the first direction D1.

The fourth contact plug 48D and the fourth contact spacer 42D may penetrate the pads 46 and inter-pad dielectric layers 39 at the first to third levels L1 to L3. The fourth contact plug 48D may be electrically isolated from the pads 46 at the first to third levels L1 to L3 by the fourth contact spacer 42D. The fourth contact plug 48D may be electrically coupled to the pad 46 at the fourth level L4.

The third contact plug 48C and the third contact spacer 42C may penetrate the pads 46 and inter-pad dielectric layers 39 at the first and second levels L1 and L2. The third contact plug 48C may be electrically isolated from the pads 46 at the first and second levels L1 and L2 by the third contact spacer 42C. The third contact plug 48C may be electrically coupled to the pad 46 at the third level L3.

The second contact plug 48B and the second contact spacer 42B may penetrate the pads 46 and inter-pad dielectric layer 39 at the first level L1. The second contact plug 48B may be electrically isolated from the pads 46 at the first level L1 by the second contact spacer 42B. The second contact plug 48B may be electrically coupled to the pad 46 at the second level L2.

The first contact plug 48A may be electrically coupled to the pad 46 at the first level L1.

The second to fourth contact plugs 48B to 48D may form a stair-less contact structure. In some embodiments, a quantity of contact plugs may be variously modified depending on a quantity of stacked memory cells.

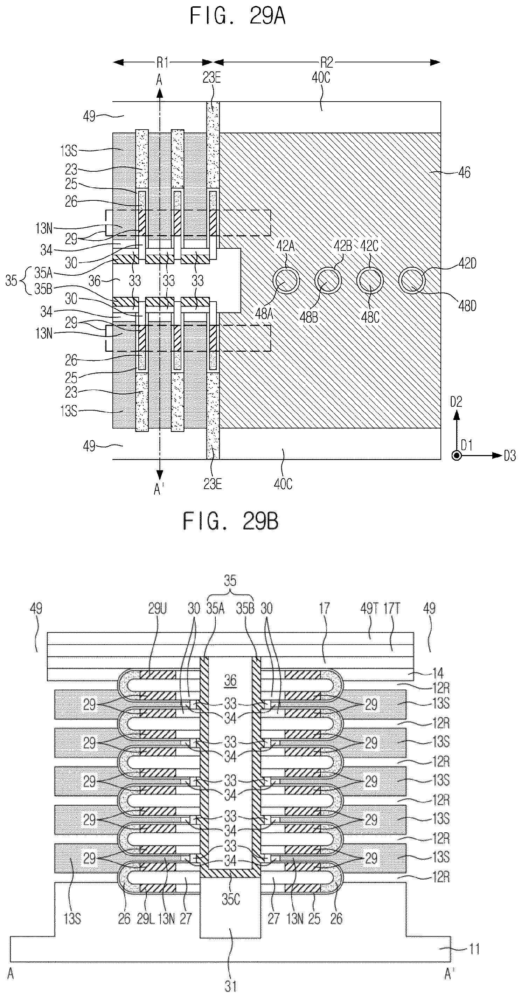

FIG. 29A is a plan view illustrating the structure at the nano sheet level to describe a method for forming second linear openings 49. FIG. 29B is a cross-sectional view of the structure taken along line A-A' illustrated in FIG. 29A.

Referring to FIGS. 29A and 29B, the second linear sacrificial layer 19L may be removed using a fourth hard mask layer 49T as a barrier. Accordingly, the second linear openings 49 may be formed.

After the second linear openings 49 are formed, the first mold layers 12A may be selectively recessed through the second linear openings 49. To selectively recess the first mold layers 12A, a difference in etch selectivity between the first mold layers 12A and the original body portions 13A may be used. The first mold layers 12A may be removed using a wet etch process or a dry etch process. For example, when the first mold layers 12A include silicon germanium layers and the original body portions 13A include monocrystalline silicon layers, the silicon germanium layers may be etched using an etchant or etch gas having a selectivity with respect to the monocrystalline silicon layers.

Subsequently, the original body portions 13A may be recessed. To recess the original body portions 13A, the wet etch process or the dry etch process may be used. Vertical thicknesses of the original body portions 13A may be reduced, as indicated by reference numeral "13S". Hereinafter, the original body portions having the reduced vertical thicknesses are referred to as "recessed body portions 13S".

Each of inter-body recesses 12R may be formed between the recessed body portions 13S that are vertically disposed.

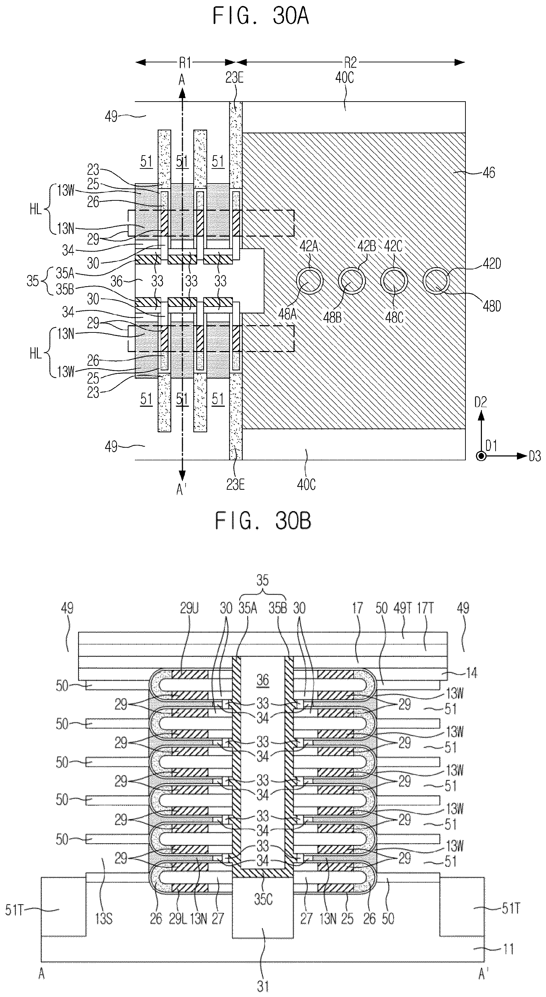

FIG. 30A is a plan view illustrating the structure at the narrow sheet level to describe a method for forming nano sheets HL. FIG. 30B is a cross-sectional view of the structure taken along line A-A' illustrated in FIG. 30A.

Referring to FIGS. 30A and 30B, third inter-cell dielectric layers 50 may be formed to fill the inter-body recesses 12R. The third inter-cell dielectric layers 50 may each include silicon oxide.

After the third inter-cell dielectric layers 50 are formed, second bottom protection layers 51T may be formed on bottom portions of the second linear openings 49. The second bottom protection layers 51T may each include a material having an etch selectivity with respect to the substrate 11. The second bottom protection layers 51T may each include a dielectric material. The second bottom protection layers 51T may each include silicon oxide, silicon nitride, silicon carbon oxide, or a combination thereof.

After the second bottom protection layers 51T are formed, storage openings 51 may be formed by horizontal recessing of the recessed body portions 13S. The storage openings 51 may be referred to as "capacitor openings". The nano sheets HL may be formed by the horizontal recessing of the recessed body portions 13S. Each of the nano sheets HL may include the narrow sheet 13N and a wide sheet 13W. The wide sheet 13W of the nano sheet HL may refer to the recessed body portion 13S remaining after the recessing. An average vertical height of the wide sheets 13W of the nano sheets HL in the first direction D1 may be greater than an average vertical height of the narrow sheets 13N. A thickness of the wide sheet 13W of the nano sheet HL may gradually increase in the second direction D2. A horizontal length of the wide sheet 13W in the second direction D2 may be less than a horizontal length of the narrow sheet 13N. The wide sheet 13W of the nano sheet HL may have a fan-like shape. The wide sheet 13W may be referred to as a "fan-shaped sheet", and the narrow sheet 13N may be referred to as a "flat plate-shaped sheet".

To form the nano sheets HL each including the wide sheet 13W, the recessed body portions 13S may be isotropically or anisotropically etched. One side of the wide sheet 13W, i.e., the side exposed by each of the storage openings 44, may have a flat shape. The one side of the wide sheet 13W may have various shapes.

The one side of the wide sheet 13W may have various shapes. For example, the one side of the wide sheet 13W may have a rounded concave shape, a rounded convex shape, an angled concave shape, or an angled convex shape.

The second bottom protection layers 51T and a lowermost third inter-cell dielectric layer 50 may prevent loss of the substrate 11 during the recessing process of the recessed body portions 13S.

Each of the storage openings 51 may be disposed between the third inter-cell dielectric layers 50 in the first direction D1.

In some embodiments, the horizontal recessing of the recessed body portions 13S for forming the wide sheets 13W may stop at a boundary area between the narrow sheet 13N and the wide sheet 13W.

The first spacer 26 may surround the wide sheets 13W at the same horizontal level, which are disposed in third direction D3. The second spacer 30 may surround the narrow sheets 13N at the same horizontal level, which are disposed in the third direction D3.

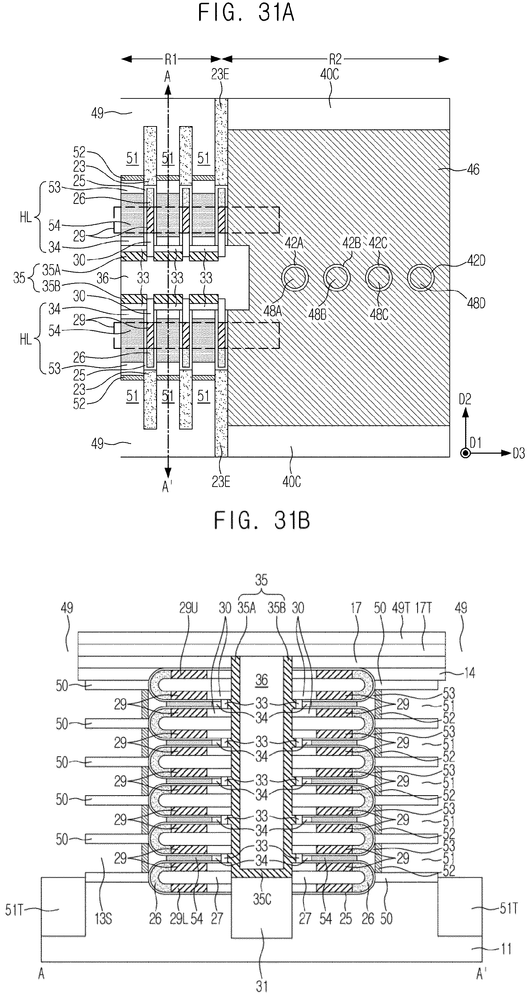

FIG. 31A is a plan view illustrating the structure at the narrow sheet level to describe a method for forming second contact nodes 52. FIG. 31B is a cross-sectional view illustrating the structure taken along line A-A' illustrated in FIG. 31A.

Referring to FIGS. 31A and 31B, a pre-cleaning process may be performed on the surfaces of the wide sheets 13W.

The second contact nodes 52 may be formed on the wide sheets 13W. Forming the second contact nodes 52 may include selective epitaxial growth (SEG). For example, a semiconductive material may be grown from the side surfaces of the wide sheets 13W through the SEG. The second contact nodes 52 may each include SEG Si. Because the wide sheets 13W each include monocrystalline silicon, a silicon layer may be epitaxially grown along crystal surfaces of the side surfaces of the wide sheets 13W.

The second contact nodes 52 may each include a dopant. When the silicon layer is grown using the SEG, dopants may be doped in situ. Accordingly, the second contact nodes 52 may each be a doped epitaxial layer. The second contact nodes 52 may each include an N-type dopant as the dopant. The N-type dopant may include phosphorus, arsenic, antimony, or a combination thereof. The second contact nodes 52 may each include a phosphorus-doped silicon epitaxial layer formed by the SEG, i.e., a doped SEG silicon doped with phosphorous (SiP or alternatively Si:P). In some embodiments, the second contact nodes 52 may be formed through deposition and etch-back processes of doped polysilicon.

Each of the second contact nodes 52 may be disposed between the third inter-cell dielectric layers 50 that are vertically stacked. The second contact nodes 52 may correspond to the second contact node SNC illustrated in FIG. 4B.

Second doped regions 53 may be formed in the wide sheets 13W. A heat treatment process may be performed to form the second doped regions 53, and thus dopants may be diffused from the second contact nodes 52.

A channel 54 may be defined between the first doped region 34 and the second doped region 53. A horizontal arrangement of the first doped region 34, the channel 54 and the second doped region 53 may form each of the nano sheets HL.

Each of the nano sheets HL may include the first doped region 34, the second doped region 53, and the channel 54. The first doped region 34 and the channel 54 may be formed in the narrow sheet 13N. The second doped region 53 may be formed in the wide sheet 13W. A portion of each of the second doped regions 53 may extend into the narrow sheets 13N. One side of each of the second doped regions 53 of the nano sheets HL may be coupled to the channel 54. The other side of each of the second doped regions 53 of the nano sheets HL may be coupled to the second contact nodes 52.

The first spacer 26 may surround the second doped regions 53 at the same horizontal level, which are disposed in the third direction D3. The second spacer 30 may surround the first doped regions 34 at the same horizontal level, which are disposed in the third direction D3. The horizontal conductive line 29 may surround the channels 54 at the same horizontal level, which are disposed in the third direction D3.

In some embodiments, an ohmic contact layer including metal silicide may be further formed after the second contact nodes 52 are formed.

As described above, the nano sheets HL may be formed by subsequent selective recessing processes performed on the second mold layers 13 of the mold stack SB, and each of the nano sheets HL may include the narrow sheet 13N and the wide sheet 13W. The first doped regions 34 and the channels 54 may be formed in the narrow sheets 13N, and the second doped regions 53 may be formed in the wide sheets 13W.

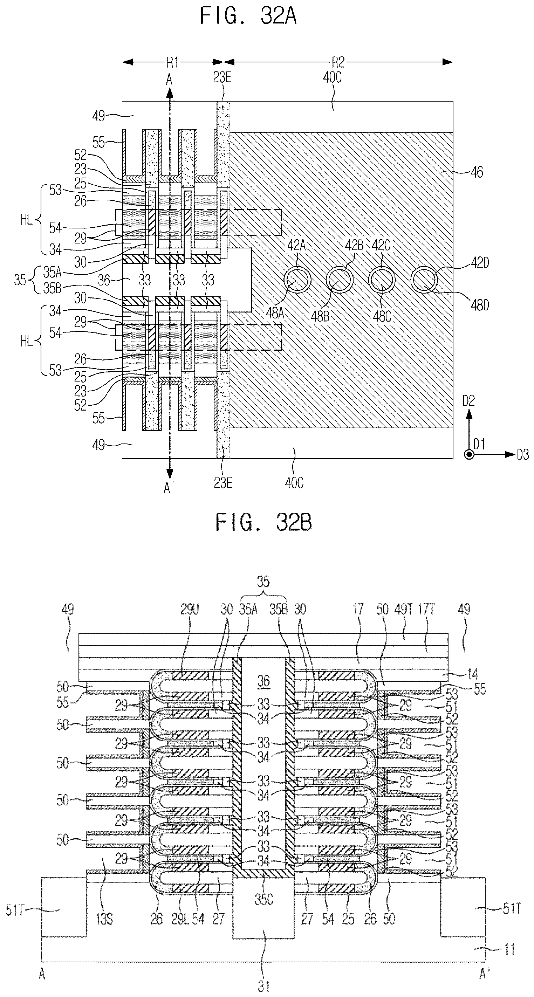

FIG. 32A is a plan view illustrating the structure at the narrow sheet level to describe a method for forming first electrodes 55. FIG. 32B is a cross-sectional view illustrating the structure taken along line A-A' illustrated in FIG. 32A.

Referring to FIGS. 32A and 32B, the first electrodes 55 of a data storage element may be formed on the second contact nodes 52. The first electrodes 55 may each have a horizontally-oriented cylindrical shape. Each of the first electrodes 55 may be disposed in a different one of the storage openings 51. The first electrodes 55 adjacent to each other in the second direction D2 may be spaced apart from each other by the second linear openings 49. The first electrodes 55 adjacent to each other in the first direction D1 may be spaced apart from each other by the third inter-cell dielectric layers 50. Forming the first electrodes 55 may include depositing a metal material, gap-filling a sacrificial material, and isolating the metal material in a vertical/horizontal direction. The sacrificial material may include oxide or polysilicon.

Each of the first electrodes 55 may include an inner space and a plurality of outer surfaces. The inner space of the first electrode 55 may include a plurality of inner surfaces. The outer surfaces of the first electrode 55 may include a vertical outer surface and a plurality of horizontal outer surfaces. The vertical outer surface of the first electrode 55 may vertically extend in the first direction D1. The horizontal outer surfaces of the first electrode 55 may horizontally extend in the second direction D2 or the third direction D3. The inner space of the first electrode 55 may be a three-dimensional space. The first electrode 55 may have a cylindrical shape.

Among the outer surfaces of the first electrode 55, the vertical outer surface may be electrically coupled to the nano sheet HL and the second contact node 52.

The first electrode 55 may include metal, noble metal, metal nitride, conductive metal oxide, conductive noble metal oxide, metal carbide, metal silicide, or a combination thereof. For example, the first electrode 55 may include titanium (Ti), titanium nitride (TiN), titanium silicon nitride (TiSiN), tantalum (Ta), tantalum nitride (TaN), tungsten (W), tungsten nitride (WN), ruthenium (Ru), ruthenium oxide (RuO₂), iridium (Ir), iridium oxide (IrO₂), platinum (Pt), molybdenum (Mo), molybdenum oxide (MoO), a titanium nitride/tungsten (TiN/W) stack, a tungsten nitride/tungsten (WN/W) stack, a titanium silicon nitride/titanium nitride (TiSiN/TiN) stack, or a combination thereof.

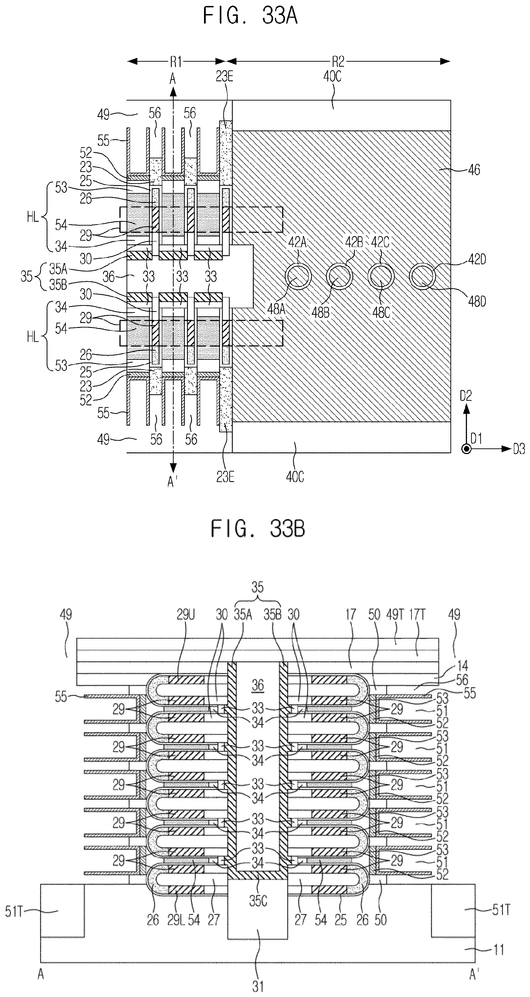

FIG. 33A is a plan view illustrating the structure at the narrow sheet level to describe a method for partially recessing the third inter-cell dielectric layers 50. FIG. 33B is a cross-sectional view of the structure taken along line A-A' illustrated in FIG. 33A.

Referring to FIGS. 33A and 33B, portions of the first and third inter-cell dielectric layers 23 and 50 may be horizontally recessed (refer to reference numeral "56"). Accordingly, the outer walls of the first electrodes 55 may be partially exposed. The first electrodes 55 may each have a semi-cylindrical shape. Horizontal recess depths of the third inter-cell dielectric layers 50 may be depths that do not expose the second contact nodes 52. The semi-cylindrical shape of each of the first electrodes 55 may include cylindrical inner surfaces and semi-cylindrical outer surfaces.

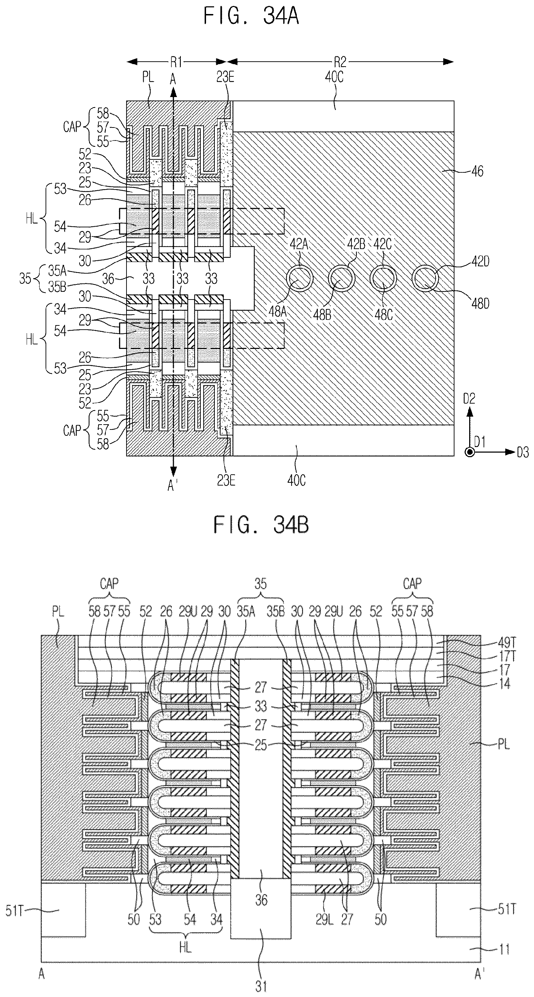

FIG. 34A is a plan view illustrating the structure at the nano sheet level to describe a method for forming a second electrode 58. FIG. 34B is a cross-sectional view of the structure taken along line A-A' illustrated in FIG. 34A.

Referring to FIGS. 34A and 34B, a dielectric layer 57 and the second electrode 58 may be sequentially formed on the first electrodes 55. The first electrode 55, the dielectric layer 57 and the second electrode 58 may be a data storage element CAP. The second electrodes 58 of the data storage elements CAP may be merged with one another and form a common plate PL.

The dielectric layer 57 and the second electrode 58 may be disposed on the cylindrical inner surfaces of the first electrode 55. A portion of the dielectric layer 57 and a portion of the second electrode 58 may extend to be disposed on the semi-cylindrical outer surfaces of the first electrode 55.

The dielectric layer 57 may be referred to as a "capacitor dielectric layer" or a "memory layer". The dielectric layer 57 may include silicon oxide, silicon nitride, a high-k material, a ferroelectric material, an antiferroelectric material, a perovskite material, or a combination thereof. The dielectric layer 57 may include hafnium oxide (HfO₂), zirconium oxide (ZrO₂), aluminum oxide (Al₂O₃), lanthanum oxide (La₂O₃), titanium oxide (TiO₂), tantalum oxide (Ta₂O₅), niobium oxide (Nb₂O₅), or strontium titanium oxide (SrTiO₃). The dielectric layer 57 may include a ZA (ZrO₂/Al₂O₃) stack, a ZAZA (ZrO₂/Al₂O₃/ZrO₂/Al₂O₃) stack, a ZAZAZ (ZrO₂/Al₂O₃/ZrO₂/Al₂O₃/ZrO₂) stack, an HAHA (HfO₂/Al₂O₃/HfO₂/Al₂O₃) stack, an HAHAH (HfO₂/Al₂O₃/HfO₂/Al₂O₃/HfO₂) stack, an HZAZH (HfO₂/ZrO₂/Al₂O₃/ZrO₂/HfO₂) stack, a ZHZAZHZ (ZrO₂/HfO₂/ZrO₂/Al₂O₃/ZrO₂/HfO₂/ZrO₂) stack, an HZHZ (HfO₂/ZrO₂/HfO₂/ZrO₂) stack, an AHZAZHA (Al₂O₃/HfO₂/ZrO₂/Al₂O₃/ZrO₂/HfO₂/Al₂O₃) stack, or an AHZAHZA (Al₂O₃/HfO₂/ZrO₂/Al₂O₃/HfO₂/ZrO₂/Al₂O₃) stack.

The second electrode 58 may include metal, noble metal, metal nitride, conductive metal oxide, conductive noble metal oxide, metal carbide, metal silicide, or a combination thereof. For example, the second electrode 58 may include titanium (Ti), titanium nitride (TiN), titanium silicon nitride (TiSiN), tantalum (Ta), tantalum nitride (TaN), tungsten (W), tungsten nitride (WN), ruthenium (Ru), ruthenium oxide (RuO₂), iridium (Ir), iridium oxide (IrO₂), platinum (Pt), molybdenum (Mo), molybdenum oxide (MoO), a titanium nitride/tungsten (TiN/W) stack, a tungsten nitride/tungsten (WN/W) stack, a titanium silicon nitride/titanium nitride (TiSiN/TiN) stack, a titanium silicon nitride/titanium nitride/tungsten (TiSiN/TiN/W) stack, or a combination thereof. The second electrode 58 may also include a combination of a metal-based material and a silicon-based material. For example, a titanium nitride, tungsten, and polysilicon may be sequentially stacked in the second electrode 58.

In some embodiments, a plurality of interface control layers may be further included between the first electrode 55 and the dielectric layer 57 and between and the dielectric layer 57 and the second electrode 58 to alleviate leakage current. Each of the interface control layers may include titanium oxide (TiO₂), tantalum oxide (Ta₂O₅), niobium oxide (Nb₂O₅), niobium nitride (NbN), niobium oxynitride (NbON), or a combination thereof. The data storage element CAP may include a first interface control layer, a second interface control layer, or a combination thereof. The first interface control layer and the second interface control layer may be conductive or dielectric. The first interface control layer may be formed between the first electrode 55 and the dielectric layer 57, and the second interface control layer may be formed between the dielectric layer 57 and the second electrode 58. The first interface control layer and the second interface control layer may be of the same material or different materials. For example, a structure in which the first interface control layer, dielectric layer 57, and second interface control layer of the data storage element CAP are sequentially stacked may include an NZHZAZHZATN (Nb₂O₅/ZrO₂/HfO₂/ZrO₂/Al₂O₃/ZrO₂/HfO₂/ZrO₂/Al₂O₃/TiO₂/Nb₂O₅) stack.

In some embodiments, the recessing of the first and third inter-cell dielectric layers 23 and 50 illustrated in FIG. 33B may be omitted. Thereafter, as illustrated in FIG. 34B, the dielectric layer 57 and the second electrode 58 may be formed. Accordingly, the data storage element CAP including the first electrode 55 having a concave shape may be formed.

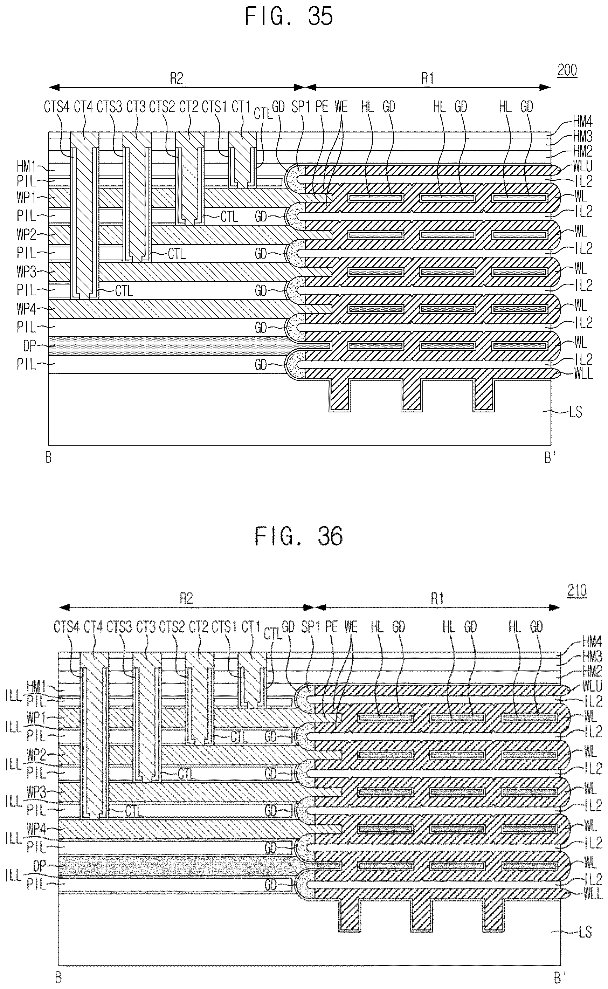

FIGS. 35 to 37 are schematic cross-sectional views of semiconductor devices 200, 210, and 220 in accordance with embodiments of the present disclosure. FIGS. 35 to 37 may be similar to the semiconductor device 100 illustrated in FIGS. 4A to 4E. Detailed descriptions of overlapping components are provided above with reference to FIGS. 4A to 4E.

Referring to FIGS. 35 to 37, each of the semiconductor devices 200, 210, and 220 may include a first region R1 and a second region R2. Each of second conductive lines WL in the first region R1 may be coupled to a different one of pads WP1 to WP4. The second conductive lines WL may each include an edge portion WE having a concave shape. The pads WP1 to WP4 may each include an inner edge PE. The inner edges PE of the pads WP1 to WP4 may each have a convex shape. The inner edges PE of the pads WP1 to WP4 may be disposed in inner spaces of the edge portions WE of the second conductive lines WL. The inner edges PE of the pads WP1 to WP4 may be electrically coupled to the edge portions WE of the second conductive lines WL. The inner edges PE of the pads WP1 to WP4 and the edge portions WE of the second conductive lines WL may contact a first spacer SP1.

The second region R2 may include an alternating stack of the pads WP1 to WP4 and inter-pad dielectric layers PIL and an array of contact plugs CT1 to CT4 which are disposed in the alternating stack, are laterally spaced apart from each other in a first horizontal direction, i.e., a third direction D3, and have different heights. Top surfaces of the contact plugs CT1 to CT4 may be disposed in the same horizontal plane, and bottom portions of the contact plugs CT1 to CT4 may be adjoined to the pads WP1 to WP4, respectively.

The first contact plug CT1 may be electrically coupled to the first pad WP1 at a first level L1 and may be electrically coupled to the second conductive line WL at the first level L1 through the first pad WP1. The second contact plug CT2 may be electrically coupled to the second pad WP2 at a second level L2 and may be electrically coupled to the second conductive line WL at the second level L2 through the second pad WP2. The third contact plug CT3 may be electrically coupled to the third pad WP3 at a third level L3 and electrically coupled to the second conductive line WL at the third level L3 through the third pad WP3. The fourth contact plug CT4 may be electrically coupled to the fourth pad WP4 at a fourth level L4 and electrically coupled to the second conductive line WL at the fourth level L4 through the fourth pad WP4.

A first contact spacer CTS1 may be disposed on a sidewall of the first contact plug CT1, and a second contact spacer CTS2 may be disposed on a sidewall of the second contact plug CT2. A third contact spacer CTS3 may be disposed on a sidewall of the third contact plug CT3, and a fourth contact spacer CTS4 may be disposed on a sidewall of the fourth contact plug CT4. A vertical height of the fourth contact plug CT4 may be greater than a vertical height of the third contact plug CT3, and the vertical height of the third contact plug CT3 may be greater than a vertical height of the second contact plug CT2. The vertical height of the second contact plug CT2 may be greater than a vertical height of the first contact plug CT1. The vertical heights may refer to heights in a first direction D1.

The fourth contact plug CT4 and the fourth contact spacer CTS4 may penetrate the pads WP1, WP2, and WP3 at the first level L1, the second level L2, and the third level L3. The fourth contact plug CT4 may be electrically isolated from the pads WP1, WP2, and WP3 at the first level L1, the second level L2, and the third level L3 by the fourth contact spacer CTS4.

The third contact plug CT3 and the third contact spacer CTS3 may penetrate the pads WP1 and WP2 at the first level L1 and the second level L2. The third contact plug CT3 may be electrically isolated from the pads WP1 and WP2 at the first level L1 and the second level L2 by the third contact spacer CTS3.

The second contact plug CT2 and the second contact spacer CTS2 may penetrate the pad WP1 at the first level L1. The second contact plug CT2 may be electrically isolated from the pad WP1 at the first level L1 by the second contact spacer CTS2.

The first pad WP1 may surround side surfaces of the second to fourth contact plugs CT2, CT3 and CT4. The second pad WP2 may surround the side surfaces of the third and fourth contact plugs CT3 and CT4. The third pad WP3 may surround the side surface of the fourth contact plug CT4.

The first pad WP1 may directly contact a bottom surface of the first contact plug CT1. The second pad WP2 may directly contact a bottom surface of the second contact plug CT2. The third pad WP3 may directly contact a bottom surface of the third contact plug CT3. The fourth pad WP4 may directly contact a bottom surface of the fourth contact plug CT4.

Referring to FIG. 35, the contact spacers CTS1 to CTS4 may each include a low-k material such as SiCOH and SiOF.

Contact liners CTL may be formed on sidewalls of the respective contact spacers CTS1 to CTS4. The contact liners CTL and the contact spacers CTS1 to CTS4 may be different materials. The contact liners CTL may each include oxide, nitride, or a combination thereof. The contact liners CTL may strengthen interfacial adhesion between the contact spacers CTS1 to CTS4 and the inter-pad dielectric layers PIL. The contact liners CTL may also serve to reduce loss of silicon.

The inter-pad dielectric layers PIL may each include a low-k material such as SiCOH or SiOF.

Referring to FIG. 36, the contact spacers CTS1 to CTS4 may each include a low-k material such as SiCOH and SiOF. Contact liners CTL may be formed on sidewalls of the respective contact spacers CTS1 to CTS4. The contact liners CTL may each include oxide, nitride, or a combination thereof.

Inter-pad liners ILL may be formed between the inter-pad dielectric layers PIL and the pads WP1 to WP4. The inter-pad liners ILL may cover outer surfaces of the inter-pad dielectric layers PIL. The inter-pad liners ILL may directly contact the pads WP1 to WP4. The inter-pad liners ILL and the inter-pad dielectric layers PIL may be different materials. The inter-pad dielectric layers PIL may each be a low-k material, and the inter-pad liners ILL may each have a higher dielectric constant than the inter-pad dielectric layers PIL. The inter-pad liners ILL may each include oxide, nitride, or a combination thereof. The inter-pad liners ILL may strengthen interfacial adhesion between pad-side sheets and the inter-pad dielectric layers PIL while the inter-pad dielectric layers PIL are formed.

The inter-pad dielectric layers PIL may each include a low-k material such as SiCOH or SiOF.

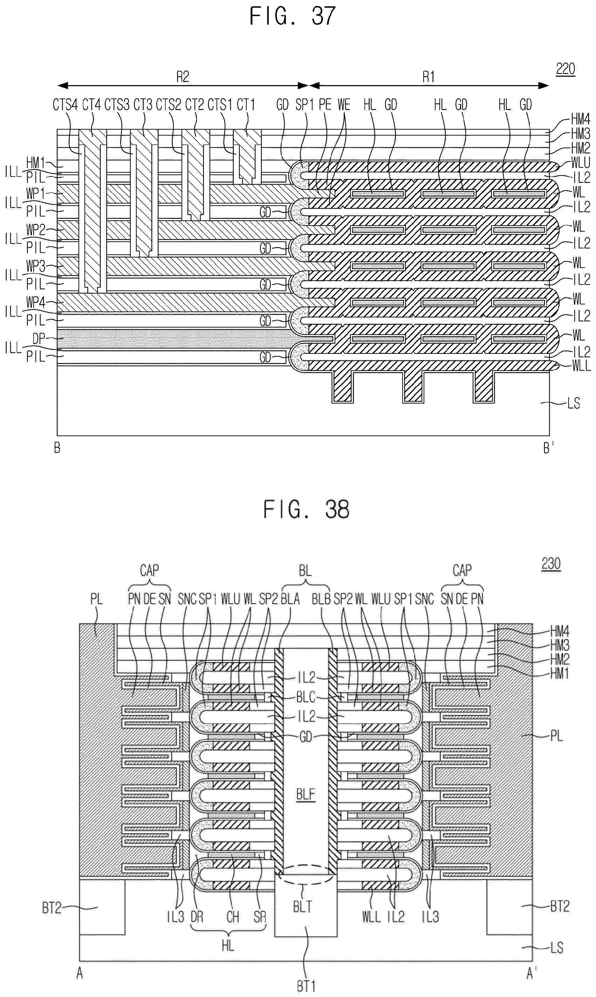

Referring to FIG. 37, the contact spacers CTS1 to CTS4 may each include a low-k material such as SiCOH and SiOF. The inter-pad dielectric layers PIL may each include a low-k material such as SiCOH or SiOF. Inter-pad liners ILL may be formed between the inter-pad dielectric layers PIL and the pads WP1 to WP4. The inter-pad liners ILL may each include oxide, nitride, or a combination thereof.

The semiconductor device 200 illustrated in FIG. 35 may not include the inter-pad liners ILL. The semiconductor device 220 illustrated in FIG. 37 may not include the contact liners CTL. The semiconductor device 210 illustrated in FIG. 36 may include the inter-pad liners ILL and the contact liners CTL.

In the semiconductor device 100 illustrated in FIGS. 4A to 4E, the inter-pad dielectric layers PIL and the contact spacers CTS1 to CTS4 may each include a low-k material. The semiconductor device 100 may not include the inter-pad liners ILL and the contact liners CTL.

The semiconductor devices 200 and 210 illustrated in FIGS. 35 and 36 may reduce parasitic capacitance between the pads WP1 to WP3 surrounding the contact plugs CT2 to CT4 because the contact spacers CTS1 to CTS4 each include a low-k material.

The semiconductor devices 200, 210, and 220 illustrated in FIGS. 35 to 37 may reduce parasitic capacitance between the pads WP1 to WP4 because the inter-pad dielectric layers PIL each include a low-k material having a dielectric constant of 4 or less, for example, 2.0 to 3.5. Accordingly, an operating speed of the semiconductor devices 200, 210 and 220 may increase, and power consumption of the semiconductor devices 200, 210, and 220 may decrease.

Because the semiconductor devices 200 and 210 illustrated in FIGS. 35 and 36 each include the contact liners CTL, the interfacial adhesion between the contact spacers CTS1 to CTS4 and the inter-pad dielectric layers PIL may be strengthened.

Because the semiconductor devices 210 and 220 illustrated in FIGS. 36 and 37 each include the inter-pad liners ILL, the interfacial adhesion between the pad-side sheets and the inter-pad dielectric layers PIL may be strengthened.

In the semiconductor devices 200, 210, and 220 illustrated in FIGS. 35 to 37, the pads WP1 to WP4 in the second region R2 may have a stair-less structure. Because the pads WP1 to WP4 are formed to have the stair-less structure, an occupied area or volume of the pads WP1 to WP4 in the second region R2 may be reduced.

FIG. 38 is a schematic cross-sectional view of a semiconductor device 230 in accordance with an embodiment of the present disclosure. The semiconductor device 230 illustrated in FIG. 38 may be similar to the semiconductor device 100 illustrated in FIGS. 4A to 4E. Detailed descriptions of overlapping components are provided above with reference to FIGS. 4A to 4E.

Referring to FIG. 38, the semiconductor device 230 may include a first vertical conductive line BLA and a second vertical conductive line BLB. Bottom portions of the first and second vertical conductive lines BLA and BLB may be isolated from each other (refer to reference symbol "BLT").

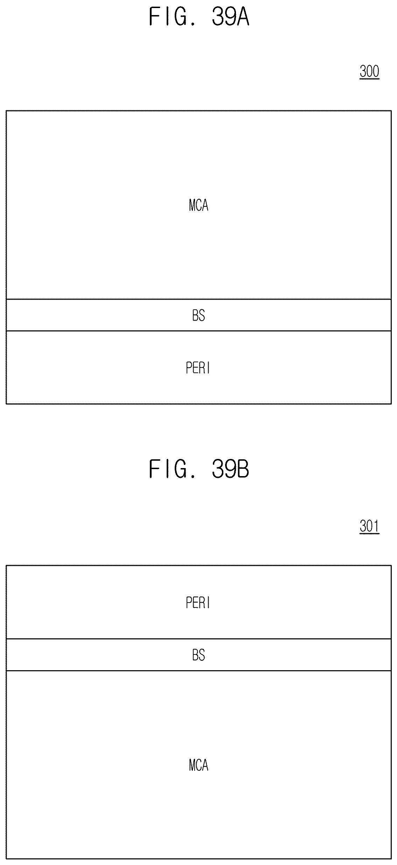

FIGS. 39A and 39B are schematic cross-sectional views of semiconductor devices 300 and 301 in accordance with embodiments of the present disclosure.

Referring to FIG. 39A, the semiconductor device 300 may include a memory cell array MCA, a peripheral circuit portion PERI, and a bonding interface BS. The bonding interface BS may be disposed between the memory cell array MCA and the peripheral circuit portion PERI. In the semiconductor device 300, the memory cell array MCA may be disposed at a level higher than the peripheral circuit portion PERI. The semiconductor device 300 may be referred to as a "Peri Under Cell array (PUC) structure". The memory cell array MCA may include a substrate on which back-grinding is performed and an array of memory cells. For example, as described with reference to FIG. 34B, after the data storage element CAP is formed, the substrate 11 may be flipped over through wafer-flipping, and then a back side of the substrate 11 may be partially ground.

Referring to FIG. 39B, the semiconductor device 301 may include a memory cell array MCA, a peripheral circuit portion PERI, and a bonding interface BS. The bonding interface BS may be disposed between the memory cell array MCA and the peripheral circuit portion PERI. In the semiconductor device 301, the memory cell array MCA may be disposed at a level lower than the peripheral circuit portion PERI. The semiconductor device 301 may be referred to as a "Cell array Under Peri (CUP) structure". Forming the peripheral circuit portion PERI may include forming a plurality of control circuits on a peripheral circuit substrate and forming multi-level interconnection on the control circuits.

In FIG. 39A and FIG. 39B, the bonding interface BS may include pad bonding, hybrid bonding, oxide-to-oxide bonding, metal-to-metal bonding, or a combination thereof. The hybrid bonding may refer to a combination of the pad bonding and the oxide-to-oxide bonding. The pad bonding may include forming a cell bonding pad for the memory cell array MCA, forming a peripheral circuit bonding pad for the peripheral circuit portion PERI, performing the wafer-flipping so that the cell bonding pad and the peripheral circuit bonding pad face each other, and performing wafer bonding.

The semiconductor device 300 illustrated in FIG. 39A may perform the wafer-flipping on the substrate on which the memory cell array is formed so that the cell bonding pad and the peripheral circuit bonding pad face each other, after the cell bonding pad and the peripheral circuit bonding pad are formed. The semiconductor device 301 illustrated in FIG. 39B may perform the wafer-flipping on the substrate on which the peripheral circuit portion is formed so that the cell bonding pad and the peripheral circuit bonding pad face each other, after the cell bonding pad and the peripheral circuit bonding pad are formed.

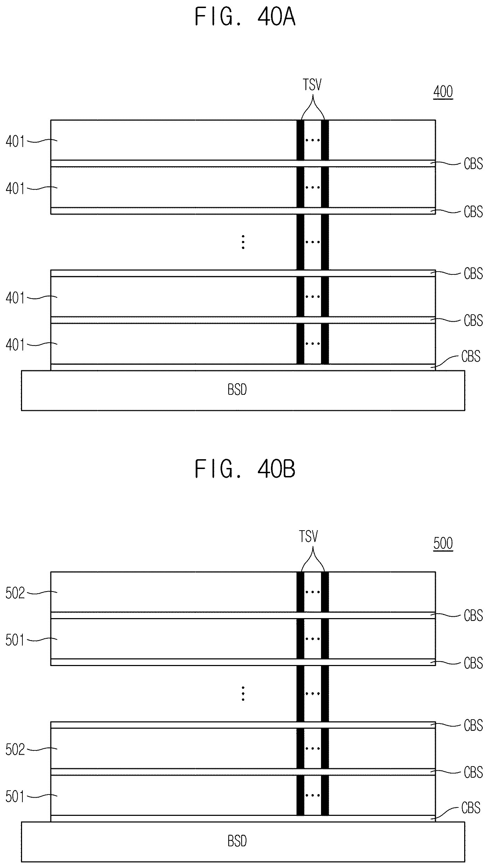

FIGS. 40A and 40B illustrate various views illustrating stack assemblies 400 and 500 in accordance with embodiments of the present disclosure.

Referring to FIG. 40A, the stack assembly 400 may include an assembly of semiconductor dies. For example, the stack assembly 400 may include a first semiconductor die BSD and a plurality of second semiconductor dies 401. The first semiconductor die BSD may include logic circuits. Each of the second semiconductor dies 401 may include memory cell arrays according to embodiments described above.

Each of the second semiconductor dies 401 may include structures in which a memory cell array stack and a peripheral circuit portion are stacked, for example, the semiconductor device 300 illustrated in FIG. 39A or the semiconductor device 301 illustrated in FIG. 39B. The logic circuits of the first semiconductor die BSD may be different from the peripheral circuit portions of the second semiconductor dies 401. The second semiconductor dies 401 may be at a chip level or a wafer level.

The second semiconductor dies 401 may be electrically coupled to each other through a plurality of through silicon vias TSV and bonding interfaces CBS. The first semiconductor die BSD and a lowermost second semiconductor die 401 may be electrically coupled to each other through the bonding interface CBS. The second semiconductor dies 401 may be referred to as "core dies", "semiconductor chips", or "memory chips".

The bonding interface CBS may include micro-bump, pad bonding, hybrid bonding, oxide-to-oxide bonding, metal-to-metal bonding, or a combination thereof.

Referring to FIG. 40B, the stack assembly 500 may include an assembly of semiconductor dies. For example, the stack assembly 500 may include a first semiconductor die BSD, a plurality of second semiconductor dies 501, and a plurality of third semiconductor dies 502. The first semiconductor die BSD may include logic circuits. Each of the second semiconductor dies 501 and each of the third semiconductor dies 502 may include memory cell arrays according to embodiments described above. The second semiconductor dies 501 and the third semiconductor dies 502 may have different structures.

Each of the second semiconductor dies 501 may include the semiconductor device 300 illustrated in FIG. 39A in which a memory cell array is stacked over a peripheral circuit portion. Each of the third semiconductor dies 502 may include the semiconductor device 301 illustrated in FIG. 39B in which a peripheral circuit portion is stacked over a memory cell array.

In some embodiments, each of the second semiconductor dies 501 may include the semiconductor device 301 illustrated in FIG. 39B in which a peripheral circuit portion is stacked over a memory cell array, and each of the third semiconductor dies 502 may include the semiconductor device 300 illustrated in FIG. 39A in which a memory cell array is stacked over a peripheral circuit portion.

The logic circuits of the first semiconductor die BSD may be different from the peripheral circuit portions of the second and third semiconductor dies 501 and 502. The second and third semiconductor dies 501 and 502 may be at a chip level or a wafer level.

The second and third semiconductor dies 501 and 502 may be electrically coupled to each other through a plurality of through silicon vias TSV and bonding interfaces CBS. The first semiconductor die BSD and a lowermost second semiconductor die 501 may be electrically coupled to each other through the bonding interface CBS. The second and third semiconductor dies 501 and 502 may be referred to as "core dies", "semiconductor chips", or "memory chips".

The bonding interface CBS may include micro-bump, pad bonding, hybrid bonding, oxide-to-oxide bonding, metal-to-metal bonding, or a combination thereof.

The stack assemblies 400 and 500 described with reference to FIGS. 40A and 40B may be high bandwidth memories.

According to various embodiments of the present disclosure, it is possible to reduce parasitic capacitance between pads surrounding contact plugs because contact spacers each include a low-k material.

According to various embodiments of the present disclosure, the speed of a semiconductor device may be increased and power consumption may be decreased based on contact spacers that each include a low-k material as provided by the embodiments of the present disclosure.

According to various embodiments of the present disclosure, the reliability of a 3D memory device may be improved, including data retention, endurance (program erase P/E cycles), temperature cycling, and electrostatic discharge (ESD) resistance, etc.

While the embodiments of the present disclosure have been illustrated and described with respect to specific embodiments and drawings, the disclosed embodiments are not intended to be restrictive. Further, it is noted that the embodiments may be achieved in various ways through substitution, change, and modification, as those skilled in the art will recognize in light of the present disclosure, without departing from the spirit and/or scope of the present disclosure and the following claims. Furthermore, the embodiments may be combined to form additional embodiments.

## Claims

1. A semiconductor device comprising:
a vertical arrangement and a horizontal arrangement of nano sheets;
horizontal conductive lines that surround the horizontal arrangement of the nano sheets;
pads coupled to edge portions of the horizontal conductive lines;
inter-pad dielectric layers disposed between the pads;
contact plugs each coupled to a different one of the pads; and
contact spacers each including a first low-k material and each formed on a sidewall of each of the contact plugs.

2. The semiconductor device of claim 1, wherein the first low-k material has a lower dielectric constant than silicon oxide (SiO₂).

3. The semiconductor device of claim 1, wherein the first low-k material has a lower dielectric constant than silicon carbon oxide (SiCO).

4. The semiconductor device of claim 1, wherein the first low-k material includes SiCOH, SiOF, or a combination thereof.

5. The semiconductor device of claim 1, wherein each of the inter-pad dielectric layers includes a second low-k material.

6. The semiconductor device of claim 5, wherein the second low-k material has a lower dielectric constant than silicon carbon oxide (SiCO).

7. The semiconductor device of claim 6, wherein the second low-k material includes SiCOH, silicon oxyfluoride (SiOF), or a combination thereof.

8. The semiconductor device of claim 1, wherein horizontal lengths of the pads have the same structure.

9. The semiconductor device of claim 1, wherein the edge portions of the horizontal conductive lines each include a concave shape, the pads include edges each having a convex shape, and the edges of the pads directly contact inner surfaces of the edge portions of the horizontal conductive lines.

10. The semiconductor device of claim 1, further comprising:
a vertical conductive line coupled to the vertical arrangement of the nano sheets; and
data storage elements each coupled to a different one of the nano sheets in the vertical arrangement and the horizontal arrangement.

11. The semiconductor device of claim 10, further comprising:
first contact nodes formed between the nano sheets and the vertical conductive line; and
second contact nodes formed between the nano sheets and the data storage elements.

12. The semiconductor device of claim 1, further comprising contact liners formed on sidewalls of the contact spacers.

13. The semiconductor device of claim 1, further comprising inter-pad liners formed between the inter-pad dielectric layers and the pads.

14. The semiconductor device of claim 1, further comprising:
contact liners formed on sidewalls of the contact spacers; and
inter-pad liners formed between the inter-pad dielectric layers and the pads,
wherein the contact liners and the inter-pad liners each include a dielectric material.

15. The semiconductor device of claim 1, wherein the contact plugs have different vertical heights.
